(19) Europäisches Patentamt
European Patent Office
Office européen des brevets

(11) EP 2 574 460 B1

# (12) EUROPEAN PATENT SPECIFICATION

(45) Date of publication and mention of the grant of the patent:
**13.05.2015 Bulletin 2015/20**

(51) Int Cl.:
***B41C 1/10*** *(2006.01)* ***G03F 7/004*** *(2006.01)*

(21) Application number: **12186347.6**

(22) Date of filing: **27.09.2012**

## (54) Lithographic printing plate precursor and method of manufacturing lithographic printing plate

Lithographiedruckplattenvorläufer und Verfahren zur Herstellung einer Lithographiedruckplatte

Précurseur de plaque d'impression lithographique et procédé de fabrication de la plaque d'impression lithographique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.09.2011 JP 2011210531**
**23.07.2012 JP 2012162181**

(43) Date of publication of application:
**03.04.2013 Bulletin 2013/14**

(73) Proprietor: **FUJIFILM Corporation**
**Tokyo 106-8620 (JP)**

(72) Inventor: **Nakayama, Takafumi**
**Shizuoka, 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A2- 1 459 888**
**EP-A2- 1 510 866**
**EP-A2- 1 767 352**
**JP-A- 2005 234 385**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 574 460 B1

## Description

BACKGROUND OF THE INVENTION

Field of the Invention

The present invention relates to a lithographic printing plate precursor and a method of manufacturing a lithographic printing plate, according to which a printing plate is directly manufacturable based on digital signal output from a computer or the like using various types of laser, the technique being so-called direct plate making, and particularly to a lithographic printing plate precursor and a method of manufacturing planographic a printing plate suitable for simplified processes.

Description of the Related Art

Solid-state laser, semiconductor laser, and gas laser capable of emitting ultraviolet radiation, visible light and infrared radiation, over a wavelength range of 300 nm to 1200 nm, have been becoming more readily available in larger output and smaller size, and these types of laser are very important as recording light sources in direct plate making process using digital data output from a computer or the like. Various recording materials sensitive to these types of laser light have been investigated. The first category of the materials are those adaptive to infrared laser recording at an image recording wavelength of 760 nm or longer, which are exemplified by positive recording material, and negative recording material causing acid-catalyzed crosslinking. The second category of the materials are those adoptive to ultraviolet or visible light laser recording over the wavelength range from 300 nm to 700 nm, which are exemplified by radical-polymerizable negative recording material.

The conventional lithographic printing plate precursor (also referred to as "PS plate", hereinafter) have essentially needed, after exposure for image forming, a process of solubilizing and removing the non-image-forming area using an aqueous strong alkaline solution (development process), and have also needed water washing of the developed printing plate, rinsing with a rinsing solution containing a surfactant, and post-treatment such as using a desensitization solution containing gum arabic or a starch derivative.

Indispensableness of these additional wet processes has been a big issue of the conventional PS plate. This is because, even if the former half of the plate making process (pattern-wise exposure) may be simplified by virtue of digital processing, the effect of simplification is limitative so long as the latter half (development process) relies upon such labor-consuming wet process.

In particular in recent years, friendliness to the global environment has been a great matter of interest across the whole area of industry, so that issues to be solved from the environmental viewpoint include use of a developer more close to neutral, and reduction in volume of waste liquid. Among others, the wet post-treatment have been desired to be simplified, or replaced with a dry process.

From this point of view, there has been known methods of simplifying the post-treatment process, exemplified by single-liquid treatment or single-bath treatment, by which development and gum solution are proceeded at the same time. More specifically, they belong to a sort of simplified development process by which the original plate is exposed pattern-wise without pre-water washing; removal of a protective layer, removal of the non-image-forming area, and coating of gum solution are implemented concomitantly using a single solution or in a single bath; the original plate is dried without post-water washing, and then put into the printing process. The lithographic printing plate precursor suitable for this sort of simplified development, implemented without the post-water washing, necessarily has an image recording layer soluble into a process solution not so strongly alkaline, and the support thereof necessarily has a hydrophilic surface in view of improving staining resistance of the non-image-forming area.

These sorts of lithographic printing plate precursors have been disclosed, for example, in JP-A-2007-118579 and JP-A-2007-72308. JP-A-2007-118579 discloses a lithographic printing plate precursor containing a copolymer having (a1) ((meth)acrylic) co-repeating unit having at least one ethylenic unsaturated bond, and (a2) a copolymer having at least one functional group interactive with the surface of a support.

On the other hand, JP-A-2007-72308 discloses a lithographic printing plate precursor having the polymer shown below contained in an undercoat layer.

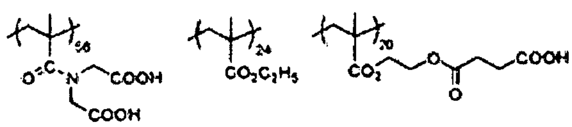

EP 1 767 352 A2 describes a lithographic printing plate precursor inter alia comprising a copolymer containing

a repeating unit having at least one ethylenically unsaturated bond and a repeating unit having at least one functional group capable of interacting with a surface oft he support. JP 2005-234385 A describes a photopolymerizable composition and a lithographic printing plate precursor excellent in printing durability and image forming property. The composition contains binder polymer having a specific repeating unit, a sensitizing dye having an absorption maximum at a wavelength of 300 - 600 nm, a polymerization initiator and a polymerizable compound.

SUMMARY OF THE INVENTION

In this situation, the present inventors found out from our investigations that both of the lithographic printing plate precursors disclosed in JP-A-2007-118579 and JP-A-2007-72308 are still insufficient in the staining resistance. The present invention is directed to solve the problem in the prior art, and an object thereof is to provide a lithographic printing plate precursor excellent in the staining resistance, while keeping the printing durability at a high level, and a method of manufacturing a lithographic printing plate. It is another object of the present invention to provide a lithographic printing plate precursor also excellent in the quality of coated surface.

In this situation, the present inventors found out that, by adopting, as a polymer for composing the undercoat layer, a copolymer having introduced therein a repeating unit derived from a (meth)acrylate-type iminodiacetic acid monomer, and a repeating unit having an ethylenic unsaturated bond in the side chain thereof, interaction of the layer with a material composing the image recording layer may be enhanced, and that the printing durability may be improved while also improving the hydrophilicity. As has been described in paragraph [0006] in JP-A-2007-72308, it was difficult to incorporate the repeating unit having in the side chain thereof an ethylenic unsaturated bond for the purpose of improving the printing durability, because of the trade-off with developability. In contrast, by combining the repeating unit having an ethylenic unsaturated bond in the side chain thereof, with the repeating unit derived from a (meth)acrylate-type iminodiacetic acid monomer, the above-described problems were found to be solved, and the fact led us to complete the present invention.

More specifically, the subject of the present invention was solved by the embodiments described below.

[1] A lithographic printing plate precursor having, on a support, an undercoat layer and an image recording layer stacked in this order, the undercoat layer containing a polymer (A) containing a repeating unit (a1) represented by the formula (O), and a repeating unit (a2) having an ethylenic unsaturated bond in the side chain thereof:

Formula (O)

(0) 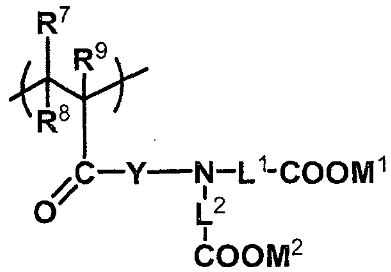

(in the formula (O), each of $R^7$ to $R^9$ independently represents a hydrogen atom, halogen atom, or methyl group, Y represents a single bond, or a divalent linking group which may have a substituent, each of $L^1$ and $L^2$ independently represents a single bond, or a divalent linking group which may have a substituent, $L^1$ or the substituent on $L^1$, and $L^2$ or the substituent on $L^2$ may combine with each other to form a ring. Each of $M^1$ and $M^2$ independently represents a hydrogen atom or monovalent metal ion or ammonium.)

[2] The lithographic printing plate precursor of [1], wherein the polymer (A) further contains a repeating unit having a hydrophilic group (a3) in the side chain thereof.

[3] The lithographic printing plate precursor of [2], wherein the repeating unit having a hydrophilic group (a3) in the side chain thereof is a repeating unit derived from a (meth)acrylic monomer.

[4] The lithographic printing plate precursor of [2] or [3], wherein the repeating unit having a hydrophilic group (a3) in the side chain thereof has structure (s) represented by the formula formulae (a3-1) and/or (a3-2) below, in the side chain thereof:

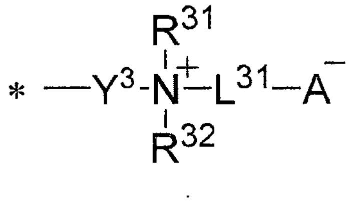

(a3-1)

(in the formula (a3-1), each of $R^{31}$ and $R^{32}$ independently represents a hydrogen atom, alkyl group, alkenyl group, alkynyl group, aryl group, or heterocyclic group, $R^{31}$ and $R^{32}$ may combine to form a ring, $L^{31}$ represents a divalent linking group, and $A^-$ represents a structure having an anion. $Y^3$ represents a single bond or a divalent linking group which may have a substituent. * represents a connector.)

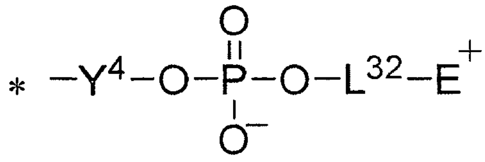

(a3-2)

(in the formula (a3-2), $L^{32}$ represents a divalent linking group, and $E^+$ represents a structure having a cation. $Y^4$ represents a single bond or a divalent linking group which may have a substituent. * represents a connector.)

[5] The lithographic printing plate precursor of [4], wherein the repeating unit having a hydrophilic group (a3) in the side chain thereof is represented by the formula (a3-3) below:

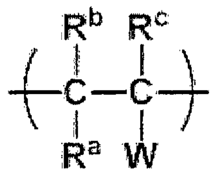

(a3-3)

(in the formula (a3-3), each of $R^a$ to $R^c$ independently represents a hydrogen atom, $C_{1-6}$ alkyl group or halogen atom. W represents a structure represented by the formula (a3-1) or formula (a3-2), and is bound to a carbon atom at the position indicated by * in the formula (a3-1) or formula (a3-2).)

[6] The lithographic printing plate precursor of any one of [1] to [5], wherein the repeating unit (a2) having an ethylenic unsaturated bond in the side chain thereof is a repeating unit derived from a (meth)acrylic monomer.

[7] The lithographic printing plate precursor of any one of [1] to [5], wherein the repeating unit (a2) having an ethylenic unsaturated bond in the side chain thereof is represented by the formula (a2-1):

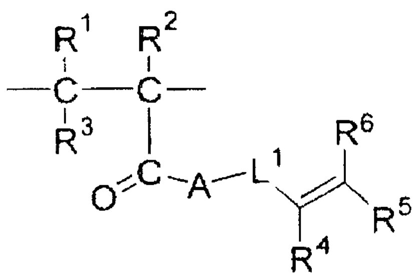

(a2-1)

(in the formula (a2-1), each of $R^1$ to $R^3$ independently represents a hydrogen atom, $C_{1-6}$ alkyl group, or halogen atom. Each of $R^4$ to $R^6$ independently represents a hydrogen atom, $C_{1-6}$ alkyl group, halogen atom, acyl group, or acyloxy group. $R^4$ and $R^5$, or $R^5$ and $R^6$, may combine to form a ring. "A" represents an oxygen atom or $NR^7$-, $R^7$

represents a hydrogen atom or $C_{1-10}$ monovalent hydrocarbon group. $L^1$ represents a single bond or a divalent linking group which may have a substituent.)

[8] The lithographic printing plate precursor of any one of [1] to [7], wherein each of $L^1$ and $L^2$ independently represents a single bond, alkylene group which may have a substituent, cycloalkylene group which may have a substituent, or arylene group which may have a substituent, $L^1$ or the substituent on $L^1$, and $L^2$ or the substituent on $L^2$ may combine with each other to form a ring.

[9] The lithographic printing plate precursor of any one of [1] to [8], wherein Y in the formula (O) is a single bond, or, a divalent linking group selected from the group consisting of -CO-, -O-, -NH-, divalent aliphatic group, divalent aromatic group and arbitrary combinations of them.

[10] The lithographic printing plate precursor of any one of [1] to [9], wherein the image recording layer of the lithographic printing plate precursor is removable with an aqueous solution of pH2 to 10.

[11] The lithographic printing plate precursor of any one of [1] to [10], wherein the image recording layer of the lithographic printing plate precursor is removable with at least either of a printing ink and dampening solution.

[12] A method of manufacturing a lithographic printing plate comprising exposing the lithographic printing plate precursor described in any one of [1] to [11] to light in a pattern-wise manner; and removing an unexposed portion of the image recording layer of the lithographic printing plate precursor under the presence of a developer of pH2 to 10.

[13] The method of manufacturing a lithographic printing plate of [12], further comprising forming a protective layer on the surface of the support opposite to the surface having the image recording layer formed thereon,

wherein the developing process further comprises removing an unexposed portion of the image recording layer together with the protective layer under the presence of the developer further containing a surfactant (but excluding the water washing process).

[14] A method of manufacturing the lithographic printing plate comprising:

exposing the lithographic printing plate precursor described in any one of [1] to [11] to light in a pattern-wise manner; and

removing, on-machine, an unexposed portion of the image recording layer while feeding a printing ink and a dampening solution.

According to the present invention, it became possible to provide a lithographic printing plate precursor capable of ensuring a good quality of coated surface, and is excellent in the staining resistance while keeping a high level of printing durability, and a method of manufacturing such lithographic printing plate.

BRIEF DESCRIPTION OF THE DRAWINGS

FIG. 1 is an explanatory drawing illustrating an exemplary configuration of an automatic processor; and

FIG. 2 is an explanatory drawing illustrating another exemplary configuration of the automatic processor.

BEST MODE FOR CARRYING OUT THE INVENTION

The present invention will be detailed below. Note that, in this specification, the term "to" used together with the preceding and succeeding numerals will indicate a numerical range including the numerals as the lower limit value and the upper limit value, respectively.

In this specification, all notation of groups in the compounds represented by the formulae, without special comment of "substituted" or "unsubstituted", will be understood to embrace not only unsubstituted groups but also groups having substituent group(s) unless otherwise specifically noted, so long as they can structurally have additional substituent group(s). For example, the description of "R represents an alkyl group, aryl group or heterocyclic group" means that "R represents an unsubstituted alkyl group, substituted alkyl group, unsubstituted aryl group, substituted aryl group, unsubstituted heterocyclic group or substituted heterocyclic group".

[Lithographic Printing Plate Precursor]

The lithographic printing plate precursor of the present invention has, on a support, an undercoat layer and an image recording layer stacked in this order. The undercoat layer contains a polymer (A) containing a repeating unit (a1) represented by the formula (O), and a repeating unit (a2) having an ethylenic unsaturated bond in the side chain thereof.

Formula (O)

(0) 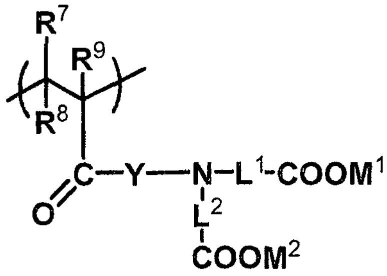

(In the formula (O), each of $R^7$ to $R^9$ independently represents a hydrogen atom, halogen atom, or methyl group, Y represents a single bond, or a divalent linking group which may have a substituent, each of $L^1$ and $L^2$ independently represents a single bond, or a divalent linking group which may have a substituent, $L^1$ or the substituent on $L^1$, and $L^2$ or the substituent on $L^2$ may combine with each other to form a ring. Each of $M^1$ and $M^2$ independently represents a hydrogen atom or monovalent metal ion or ammonium.)

In the undercoat layer, the polymer containing a repeating unit having at least one functional group interactive with the surface of the support is used. A repeating unit derived from iminodiacetic acid monomer has been known as an exemplary repeating unit having at least one functional group interactive with the surface of the support. The known repeating unit derived from iminodiacetic acid monomer was, however, of styrene type. The present invention succeeded in reducing hydrophobicity and improving the staining resistance, by replacing the styrene-type iminodiacetic acid monomer with (meth)crylate-type iminodiacetic acid monomer. The present invention also succeeded in improving the printing durability despite elevating the hydrophilicity, by introducing the (meth) acrylate-type iminodiacetic acid, to thereby enhance the interaction with a material composing the image recording layer. The interaction with the material composing the image recording layer is supposed to be ascribable to a hydrogen bond with the material composing the image recording layer, via an ester or amide bond.

The present invention also succeeded in largely improving the quality of coated surface (nonuniformity in coating). When the polymer containing the repeating unit derived from styrene-type iminodiacetic acid monomer is used, since the polymer coagulates in a coating liquid for forming the undercoat layer (water, or water-methanol mixed solvent), so that the undercoat layer cannot sufficiently cover the support in the process coating and drying. In contrast, the acrylate-type monomer may be suppressed from coagulating, and may therefore be supposed to improve the coverage. This was an unexpected effect, and was not readily reached even by those skilled in the art. This is the basis for claiming the inventive step. Accordingly, a printing plate excellent both in the adhesiveness and hydrophilicity, and excellent in the printing durability and staining resistance may be provided.

<Polymer (A) >

(a1) Repeating Unit Represented by Formula (O)

The polymer (A) used in the present invention contains a repeating unit (a1) represented by the formula (O) :

Formula (O)

(0) 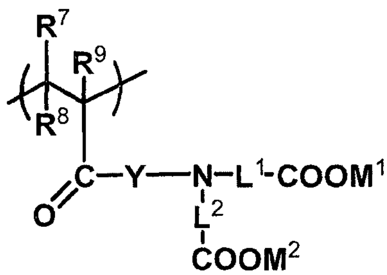

(In the formula (O), each of $R^7$ to $R^9$ independently represents a hydrogen atom, halogen atom, or methyl group, Y represents a single bond, or a divalent liking group which may have a substituent, each of $L^1$ and $L^2$ independently represents a single bond or a divalent linking group which may have a substituent. $L^1$ or the substituent on $L^1$, and $L^2$

or the substituent on $L^2$ may combine with each other to form a ring. Each of $M^1$ and $M^2$ independently represents a hydrogen atom or monovalent metal ion or ammonium.)

When $R^7$ to $R^9$ represents a halogen atom, the halogen atom is preferably a fluorine atom or chlorine atom.

It is preferable that each of $R^7$ to $R^9$ independently represents a hydrogen atom or methyl group. Each of $R^7$ and $R^8$ is preferably represents a hydrogen atom.

When Y represents a divalent linking group, the divalent linking group is preferably selected from the group consisting of -CO-, -O-, -NH-, divalent aliphatic group, divalent aromatic group and arbitrary combinations of them, more preferably selected from the group consisting of -O-, divalent aliphatic group, divalent aromatic group and arbitrary combinations of them, and still more preferably selected from the group consisting of -O-, divalent aliphatic group and arbitrary combinations of them.

The divalent aliphatic group herein means an alkylene group, substituted alkylene group, alkenylene group, substituted alkenylene group, alkynylene group, substituted alkynylene group or polyalkylenoxy group. Among them, preferable examples include alkylene group, substituted alkylene group, alkenylene group, substituted alkenylene group, and polyalkylenoxy group, and more preferable examples include alkylene group, substituted alkylene group and polyalkylenoxy group. The divalent aliphatic group preferably has a chain-like structure rather than a cyclic structure, and more preferably has a straight-chain structure rather than a branched structure. The number of the carbon atoms of the divalent aliphatic group is preferably 1 to 20, more preferably 1 to 15, still more preferably 1 to 12, furthermore preferably 1 to 10, particularly 1 to 8, and most preferably 1 to 4.

Examples of the substituent on the divalent aliphatic group include halogen atom (F, Cl, Br, I), hydroxy group, carboxy group, amino group, cyano group, aryl group, alkoxy group, aryloxy group, monoalkylamino group, dialkyl amino group, arylamino group and diarylamino group.

Examples of the divalent aromatic group include phenylene group, substituted phenylene group, naphthalene group and substituted naphthalene group, among which phenylene group is preferable. Examples of the substituent on the divalent aromatic group include alkyl group, in addition to those exemplified as the substituent on the divalent aliphatic group.

Y preferably represents a single bond, or a divalent linking group selected from the group consisting of -O-, divalent aliphatic group, and arbitrary combinations of them. Single bond is more preferable.

When each of $L^1$ and $L^2$ represents a divalent linking group, the divalent linking group is preferably selected from the group consisting of -CO-, -O-, -NH-, divalent aliphatic group, divalent aromatic group and arbitrary combinations of them. Preferable examples thereof are same as those exemplified for Y.

Each of $L^1$ and $L^2$ is preferably a single bond, an alkylene group which may have a substituent, a cycloalkylene which may have a substituent, or an arylene group which may have a substituent. Examples of the substituent possibly bound to the alkylene group or to the cycloalkylene group are same as those exemplified for the divalent aliphatic group. Examples of the substituent possibly bound to the arylene group are same as those exemplified for the divalent aromatic group.

Each of $L^1$ and $L^2$ preferably has 1 to 10 carbon atoms, and more preferably 1 to 7 carbon atoms, when each of them represents an alkylene group which may have a substituent, cycloalkylene group which may have a substituent, or arylene group which may have a substituent.

Each of $L^1$ and $L^2$ independently represents a single bond, $C_{1-3}$ alkylene group, cyclohexene group, or phenylene group, wherein single bond or $C_{1-3}$ alkylene group are more preferable, and $C_{1-2}$ alkylene group is particularly preferable.

Examples of the monovalent metal ion represented by $M^1$ and $M^2$ include lithium ion, sodium ion, and potassium ion, wherein each of $M^1$ and $M^2$ preferably represents a hydrogen atom, sodium ion or potassium ion, and more preferably represents a hydrogen atom or sodium ion.

Preferable examples of the repeating unit represented by the formula (O) will be shown below. It is to be understood, of course, that the present invention is not limited thereto. In the formulae, Bu represents a *n*-butyl group.

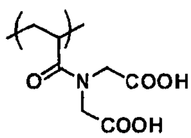
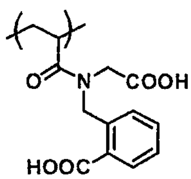
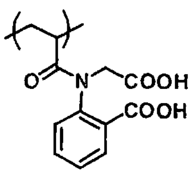
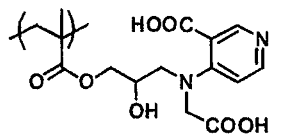

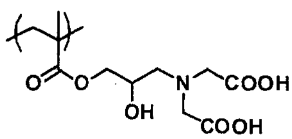
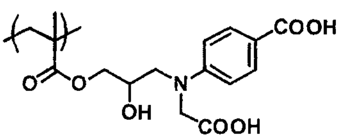
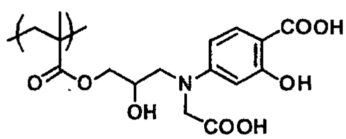

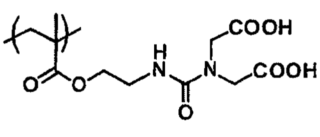
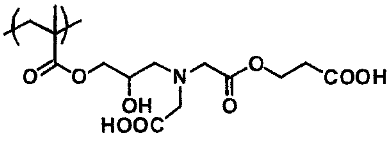
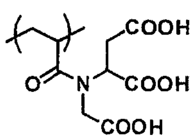

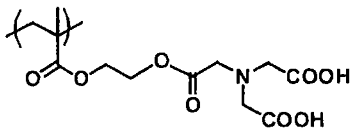
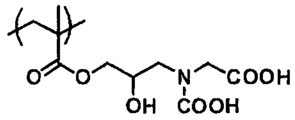
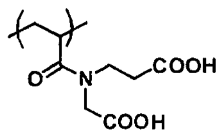

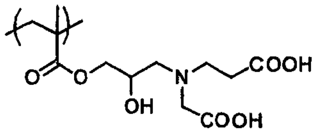,
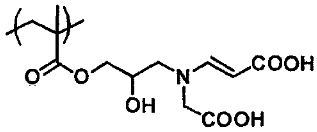
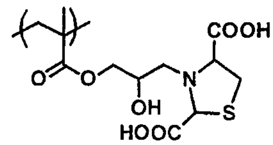

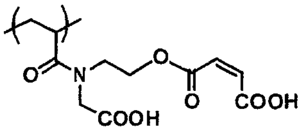
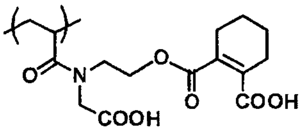
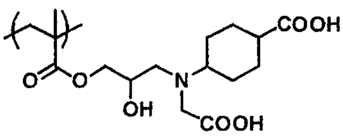

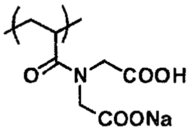
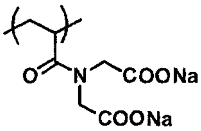
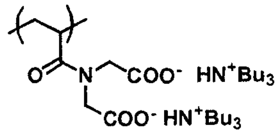

In the polymer (A) in the present invention, the content of the repeating unit represented by the formula (O) is preferably 1 to 99 mol%, more preferably 20 to 95 mol%, and still more preferably 40 to 90 mol%. The content in these ranges helps more effective expression of the effect of the present invention.

(a1-2) Repeating Unit Having in Side Chain Thereof Structure Interactive with Surface of Support

The polymer (A) used in the present invention may contain, in addition to the repeating unit (a1) described in the above, other repeating unit having in the side chain thereof a structure interactive with the surface of the support. Examples of the other repeating unit having in the side chain thereof a structure interactive with the surface of the support include those having, in the side chain thereof, one or more species of structures represented by the formulae (a1-1) to (a1-5) below:

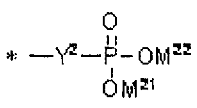
(a1-1)

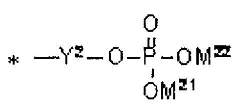
(a1-2)

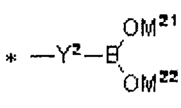
(a1-3)

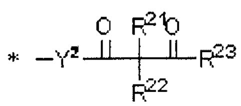
(a1-4)

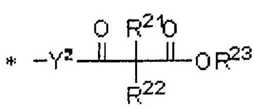
(a1-5)

[In the formulae (a1-1), (a1-2), (a1-3), (a1-4) and (a1-5), each of $M^{21}$ and $M^{22}$ independently represents a hydrogen atom, metal atom which belongs to alkali metal or alkali earth metal, or, ammonium. Each of $R^{21}$ to $R^{23}$ independently

represents a hydrogen atom, or, alkyl group. $Y^2$ represents a single bond, or, a divalent linking group selected from the group consisting of -CO-, -O-, -NH-, divalent aliphatic group, divalent aromatic group, and arbitrary combinations of them. * represents a site bound to the principal chain of the polymer compound.]

Examples of the alkyl group represented by each of $R^{21}$ to $R^{23}$ include methyl group, ethyl group, propyl group, octyl group, isopropyl group, *tert*-butyl group, isopentyl group, 2-ethylhexyl group, 2-methylhexyl group, and cyclopentyl group.

Each of $R^{21}$ to $R^{23}$ is preferably a hydrogen atom or methyl group.

$Y^2$ represents a single bond, or, a divalent linking group selected from the group consisting of -CO-, -O-, -NH-, divalent aliphatic group, divalent aromatic group and arbitrary combinations of them.

Specific examples of $Y^2$ composed of the arbitrary combinations are as follow. In the examples listed below, the left-hand side of each formula is bound to the principal chain.

- $L^1$-: -CO-O-divalent aliphatic group-
- $L^2$-: -CO-O-divalent aromatic group-
- $L^3$-: -CO-NH-divalent aliphatic group-
- $L^4$-: -CO-NH-divalent aromatic group-

The divalent aliphatic group herein means an alkylene group, substituted alkylene group, alkenylene group, substituted alkenylene group, alkynylene group, substituted alkynylene group or polyalkylenoxy group. Among them, alkylene group, substituted alkylene group, alkenylene group, and substituted alkenylene group are preferable, and alkylene group and substituted alkylene group are more preferable.

The divalent aliphatic group has a chain-like structure rather than a cyclic structure, and more preferably has a straight-chain structure rather than a branched structure. The number of carbon atoms of the divalent aliphatic group is preferably 1 to 20, more preferably 1 to 15, still more preferably 1 to 12, furthermore preferably 1 to 10, particularly 1 to 8, and most preferably 1 to 4.

Examples of the substituent on the divalent aliphatic group include halogen atom (F, Cl, Br, I), hydroxy group, carboxy group, amino group, cyano group, aryl group, alkoxy group, aryloxy group, acyl group, acyloxy group, monoalkylamino group, dialkyl amino group, arylamino group and diarylamino group.

Examples of the divalent aromatic group include phenylene group, substituted phenylene group, naphthalene group and substituted naphthalene group, wherein phenylene group is preferable.

Examples of the substituent on the divalent aromatic group, other than the substituents on the divalent aliphatic group described in the above, include alkyl group.

$Y^2$ preferably represents a single bond, divalent aromatic group, -$L^1$-, -$L^2$-, -$L^3$- or -$L^4$-, wherein single bond, -$L^1$- and -$L^2$- are most preferable.

From the viewpoint of the staining resistance and printing durability, the structure interactive with the surface of the support is preferably (a1-1) or (a1-2).

Each of $M^{21}$ and $M^{22}$ preferably represents a hydrogen atom.

Specific examples thereof includes the structures shown below, of course without limiting the present invention.

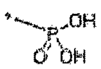
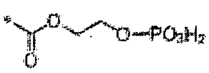
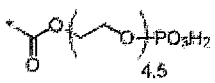
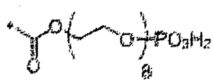
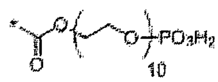

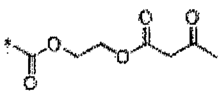
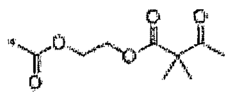

The repeating unit (a1-2) having in the side chain thereof a structure interactive with the surface of the support is preferably a repeating unit derived from a (meth)acrylic monomer.

The other repeating unit (a1-2) having in the side chain thereof a structure interactive with the surface of the support, used in the present invention, is preferably a repeating unit represented by the formula (A2) below:

Formula (A2)

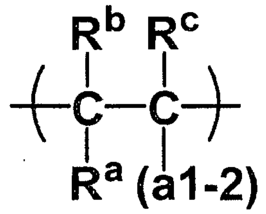

(A2)

In the formula (A2), each of $R^a$ to $R^c$ independently represents a hydrogen atom, $C_{1-6}$ alkyl group or halogen atom.
(a1-2) represents a structure represented by the formulae (a1-1) to (a1-5), and is bound to a carbon atom at the site indicated by * in the formulae (a1-1) to (a1-5).
Content of the repeating unit represented by the formula (A2) is preferably 10 mol% or less of the copolymer of the present invention, more preferably 1 mol% or less, and still more preferably substantially zero. It is particularly preferable that substantially no styrene-type repeating unit derived from iminodiacetic acid monomer is contained therein.

(a2) Repeating Unit Having Ethylenic Unsaturated Bond in Side Chain Thereof

The polymer (A) in the present invention contains the repeating unit having an ethylenic unsaturated bond in the side chain thereof, preferably a repeating unit derived from a (meth)acrylic monomer, and more preferably a repeating unit represented by the formula (a2-1) below:

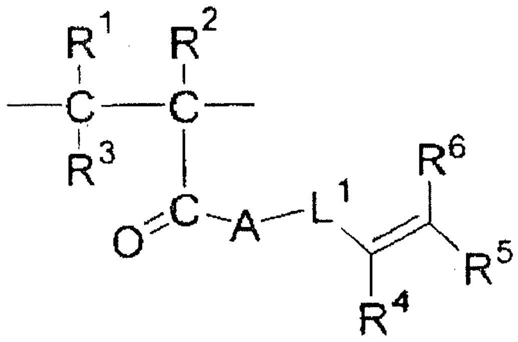

(a2-1)

(In the formula (a2-1), each of $R^1$ to $R^3$ independently represents a hydrogen atom, $C_{1-6}$ alkyl group, or halogen atom. Each of $R^4$ to $R^6$ independently represents a hydrogen atom, $C_{1-6}$ alkyl group, halogen atom, acyl group, or acyloxy group. $R^4$ and $R^5$, or, $R^5$ and $R^6$ may form a ring. "A" represents an oxygen atom or $NR^7$-, and $R^7$ represents a hydrogen atom or $C_{1-10}$ monovalent hydrocarbon group. $L^1$ represents a divalent linking group which may have a substituent.)
When each of $R^1$ to $R^3$ represents a halogen atom, the halogen atom is preferably a fluorine atom or chlorine atom.
Each of $R^1$ to $R^3$ preferably represents a hydrogen atom or methyl group. Each of $R^1$ and $R^3$ preferably represents a hydrogen atom.
When each of $R^4$ to $R^6$ represents a halogen atom, the halogen atom is preferably a fluorine atom or chlorine atom.
Each of $R^4$ to $R^6$ preferably represents a hydrogen atom or methyl group. Each of $R^5$ and $R^6$ preferably represents a hydrogen atom.
It is more preferable that $R^4$ and $R^5$, or, $R^5$ and $R^6$ do not form a ring.
$R^7$ is preferably a hydrogen atom.
$L^1$ represents a divalent liking group which may have a substituent, and more specifically represents a linking group composed of two or more atoms selected from the group consisting of hydrogen atom, carbon atom, oxygen atom, nitrogen atom and sulfur atom. The number of carbon atoms composing the main skeleton of the linking group represented by $L^1$ is preferably 1 to 70, more preferably 1 to 60, still more preferably 1 to 50, and particularly 1 to 20.
Note that the main skeleton of the linking group in the present invention means an atom or atomic group which is used only for linking the "A" in the formula (a2-1) with the terminal ethylenic unsaturated bond. An exemplary structure of the compound represented by the formula (a2-1) in the present invention is shown below, with an indication and a method of counting the number of atoms composing the main skeleton of the linking group represented by $L^1$ in the structure.

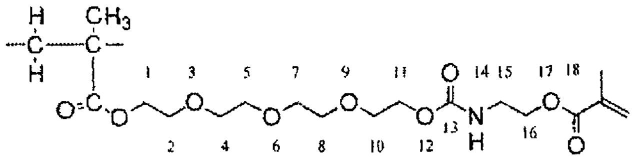

Number of atoms composing main skeleton of linking group

: 18

(a3) Repeating Unit Having Hydrophilic Group in Side Chain Thereof

The polymer (A) used in the present invention may contain, as (a3), a repeating unit having at least one hydrophilic group in the side chain thereof, for the purpose of elevating the hydrophilicity of the surface of the non-image-forming area. The hydrophilic group means those capable of readily forming hydrogen bond, van der Waals bond, or ionic bond to water molecule, and specifically includes hydroxy group, carboxyl group, amino group, sulfo group, group having positive charge or negative charge, zwitter ion group and metal salt thereof.

The repeating unit (a3) having a hydrophilic group in the side chain thereof is preferably a repeating unit derived from a (meth)acrylic monomer.

The polymer used in the present invention preferably has a repeating unit having, in particular, a zwitter ion structure as a hydrophilic group, in order to make the surface of the support in the non-image-forming area highly hydrophilic. It is particularly preferable that the side chain having the zwitter ion structure is represented by the formula (a3-1) or (a3-2) below:

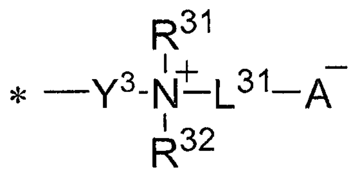

(a3-1)

(In the formula (a3-1), each of $R^{31}$ and $R^{32}$ independently represents a hydrogen atom, alkyl group, alkenyl group, alkynyl group, aryl group, or heterocyclic group, $R^{31}$ and $R^{32}$ may combine with each other to form a cyclic structure, $L^{31}$ represents a divalent linking group, and $A^-$ represents a structure having an anion. $Y^3$ represents a single bond or a divalent linking group which may have a substituent. * represents a connector.)

The cyclic structure possibly formed by combination of $R^{31}$ and $R^{32}$ may have a hetero atom such as oxygen atom, and is preferably a 5 to 10-membered ring, and more preferably a 5 or 6-membered ring.

The number of carbon atoms of $R^{31}$ and $R^{32}$, including the number of atoms of the substituent described later, is preferably 1 to 30, more preferably 1 to 20, still more preferably 1 to 15, furthermore preferably 1 to 8, and particularly 1 to 4.

Examples of the alkyl group represented by $R^{31}$ and $R^{32}$ include methyl group, ethyl group, propyl group, octyl group, isopropyl group, tert-butyl group, isopentyl group, 2-ethylhexyl group, 2-methylhexyl group, and cyclopentyl group.

Examples of the alkenyl group represented by $R^{31}$ and $R^{32}$ include vinyl group, allyl group, prenyl group, geranyl group, and oleyl group.

Examples of the alkynyl group represented by $R^{31}$ and $R^{32}$ include ethynyl group, propargyl group, and trimethylsilylethynyl group.

Examples of the aryl group represented by $R^{31}$ and $R^{32}$ include phenyl group, 1-naphthyl group, and 2-naphthyl group. Examples of the heterocyclic group include furanyl group, thiophenyl group, and pyridinyl group.

Each of these groups may have a substituent. Examples of the substituent include a halogen atom (F, Cl, Br, I), hydroxy group, carboxy group, amino group, cyano group, aryl group, alkoxy group, aryloxy group, acyl group, alkoxycarbonyl group, aryloxycarbonyl group, acyloxy group, monoalkylamino group, dialkyl amino group, monoarylamino group and diarylamino group.

From the viewpoint of effect and availability, particularly preferable examples of each of $R^{31}$ and $R^{32}$ include hydrogen atom, methyl group, and ethyl group.

The divalent linking group linking to the principal chain of the polymer compound represented by $Y^3$ is preferably a single bond, or, a divalent linking group selected from the group consisting of -CO-, -O-, -NH-, divalent aliphatic group, divalent aromatic group and arbitrary combinations of them.

Specific examples of $Y^3$ composed of the arbitrary combinations are as follow. In the examples listed below,

the left-hand side of each formula is bound to the principal chain.

-$L^1$-. -CO-O-divalent aliphatic group-
-$L^2$-: -CO-O-divalent aromatic group-
-$L^3$-: -CO-NH-divalent aliphatic group-
-$L^4$-: -CO-NH-divalent aromatic group-

The divalent aliphatic group herein means an alkylene group, substituted alkylene group, alkenylene group, substituted alkenylene group, alkynylene group, or substituted alkynylene group or polyalkylenoxy group. Among them, preferable examples include alkylene group, substituted alkylene group, alkenylene group and substituted alkenylene group, more preferable examples include alkylene group and substituted alkylene group, and still more preferable examples include unsubstituted alkylene group.

The divalent aliphatic group preferably has a chain-like structure rather than a cyclic structure, and more preferably has a straight-chain structure rather than a branched structure. The number of the carbon atoms of the divalent aliphatic group is preferably 1 to 20, more preferably 1 to 15, still more preferably 1 to 12, furthermore preferably 1 to 10, particularly 1 to 8, and most preferably 1 to 4.

Examples of the substituent on the divalent aliphatic group include halogen atom (F, Cl, Br, I), hydroxy group, carboxy group, amino group, cyano group, aryl group, alkoxy group, aryloxy group, acyl group, acyloxy group, monoalkylamino group, dialkyl amino group, arylamino group and diarylamino group.

Examples of the divalent aromatic group include phenylene group, substituted phenylene group, naphthalene group and substituted naphthalene group. Among them, phenylene group is preferable.

Examples of the substituent on the divalent aromatic group include alkyl group, in addition to the above-described substituents on the divalent aliphatic group.

More preferable examples of $Y^3$ include a single bond, -CO-, divalent aliphatic group, divalent aromatic group, and -$L^1$- to -$L^4$-. From the viewpoint of staining resistance, $Y^3$ is preferably -$L^1$- or $L^3$-, and more preferably -$L^3$-. The divalent aliphatic group in -$L^3$- is preferably $C_{2-4}$ straight-chain alkylene group, and most preferably $C_3$ straight-chain alkylene group from the viewpoint of readiness of synthesis.

$L^{31}$ represents a linking group which is preferably -CO-, -O-, -NH-, divalent aliphatic group, divalent aromatic group and arbitrary combinations of them. $L^{31}$ preferably has the number of carbon atoms of 30 or smaller, including the number of carbon atoms of the substituent possibly bound thereto. Specific examples of the substituent include alkylene group (preferably $C_{1-20}$ alkylene group, more preferably $C_{1-10}$ alkylene group, and still more preferably $C_{2-6}$ alkylene group), and, phenylene group, arylene group such as xylylene group (preferably $C_{5-15}$ arylene group, and more preferably $C_{6-10}$ arylene group). From the viewpoint of staining resistance, $L^{31}$ is preferably $C_{3-5}$ straight-chain alkylene group, more preferably $C_4$ or $C_5$ straight-chain alkylene group, and still more preferably $C_4$ straight-chain alkylene group.

Specific examples of $L^{31}$ include the linking groups listed below:

$-CH_2-$ $-CH_2CH_2-$ $-CH_2CH_2CH_2-$ $-CH_2CH_2CH_2CH_2-$
$-CH_2CH_2CH_2CH_2CH_2-$ $-CH_2CH_2CH_2CH_2CH_2CH_2-$

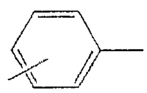 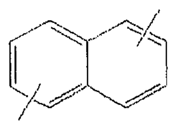 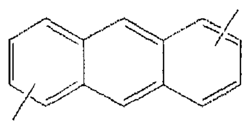

Each of these linking groups may additionally have a substituent.

Examples of the substituent include halogen atom (F, Cl, Br, I), hydroxy group, carboxy group, amino group, cyano group, aryl group, alkoxy group, aryloxy group, acyl group, alkoxycarbonyl group, aryloxycarbonyl group, acyloxy group, monoalkylamino group, dialkyl amino group, monoarylamino group and diarylamino group.

In the formula (a3-1), $A^-$ preferably represents a carboxylate, sulfonate, phosphonate, or phosphinate.

Specific examples of $A^-$ include the anions shown below:

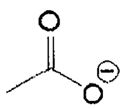 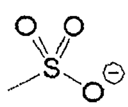 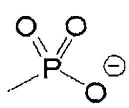 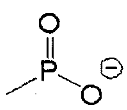

From the viewpoint of staining resistance, $A^-$ is most preferably a sulfonate. In the formula (a3-1), a combination of $L^{31}$ representing a $C_4$ or $C_5$ straight-chain alkylene group and $A^-$ representing a sulfonate is preferable, and a combination of $L^{31}$ representing a $C_4$ straight-chain alkylene group and $A^-$ representing a sulfonate is most preferable.

A combination of $Y^3$ representing $-L^1-$ or $L^3-$, each of $R^{31}$ and $R^{32}$ independently representing an ethyl group or methyl group, $L^{31}$ representing a $C_4$ or $C_5$ straight-chain alkylene group, and $A^-$ representing a sulfonate group is preferable.

Moreover, a combination of $Y^3$ representing $-L^3-$, each of $R^{31}$ and $R^{32}$ independently representing a methyl group, $L^{31}$ representing a $C_4$ straight-chain alkylene group, and $A^-$ representing a sulfonate is more preferable.

More specifically, those represented by the formulae below are preferable:

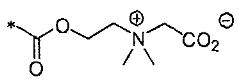
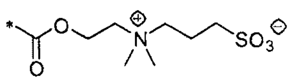
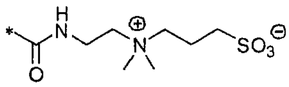

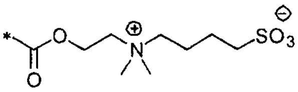
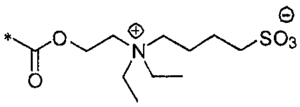
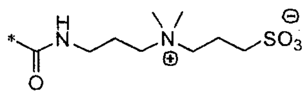

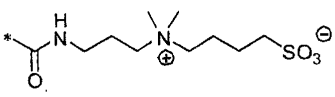
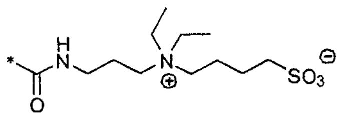
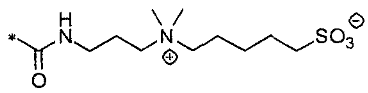

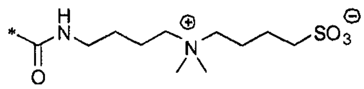
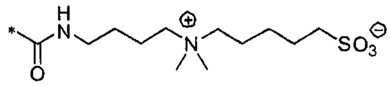

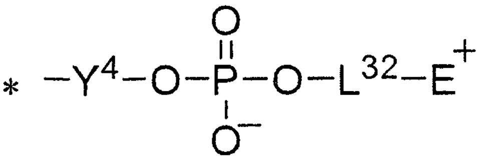

(a3-2)

(In the formula (a3-2), $L^{32}$ represents a divalent linking group, and $E^+$ represents a structure having a cation. $Y^4$ represents a single bond or a divalent linking group which may have a substituent. * represents a connector.)

In the formula (a3-2), $L^{32}$ represents a linking group, and preferably -CO-, -O-, -NH-, divalent aliphatic group, divalent aromatic group and arbitrary combinations of them.

$L^{32}$ represents a linking group, and preferably -CO-, -O-, -NH-, divalent aliphatic group, divalent aromatic group and arbitrary combinations of them. The number of carbon atoms of $L^{32}$ is preferably 30 or smaller, including the number of carbon atoms of the substituent possibly bound thereto. Specific examples of the substituent include an alkylene group (preferably $C_{1-20}$ alkylene group, more preferably $C_{1-10}$ alkylene group, more preferably $C_{2-6}$ alkylene group), and, arylene group such as phenylene group, xylylene group (preferably $C_{5-15}$ arylene group, and more preferably $C_{6-10}$ arylene group). From the viewpoint of staining resistance, $L^{32}$ is preferably a $C_{1-5}$ straight-chain alkylene group, and more preferably $C_{1-3}$ straight-chain alkylene group.

Specific examples of $L^{32}$ include the linking groups shown below:

$-CH_2-$ $-CH_2CH_2-$ $-CH_2CH_2CH_2-$ $-CH_2CH_2CH_2CH_2-$

$-CH_2CH_2CH_2CH_2CH_2-$ $-CH_2CH_2CH_2CH_2CH_2CH_2-$

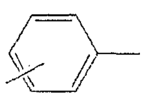
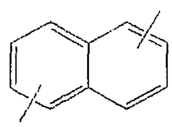
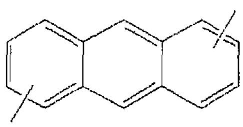

These linking groups may have an additional substituent.

Examples of the substituent include halogen atom (F, Cl, Br, I), hydroxy group, carboxy group, amino group, cyano group, aryl group, alkoxy group, aryloxy group, acyl group, alkoxycarbonyl group, aryloxycarbonyl group, acyloxy

group, monoalkylamino group, dialkyl amino group, monoarylamino group and diarylamino group.

$Y^4$ is synonymous to $Y^3$ in the formula (a3-1), representing the same preferable range.

$E^+$ represents a structure having a cation, preferably represents a structure having ammonium, phosphonium, iodonium, or sulfonium. $E^+$ more preferably represents a structure having ammonium or phosphonium, and particularly a structure having ammonium. Examples of the structure having a cation include trimethylammonio group, triethylammonio group, tributylammonio group, benzyl dimethylammonio group, diethylhexylammonio group, (2-hydroxyethyl)dimethylammonio group, pyridinio group, N-methylimidazolio group, N-acrydinio group, trimethylphosphonio group, triethylphosphonio group, and triphenylphosphonio group.

In more preferable examples of combinations of $L^{32}$, $Y^4$ and $E^+$, $L^{32}$ represents a $C_{2-4}$ alkylene group, $Y^4$ represents $-L^1-$ or $L^3-$, and $E^+$ represents a trimethylammonio group or triethylammonio group.

Specific examples of the structure include the followings:

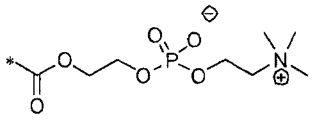
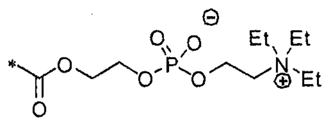
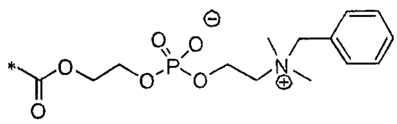

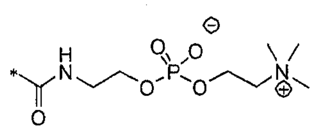
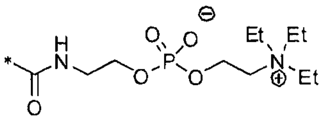
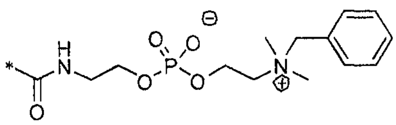

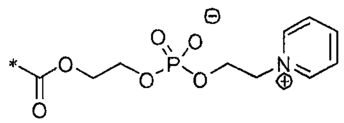
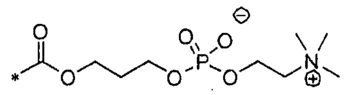
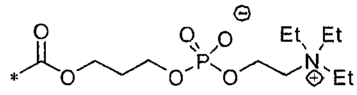

In the present invention, it is preferable that the repeating unit (a3) having a hydrophilic group in the side chain thereof is specifically represented by the formula (a3-3) below:

Formula (a3-3)

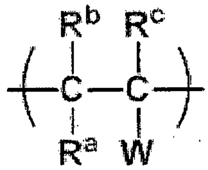 (a3-3)

(In the formula (a3-3), each of $R^a$ to $R^c$ independently represents a hydrogen atom, $C_{1-6}$ alkyl group or halogen atom. W represents a structure represented by the formula (a3-1) or formula (a3-2), and is bound to a carbon atom at the site indicated by * in the formula (a3-1) or formula (a3-2).)

It is preferable that each of $R^a$ to $R^c$ independently represents a hydrogen atom or methyl group. Each of $R^a$ and $R^b$ preferably represents a hydrogen atom.

In the polymer used in the present invention, ratio of the repeating unit (a3) having the structure represented by the formula (a3-1) or formula (a3-2) is preferably 1 to 70 mol% of the total repeating unit, from the viewpoint of the staining resistance and developability, and more preferably 1 to 50 mol%, and still more preferably 1 to 30 mol%.

The polymer (A) may be a copolymer having other repeating unit besides the above-described repeating units. Examples of the monomers copolymerizable to the polymer include those selected from acylic esters, methacrylic esters, N,N-disubstituted acrylamides, N,N-disubstituted methacrylamides, styrenes, acrylonitriles, and methacrylonitriles. Content of the other repeating unit is preferably 20 mol% or less of the polymer (A).

Specific examples thereof include acrylic esters such as alkyl acrylates preferably having a $C_{1-20}$ alkyl group (more specifically, for example, methyl acrylate, ethyl acrylate, propyl acrylate, butyl acrylate, amyl acrylate, ethylhexyl acrylate, octyl acrylate, tert-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate, and tetrahydrofurfuryl acrylate); aryl acrylates (for example, phenyl acrylate); methacrylic

esters such as alkyl methacrylates preferably having a $C_{1-20}$ alkyl group (for example, methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate, and tetrahydrofurfuryl methacrylate); aryl methacrylates (for example, phenyl methacrylate, cresyl methacrylate, and naphthyl methacrylate); styrenes such as styrene and alkyl styrene (for example, methylstyrene, dimethylstyrene, trimethylstyrene, ethylstyrene, diethylstyrene, isopropylstyrene, butylstyrene, hexylstyrene, cyclohexylstyrene, decylstyrene, benzyl styrene, chloromethylstyrene, trifluoromethylstyrene, ethoxymethylstyrene, and acetoxymethylstyrene); alkoxystyrenes (for example, methoxystyrene, 4-methoxy-3-methylstyrene, and dimethoxystyrene); halogen-containing styrenes (for example, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, and 4-fluoro-3-trifluoromethylstyrene); acrylonitrile, methacrylonitrile, methacrylic acid, acrylic acid, and 2-acrylamide-2-methylpropane sulfonate.

It is particularly preferable that the polymer (A) in the present invention contains a repeating unit, as the other repeating unit, having in the side chain thereof an alkyl ether chain composed of $-(CH_2)_n-O-$, where n is an integer of 1 to 4, repeated 2 to 150 times, and more preferably 9 to 150 times from the viewpoint of staining resistance, still more preferably 9 to 100 times, furthermore preferably 20 to 100 times, and particularly 50 to 100 times. The other repeating unit preferably has a structure represented by the formula below:

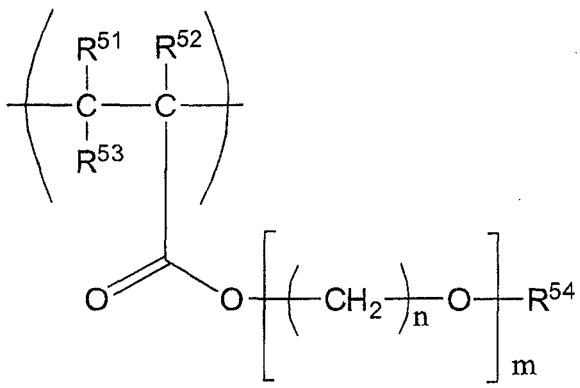

In the formula, each of $R^{51}$ to $R^{53}$ independently represents a hydrogen atom, $C_{1-6}$ alkyl group or halogen atom, wherein hydrogen atom or methyl group is preferable. $R^{54}$ represents a hydrogen atom or $C_{1-6}$ alkyl group, wherein hydrogen atom, methyl group or ethyl group is more preferable. n represents an integer from 1 to 4, and is preferably an integer of 2 or 3. m represents an integer from 2 to 150, and more preferably from 9 to 150 from the viewpoint of staining resistance, still more preferably from 9 to 100, furthermore preferably from 20 to 100, and particularly from 50 to 100.

By using the polymer (A) having such repeating unit for the undercoat layer of the lithographic printing plate precursor of the on-machine developable type, a good on-machine development property may be achieved. The content of the repeating unit having the alkyl ether chain in the side chain thereof is preferably 0 to 20 mol% of the polymer (A).

Mass average molar mass (Mw) of the polymer (A) may arbitrarily be set depending on performance design of the lithographic printing plate precursor. From the viewpoint of the printing durability and staining resistance, the mass average molar mass is preferably 2,000 to 1,000,000, more preferably 2,000 to 500,000, and most preferably 8,000 to 300,000.

In the polymer (A) used in the present invention, the total content of the repeating unit represented by the formula (O), the repeating unit represented by the formula (A2), and the repeating unit represented by the formula (a3-3) accounts for 80 mol% or more of the polymer (A), and more preferably 90 mol% or more.

The polymer newly disclosed by the present invention is exemplified by the polymers below:

(1) a copolymer containing the repeating unit (a1) represented by the formula (O) and the repeating unit (a2) represented by the formula (a2-1); and

(2) a polymer of (1) described in the above, further containing in the side chain thereof a hydrophilic group (a3) having in the side chain thereof a structure represented by the formula (a3-1) and/or (a3-2).

Examples of the polymer (A) used in the present invention will be shown below, of course without limiting the present invention. The content of each repeating unit is expressed in molar ratio.

(P-1) Mw=90,000 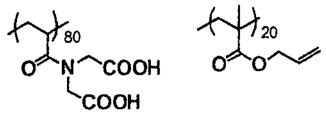

(P-2) Mw=80,000 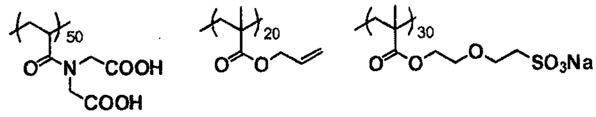

(P-3) Mw=110,000 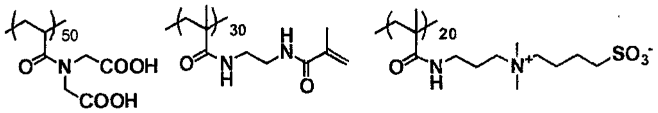

(P-4) Mw=130,000 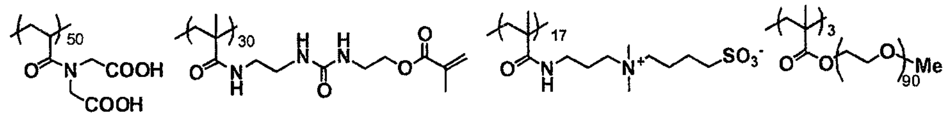

(P-5) Mw=60,000 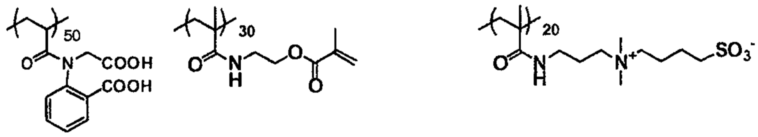

(P-6) Mw=30,000 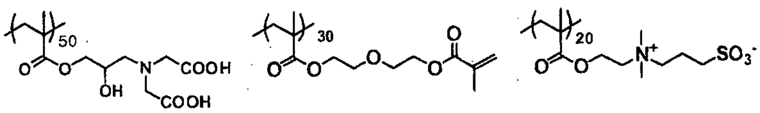

(P-7) Mw=50,000 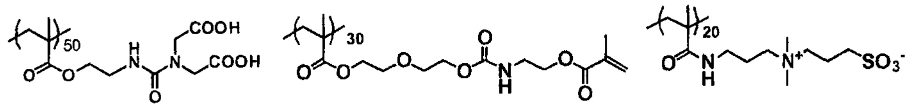

(P-8) Mw=100,000 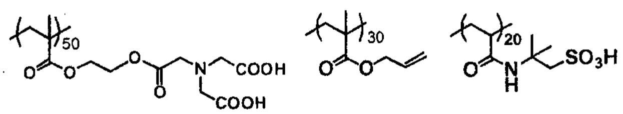

(P-9) Mw=90,000 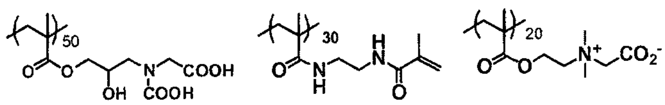

(P-10) Mw=40,000 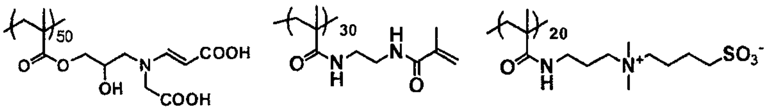

(P-11) Mw=40,000 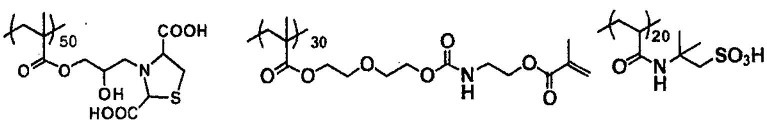

(P-12) Mw=20,000 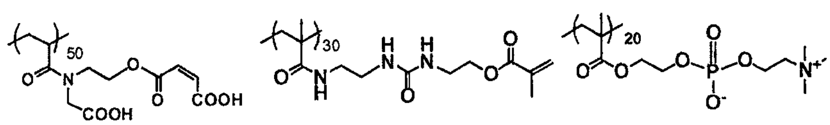

(P-13) Mw=100,000 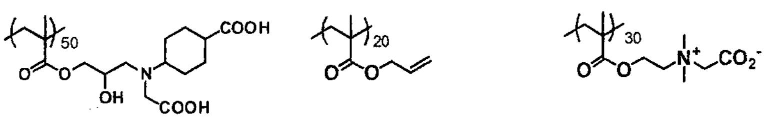

(P-14) M±140,000 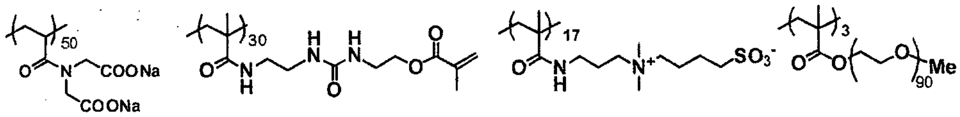

(continued)

(P-15) Mw=70,000

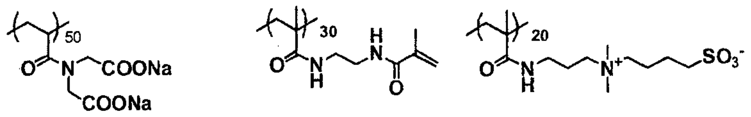

(P-16) Mw=80,000

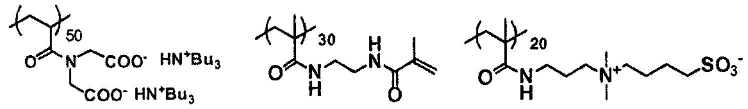

(P-17) Mw=110,000

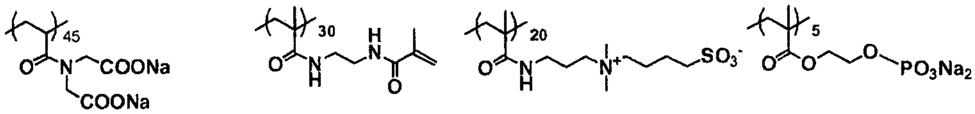

(P-18) Mw=40,000

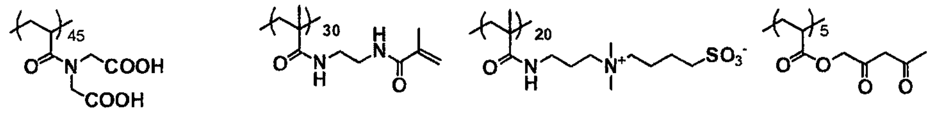

(P-19) Mw=10,000

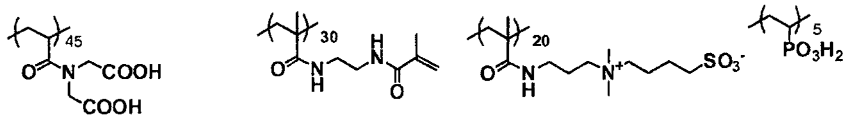

(P-20) Mw=110,000

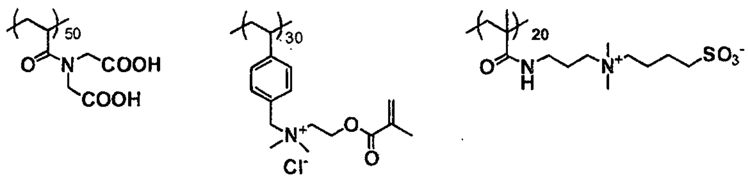

(P-21) Mw=100,000

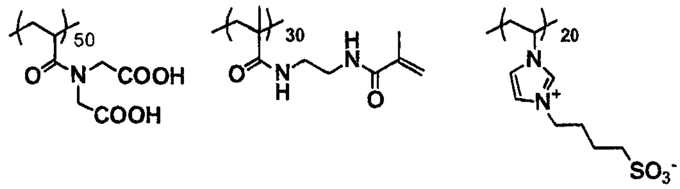

(P-22) Mw=70,000

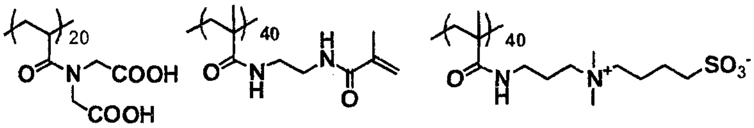

(P-23) Mw=7,000

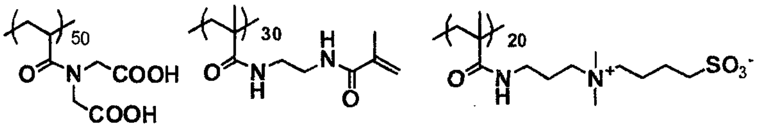

(P-24) Mw=13,000

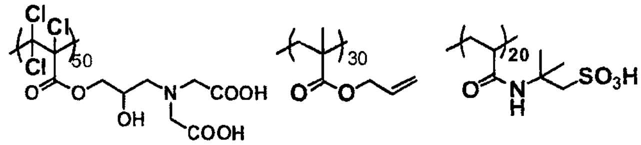

(P-25) Mw=90,000

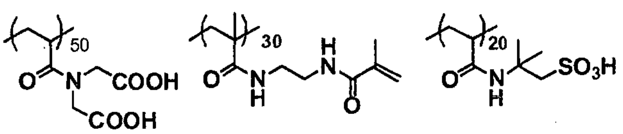

(P-26) Mw=120,000

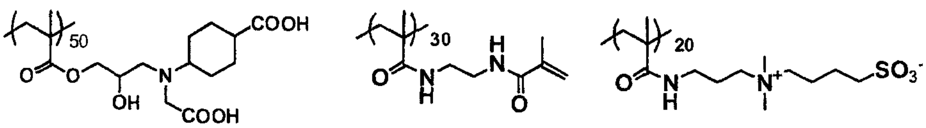

<<Method of Preparing Polymer (A)>>

While the polymer (A) may also be synthesized by known methods, preferably used for the synthesis is radical polymerization, followed by urea forming reaction between amino groups in the side chains of the polymer and a radical polymerizable group of an isocyanate compound.

General methods of radical polymerization are described in "Shin Kobunshi Jikkengaku (New Experimental Course in Polymer Science) 3", edited by The Society of Polymer Science, Japan, published by Kyoritsu Shuppan Co. Ltd., March 28, 1996), "Kobunshi no Gosei to Hanno (Syntheses and Reactions of Polymers) 1", edited by The Society of Polymer Science, Japan, published by Kyoritsu Shuppan Co. Ltd., May, 1992), "Shin Jikken Kagaku Koza (New Course in Experimental Chemistry) 19, Kobunshi Kagaku (Polymer Science) (I) (edited by The Chemical Society of Japan, published by Maruzen Co. Ltd., November 20, 1980,), "Bussitsu Kogaku Koza Kobunshi Gosei Kagaku (The Course of Material Engineering, Polymer Synthetic Chemistry)" (published in September, 1995, by Tokyo Denki University Press, September, 1995) and so forth, all of which adoptable to the present invention.

Preferable embodiments of the lithographic printing plate precursor according to the present invention will be detailed below.

The lithographic printing plate precursor according to the present invention has, on the support, the undercoat layer and the image recording layer stacked in this order. The lithographic printing plate precursor according to the present invention has other arbitrary layer provided between the support and the image recording layer.

The lithographic printing plate precursor according to the present invention preferably has a protective layer on the surface of the image recording layer on the side opposite to the support.

The lithographic printing plate precursor according to the present invention may have, as necessary, a backcoat layer provided on the back surface of the support.

The lithographic printing plate precursor according to the present invention is preferably adoptable to so-called direct plate making by which the plate is made directly based on digital signal output from a computer or the like using various types of laser. The original plate is also preferably developable with an aqueous solution of pH2 to 14, more preferably pH3.5 to 13, and most preferably pH6 to 13, or developable on press.

The constitutive layers composing the lithographic printing plate precursor according to the present invention will be explained in sequence, and also a method of manufacturing the lithographic printing plate precursor according to the present invention will be explained below.

<Undercoat Layer>

The undercoat layer of the lithographic printing plate precursor according to the present invention contains the polymer (A).

The undercoat layer may be provided by a method of coating a solution, prepared by dissolving the compound into water, or organic solvent such as methanol, ethanol, methyl ethyl ketone, or mixed solvent of them, over a support and then drying it; or, a method of dipping the support into a solution, prepared by dissolving the compound into water, or organic solvent such as methanol, ethanol, methyl ethyl ketone, or mixed solvent of them, so as to allow the compound to adsorb onto the support, and then by washing and drying the support. In the former method, the solution containing 0.005 to 10% by mass of the above-described compound may be coated by various methods.

Method of coating may be any of bar coater coating, spin coating, spray coating, curtain coating and so forth. On the other hand, in the latter method, the solution preferably has a concentration of 0.01 to 20% by mass, and more preferably 0.05 to 5% by mass, dipping temperature is 20 to 90°C, preferably 25 to 50°C, and dipping time is 0.1 seconds to 20 minutes, and preferably 2 seconds to 1 minute.

The amount of coating (by solid content) of the undercoat layer is preferably 0.1 to 100 $mg/m^2$, and more preferably 1 to 30 $mg/m^2$. The polymer compound (D) preferably accounts for 90% by mass or more of the solid content.

<Image Recording Layer>

The image recording layer of the lithographic printing plate precursor according to the present invention preferably contains a polymerization initiator (B), a polymerizable compound (C) and a binder (D), more preferably contains the polymerization initiator (B), the polymerizable compound (C) a binder (D) and a dye (E).

(B) Polymerization Initiator

The image recording layer of the present invention preferably contains the polymerization initiator (also referred to as initiator compound, hereinafter). In the present invention, a radical polymerization initiator is preferably used.

The initiator compound may be arbitrarily selected from compounds known among those skilled in the art without

limitation. Specific examples include trihalomethyl compound, carbonyl compound, organic peroxide, azo compound, azide compound, metallocene compound, hexaarylbiimidazole compound, organic boron compound, disulfone compound, oxim ester compound, onium salt, and iron arene complex. In particular, the initiator compound is preferably at least one species selected from the group consisting of hexaarylbiimidazole compound, onium salt, trihalomethyl compound and metallocene compound, and is particularly hexaarylbiimidazole compound, or onium salt. Two or more species of them may be used in combination as the polymerization initiator.

The hexaarylbiimidazole compound is exemplified by lophine dimers described in European Patent Nos. 24, 629 and No. 107,792, and United States Patent No. 4, 410, 621, which are exemplified by
2,2'-bis(*o*-chlorophenyl)-4,4',5,5'-tetraphenylbiimidazo le,
2,2'-bis(*o*-bromophenyl)-4,4',5,5'-tetraphenylbiimidazol e,
2,2'-bis(*o,p*-dichlorophenyl)-4,4',5,5'-tetraphenylbiimi dazole,
2,2'-bis(*o*-chlorophenyl)-4,4',5,5'-tetra(m-methoxypheny l)biimidazole,
2,2'-bis(*o,o*'-dichlorophenyl)-4,4',5,5'-tetraphenylbiim idazole,
2,2'-bis(*o*-nitrophenyl)-4,4',5,5'-tetraphenylbiimidazol e,
2,2'-bis(*o*-methylphenyl)-4,4',5,5'-tetraphenylbiimidazo le, and
2,2'-bis(*o*-trifluoromethylphenyl)-4,4',5,5'-tetraphenyl biimidazole. It is particularly preferable that the hexaarylbiimidazole compound is used in combination with a sensitizing dye which shows maximum absorption in the wavelength range from 300 to 450 nm.

The onium salt is exemplified by diazonium salts described in S.I. Schlesinger, Photogr. Sci. Eng., 18, 387(1974), T.S. Bal et al., Polymer, 21, 423(1980), and Japanese Laid-Open Patent Publication No. H05-158230; ammonium salts described for example in United States Patent No. 4,069,055, and Japanese Laid-Open Patent Publication No. H04-365049; phosphonium salts described in United States Patent Nos. 4, 069, 055 and 4, 069, 056; iodonium salts described in European Patent Nos. 104,143, United States Patent Publication No. 2008/0311520, Japanese Laid-Open Patent Publication Nos. H02-150848 and 2008-195018, and J.V. Crivello et al., Macromolecules, 10(6), 1307(1977); sulfonium salts described in European Patent No. 370,693, *ibid.* No. 233,567, *ibid.* No. 297,443, *ibid.* No. 297,442, United States Patent No. 4,933,377, *ibid.* No. 4,760,013, *ibid.* No. 4,734,444 and *ibid.* No. 2,833,827, and German Patent No. 2,904,626, *ibid.* No. 3,604,580 and ibid. No. 3,604,581; selenonium salts described in J.V. Crivello et al., J. Polymer Sci., Polymer Chem. Ed., 17, 1047(1979); arsonium salts described in C.S. Wen et al., The Proc. Conf. Rad. Curing ASIA, p478, Tokyo, Oct(1988); and azinium salts described in Japanese Laid-Open Patent Publication No. 2008-195018.

Among them, more preferable examples include iodonium salt, sulfonium salt and azinium salts. Specific examples of these compounds will be shown below, without limiting the present invention.

The iodonium salt is preferably diphenyliodonium salt, more preferably diphenyliodonium salt substituted by an electron donor group such as alkyl group or alkoxyl group, and still more preferably asymmetric diphenyliodonium salts. Specific examples include diphenyliodonium hexafluorophosphate,
4-methoxyphenyl-4-(2-methylpropyl)phenyliodonium hexafluorophosphate,
4-(2-methylpropyl)phenyl-*p*-tolyliodonium hexafluorophosphate,
4-hexyloxyphenyl-2,4,6-trimethoxyphenyliodonium hexafluorophosphate,
4-hexyloxyphenyl-2,4-diethoxyphenyliodonium tetrafluoroborate,
4-octyloxyphenyl-2,4,6-trimethoxyphenyliodonium 1-perfluorobutanesulfonate,
4-octyloxyphenyl-2,4,6-trimethoxyphenyliodonium hexafluorophosphate, and bis(4-*t*-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate, and tris(4-chlorophenyl)sulfonium hexafluorophosphate.

Examples of the azinium salt include 1-cyclohexylmethyloxypyrydinium hexafluorophosphate, 1-cyclohexyloxy-4-phenylpyrydinium hexafluorophosphate, 1-ethoxy-4-phenylpyrydinium hexafluorophosphate, 1-(2-ethylhexyloxy)-4-phenylpyrydinium hexafluorophosphate, 4-chloro-1-cyclohexylmethyloxypyrydinium hexafluorophosphate, 1-ethoxy-4-cyanopyrydinium hexafluorophosphate, 3,4-dichloro-1-(2-ethylhexyloxy)pyrydinium hexafluorophosphate, 1-benzyloxy-4-phenylpyrydinium hexafluorophosphate, 1-phenetyloxy-4-phenylpyrydinium hexafluorophosphate, 1-(2-ethylhexyloxy)-4-phenylpyrydinium *p*-toluenesulfonate, 1-(2-ethylhexyloxy)-4-phenylpyrydinium perfluorobutanesulfonate, 1-(2-ethylhexyloxy)-4-phenylpyrydinium bromide, and 1-(2-ethylhexyloxy)-4-phenylpyrydinium tetrafluoroborate.

It is particularly preferable that the onium salt is used in combination with an infrared absorber which shows maximum absorption in the wavelength range from 750 to 1400 nm.

Besides them, also polymerization initiators described in paragraphs [0071] to [0129] of Japanese Laid-Open Patent Publication No. 2007-206217 are preferably used.

The polymerization initiator is preferably used alone, or in combination of two or more species.

The content of the polymerization initiator in the image recording layer is preferably 0.01 to 20% by mass relative

to the total solid content of the image recording layer, more preferably 0.1 to 15% by mass, and still more preferably 1.0 to 10% by mass.

(C) Polymerizable Compound

The polymerizable compound used for the image recording layer is an addition polymerizable compound having at least one ethylenic unsaturated double bond, and is selected from compounds having at least one, and preferably two, terminal ethylenic unsaturated bonds. These compounds typically have any of chemical forms including monomer; prepolymer such as dimer, trimer and oligomer; and mixtures of them. Examples of the monomer include unsaturated carboxylic acid (for example, acrylic acid, methacrylic acid, itaconic acid, crotonic acid, isocrotonic acid, maleic acid), esters of them, and amides of them. More preferable examples include esters formed between unsaturated carboxylic acid and polyhydric alcohol compound, and amides formed between unsaturated carboxylic acid and polyvalent amine compound. Still other preferable examples include adducts of unsaturated carboxylate esters or amides having nucleophilic substituent group such as hydroxy group, amino group, mercapto group or the like, formed together with monofunctional or polyfunctional isocyanates or epoxys; and dehydration condensation product formed together with monofunctional or polyfunctional carboxylic acid. Still other preferable examples include adducts of unsaturated carboxylate esters or amides having electrophilic substituent group such as isocyanate group and epoxy group, formed together with monofunctional or polyfunctional alcohols, amines, or thiols; and substitution products of unsaturated carboxylate esters or amides having eliminative substituent group such as halogen group and tosyloxy group, formed together with monofunctional or polyfunctional alcohols, amines, or thiols.

Also compounds obtained by replacing the above-described unsaturated carboxylic acid with unsaturated phosphonic acid, styrene, vinyl ether or the like are also adoptable. These compounds are disclosed in Published Japanese Translation of PCT International Publication for Patent Application No. 2006-508380, Japanese Laid-Open Patent Publication Nos. 2002-287344, 2008-256850, 2001-342222, H09-179296, H09-179297, H09-179298, 2004-294935,2006-243493, 2002-275129, 2003-64130, 2003-280187, and H10-333321.

Specific examples of the monomer in the form of acrylate ester formed between polyhydric alcohol compound and unsaturated carboxylic acid include ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanurate ethylene oxide (EO)-modified triacrylate, and polyester acrylate oligomer. Examples of methacrylate ester include tetramethylene glycol dimethacrylate, neopentyl glycol dimethacrylate, trimethylolpropane trimethacrylate, ethylene glycol dimethacrylate, pentaerythritol trimethacrylate, bis[*p*-(3-methacryl oxy-2-hydroxypropoxy)phenyl]dimethylmethane, and bis-[*p*-(methacryloxyethoxy)phenyl]dimethylmethane. Specific examples of the monomer in the form of amide formed between polyvalent amine compound and unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylylene bismethacrylamide.

Also urethane-based addition polymerizable compound, obtainable by addition polymerization between the isocyanate and hydroxy group, is preferable. Preferable examples of this sort of compound include vinyl urethane compound having two or more polymerizable vinyl groups per one molecule, which is obtainable by addition reaction between a vinyl monomer having a hydroxy group represented by the formula (P) below, and a polyisocyanate compound having two or more isocyanate groups per one molecule, as described in Examined Japanese Patent Publication No. S48-41708.

$$CH_2=C(R^{104})COOCH_2CH(R^{105})_{OH} \qquad (P)$$

(where, each of $R^{104}$ and $R^{105}$ represents H or $CH_3$.)

Other preferable examples include urethane acrylates described in Japanese Laid-Open Patent Publication No. S51-37193, Examined Japanese Patent Publication No. H02-32293, *ibid*. H02-16765, Japanese Laid-Open Patent Publication No. 2003-344997, *ibid*. No. 2006-65210; urethane compounds having ethylene oxide-based skeleton described in Examined Japanese Patent Publication Nos. S58-49860, *ibid*. S56-17654, *ibid*. S62-39417, *ibid*. No. S62-39418, Japanese Laid-Open Patent Publication No. 2000-250211, *ibid*. No. 2007-94138; and urethane compound having hydrophilic group described in United States Patent No. 7,153,632, Published Japanese Translation of PCT International Publication for Patent Application No. H08-505958, Japanese Laid-Open Patent Publication No. 2007-293221, and *ibid*. No. 2007-293223.

Among them, for the lithographic printing plate precursor adapted to the on-machine development, isocyanurate of ethylene oxide-modified acrylate such as tris(acryloyloxyethyl)isocyanurate, and bis(acryloyloxyethyl)hydroxyethyl isocyanurate are particularly preferable, from the viewpoint of good balance between hydrophilicity contributive to the on-press developability and polymerizability contributive to the printing durability.

Structure of the polymerizable compound (C), and method of use, including whether it is used alone or in combination with other species, or amount of use, may be arbitrarilydetermined depending on a final desired goal of performance design of lithographic printing plate precursor. The content of the polymerizable compound (C) is preferably 5 to 75% by mass of the total solid content of the image recording layer, more preferably 25 to 70% by mass, and particularly 30 to 60% by mass.

(D) Binder

The binder (D) contained in the image recording layer of the lithographic printing plate precursor according to the present invention is selected from those capable of keeping the image recording layer component on the support, and removable by the developer. Examples of the binder (E) include (meth)acrylic polymer, polyurethane resin, polyvinyl alcohol resin, polyvinyl butyral resin, polyvinyl formal resin, polyamide resin, polyester resin, and epoxy resin. In particular, (meth)acrylic polymer, polyurethane resin, and polyvinyl butyral resin are preferably used. More preferable examples include (meth)acrylic polymer, polyurethane resin, and polyvinyl butyral resin.

In the present invention, "(meth)acrylic polymer" means copolymer having, as a polymerizable component, (meth)acrylic acid derivative such as (meth)acrylic acid, (meth) acryliate ester (alkyl ester, aryl ester, allylester, etc.), (meth)acrylamide and (meth)acrylamide derivative. "Polyurethane resin" means polymer produced by condensation reaction between a compound having two or more isocyanate groups and a compound having two or more hydroxy groups. "Polyvinyl butyral resin" means polymer synthesized by allowing polyvinyl alcohol obtained by partially or totally saponifying polyvinyl acetate to react with butyl aldehyde under an acidic condition (acetal forming reaction), which also includes polymer having introduced therein acid group and so forth, obtained by allowing the residual hydroxy group to react with a compound having acid group.

One preferable example of the (meth)acrylic polymer is a copolymer having a repeating unit which contains an acid group. The acid group is exemplified by carboxylate group, sulfonate group, phosphonate group, phosphate group, and sulfonamide group, wherein carboxylate group is particularly preferable. The repeating unit having acid group preferably used herein includes a repeating unit derived from (meth)acrylic acid, or a unit represented by the formula (I) below:

Formula (I)

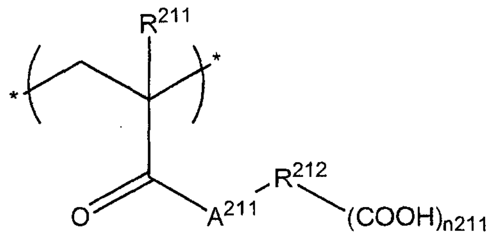

In the formula (I), $R^{211}$ represents a hydrogen atom or methyl group, $R^{212}$ represents a single bond or $n_{211}$ monovalent linking groups. $A^{211}$ represents an oxygen atom or $-NR^{213}-$ , and $R^{213}$ represents a hydrogen atom or $C_{1-10}$ monovalent hydrocarbon group. $n_{211}$ represents an integer from 1 to 5.

The linking group represented by $R^{212}$ in the formula (I) is composed of hydrogen atom, carbon atom, oxygen atom, nitrogen atom, sulfur atom and halogen atom, with a total number of atoms of preferably 1 to 80. More specifically, the alkylene group, substituted alkylene group, arylene group, and substituted arylene group are exemplified. A plurality of these divalent groups may be linked with any of amide bond, ether bond, urethane bond, urea bond and ester bond. $R^{212}$ preferably has a structure in which a plurality of single bonds, alkylene groups, substituted alkylene groups and alkylene groups and/or substituted alkylene groups are linked with any of amide bond, ether bond, urethane bond, urea bond, and ester bond; more preferably has a structure in which a plurality of single bonds, $C_{1-5}$ alkylene groups, $C_{1-5}$ substituted alkylene groups and $C_{1-5}$ alkylene groups and/or $C_{1-5}$ substituted alkylene groups are linked with any of amide bond, ether bond, urethane bond, urea bond, and ester bond; and particularly has a structure in which a plurality of single bonds, $C_{1-3}$ alkylene group, $C_{1-3}$ substituted alkylene group, and $C_{1-3}$ alkylene group and/or $C_{1-3}$ substituted alkylene groups are linked with any of amide bond, ether bond, urethane bond, urea bond, and ester bond.

Examples of the substituent group possibly bound to the linking group represented by $R^{212}$ includes group of monovalent non-metallic atoms excluding hydrogen atom, wherein examples of which include halogen atom (-F, -Br, -Cl, -I), hydroxy group, cyano group, alkoxy group, aryloxy group, mercapto group, alkylthio group, arylthio group, alkylcarbonyl group, arylcarbonyl group, carboxyl group and its conjugate base group, alkoxy carbonyl group, aryloxy carbonyl group, carbamoyl group, aryl group, alkenyl group, and alkynyl group.

$R^{213}$ is preferably a hydrogen atom or $C_{1-5}$ hydrocarbon group, more preferably a hydrogen atom or $C_{1-3}$

hydrocarbon group, and particularly a hydrogen atom or methyl group.

$n_{211}$ is preferably 1 to 3, more preferably 1 or 2, and particularly 1.

Ratio of the content (mol%) of the polymerizable component having carboxylate group, relative to the total polymerizable components of the (meth)acrylic polymer is preferably 1 to 70% from the viewpoint of developability, more preferably 1 to 50% considering a good balance between the developability and printing durability, and particularly 1 to 30%.

It is preferable for the (meth)acrylic polymer used in the present invention to additionally have a crosslinkable group. The crosslinkable group herein means a group capable of crosslinking the binder (D), in the process of radical polymerization reaction which proceeds in the image recording layer, when the lithographic printing plate precursor is exposed to light. While the functional group is not specifically limited so long as it can exhibit the above-described function, examples of the functional group capable of proceeding addition polymerization reaction include ethylenic unsaturated binding group, amino group, and epoxy group. The functional group may also be a functional group capable of producing a radical upon being exposed to light, and this sort of crosslinkable group is exemplified by thiol group and halogen group. Among them, ethylenic unsaturated binding group is preferable. The ethylenic unsaturated binding group is preferably styryl group, (meth)acryloyl group, or allyl group.

The binder (D) cures in such a way that a free radical (polymerization initiating radical, or propagating radical in the process of polymerization of radical or polymerizable compound) attaches to the crosslinkable functional group, and crosslinkage is formed among the polymer molecules thereof, by addition polymerization which proceeds directly among the polymer molecules or by sequential polymerization of the polymerizable compounds. Alternatively, the binder cures in such a way that atoms (for example, hydrogen atoms on carbon atoms adjacent to the functional crosslinking groups) in the polymer are abstracted by free radicals to produce polymer radicals, and the resultant polymer radicals then combine with each other to produce the crosslinkages among the polymer molecules.

The content of the crosslinkable group in the (meth)acrylic polymer (content of radical polymerizable unsaturated double bond determined by iodometry) is preferably 0.01 to 10. 0 mmol per one gram of the binder (D), more preferably 0.05 to 9.0 mmol, and particularly 0.1 to 8.0 mmol.

Besides the above-described repeating unit having an acid group, and the polymerization unit having a crosslinkable group, the (meth) acrylic polymer used in the present invention may have a polymerization unit of alkyl (meth)acrylate or aralkyl (meth)acrylate, polymerization unit of (meth)acrylamide or its derivative, polymerization unit of α-hydroxymethyl acrylate, or polymerization unit of styrene derivative. The alkyl group of alkyl (meth) acrylate is preferably a $C_{1-5}$ alkyl group, or an alkyl group having the above-described $C_{2-8}$ substituent group, and more preferably methyl group. The aralkyl (meth)acrylate is exemplified by benzyl (meth)acrylate. The (meth)acrylamide derivative is exemplified by N-isopropylacrylamide, N-phenylmethacrylamide, N-(4-methoxycarbonylphenyl)methacrylamide, N,N-dimethylacrylamide, and morpholinoacrylamide. The α-Hydroxymethyl acrylate is exemplified by ethyl α-hydroxymethyl acrylate, and cyclohexyl α-hydroxymethyl acrylate. The styrene derivative is exemplified by styrene, and 4-*tert*-butylstyrene.

For the case where the lithographic printing plate precursor is intended for on-machine development, the binder (D) preferably has a hydrophilic group. The hydrophilic group contributes to impart on-press developability to the image recording layer. In particular, by allowing the crosslinkable group and the hydrophilic group to coexist, the printing durability and the on-press developability may be compatible.

Examples of the hydrophilic group possibly bound to the binder (D) include hydroxy group, carboxyl group, alkylene oxide structure, amino group, ammonium group, amide group, sulfo group, and phosphate group. Among them, the alkylene oxide structure having 1 to 9 $C_{2-3}$ alkylene oxide units is preferable. The hydrophilic group may be introduced into the binder, typically by allowing monomers having hydrophilic group to copolymerize.

Preferable examples of the polyurethane resin include those described in paragraphs [0099] to [0210] of Japanese Laid-Open Patent Publication No. 2007-187836, paragraphs [0019] to [0100] of Japanese Laid-Open Patent Publication No. 2008-276155, paragraphs [0018] to [0107] of Japanese Laid-Open Patent Publication No. 2005-250438, and paragraphs [0021] to [0083] of Japanese Laid-Open Patent Publication No. 2005-250158.

Preferable examples of the polyvinyl butyral resin include those described in paragraphs [0006] to [0013] of Japanese Laid-Open Patent Publication No. 2001-75279.

The binder (D) may be neutralized by a basic compound at a part of the acid groups. The basic compound is exemplified by compounds having basic nitrogen atom, alkali metal hydroxide, and quaternary ammonium salt of alkali metal.

The binder (D) preferably has a mass average molecular weight of 5, 000 or larger, more preferably 10, 000 to 300, 000, and preferably has a number average molecular weight of 1, 000 or larger, and more preferably 2000 to 250,000. The polydispersibility (mass average molecular weight/number average molecular weight) is preferably 1.1 to 10.

The binder (D) may be used alone or in combination of two or more species.

The content of the binder (D) is preferably 5 to 75% by mass of the total solid content of the image recording layer, from the viewpoint of satisfactory levels of strength in the image-forming area and image formability, and more preferably 10 to 70% by mass, and still more preferably 10 to 60% by mass.

Total content of the polymerizable compound (C) and the binder (D) relative to the total solid content of the image recording layer is preferably 90% by mass or less. The content exceeding 90% by mass may result in degraded sensitivity and developability. The content is more preferably 35 to 80% by mass.

(E) Dye

The image recording layer preferably contains a dye. The dye is preferably a dye(E).

The sensitizing dye used for the image recording layer of the lithographic printing plate precursor according to the present invention may be arbitrarily selected without special limitation, so long as it can go into an excited state upon absorption of light in the process of pattern-wise exposure, and can supply energy to the polymerization initiator typically by electron transfer, energy transfer or heat generation, so as to improve the polymerization initiating property. In particular, sensitizing dyes showing maximum absorption in the wavelength range from 350 to 450 nm are preferably used.

The sensitizing dyes showing maximum absorption in the wavelength range from 350 to 450 nm include merocyanines, benzopyranes, coumarines, aromatic ketones, anthracenes, styryls, and oxazoles.

Among the sensitizing dyes showing maximum absorption in the wavelength range from 350 to 450 nm, preferable dyes are those represented by the formula (IX), from the viewpoint of large sensitivity.

Formula (IX)

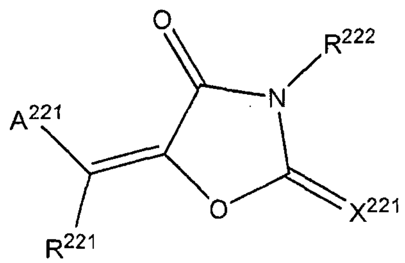

In the formula (IX), $A^{221}$ represents an aryl group or heteroaryl group which may have a substituent group, and $X^{221}$ represents an oxygen atom, sulfur atom or =N ($R^{223}$). Each of $R^{221}$, $R^{222}$ and $R^{223}$ independently represents a monovalent group of non-metallic atom, wherein $A^{221}$ and $R^{221}$, or $R^{222}$ and $R^{223}$, may combine respectively to form an aliphatic or aromatic ring.

The formula (IX) will now be further detailed. The monovalent group of non-metallic atom represented by $R^{221}$, $R^{222}$ or $R^{223}$ is preferably a hydrogen atom, substituted or unsubstituted alkyl group, substituted or unsubstituted alkenyl group, substituted or unsubstituted aryl group, substituted or unsubstituted heteroaryl group, substituted or unsubstituted alkoxy group, substituted or unsubstituted alkylthio group, hydroxy group, and halogen atom.

The aryl group and heteroaryl group represented by $A^{221}$, which may have a substituent group, are same as the substituted or unsubstituted aryl group, and substituted or unsubstituted heteroaryl group represented respectively by $R^{221}$, $R^{222}$ and $R^{223}$.

Specific examples of the sensitizing dye preferably used herein include the compounds described in paragraphs [0047] to [0053] of Japanese Laid-Open Patent Publication No. 2007-58170, paragraphs [0036] to [0037] of Japanese Laid-Open Patent Publication No. 2007-93866, and paragraphs [0042] to [0047] of Japanese Laid-Open Patent Publication No. 2007-72816.

Also the sensitizing dyes described in Japanese Laid-Open Patent Publication Nos. 2006-189604, 2007-171406, 2007-206216, 2007-206217, 2007-225701, 2007-225702, 2007-316582, and 2007-328243 are preferably used.

Next, the sensitizing dye showing maximum absorption in the wavelength range from 750 to 1400 nm (also referred to as "infrared absorber", hereinafter) will be described. The infrared absorber preferably used herein is dye or pigment.

The dye adoptable herein may be arbitrarily selected from commercially available dyes and those described in literatures such as "Senryo Binran (Dye Handbook)" (edited by The Society of Synthetic Organic Chemistry, Japan, 1970). The specific examples include azo dye, metal complex azo dye, pyrazolone azo dye, naphthoquinone dye, anthraquinone dye, phthalocyanine dye, carbonium dye, quinone imine dye, methine dye, cyanine dye, squarylium colorant, pyrylium salt dye, and metal thiolate complex dye.

Among them, particularly preferable examples include cyanine colorant, squarylium colorant, pyrylium salt, nickel thiolate complex, and indolenine cyanine colorant. More preferable examples include cyanine colorant and indolenine cyanine colorant, and particularly preferable example include a cyanine colorant represented by the formula (a) below:

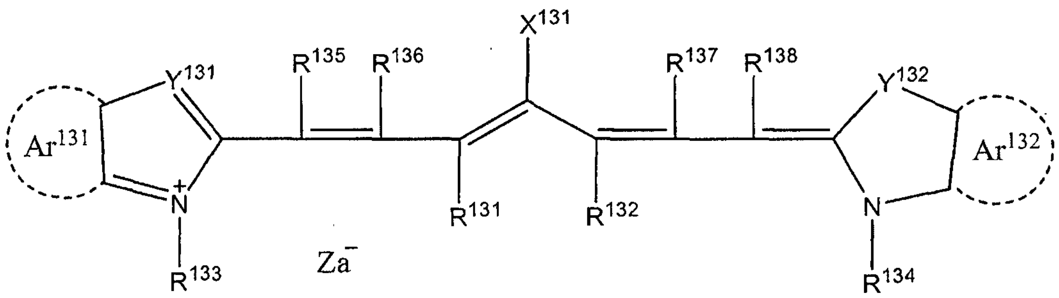

In the formula (a), $X^{131}$ represents a hydrogen atom, halogen atom, $-NPh_2$, $-X^{132}-L^{131}$ or the group shown below, where Ph represents a phenyl group.

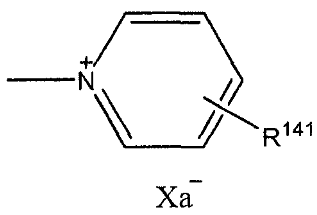

In the formula, $X^{132}$ represents an oxygen atom, nitrogen atom or sulfur atom, and $L^{131}$ represents a $C_{1-12}$ hydrocarbon group, aryl group having a hetero atom (N, S, O, halogen, Se), and $C_{1-12}$ hydrocarbon group having a hetero atom. $X_a^-$ is synonymous with $Z_a^-$ described later. $R^{141}$ represents a substituent group selected from hydrogen atom or alkyl group, aryl group, substituted or unsubstituted amino group, and halogen atom.

Each of $R^{131}$ and $R^{132}$ independently represents $C_{1-12}$ hydrocarbon group. From the viewpoint of stability of coating liquid for forming the image recording layer, each of $R^{131}$ and $R^{132}$ is preferably a $C_2$ or longer hydrocarbon group. $R^{131}$ and $R^{132}$ may combine with each other to form a ring which is preferably a five-membered ring or six-membered ring.

$Ar^{131}$ and $Ar^{132}$ may be same or different, and each represents an aryl group which may have a substituent group. Preferable examples of the aryl group include benzene ring group and naphthalene ring group. Preferable examples of the substituent group include $C_{12}$ or shorter hydrocarbon group, halogen atom, and $C_{12}$ or shorter alkoxy group. $Y^{131}$ and $Y^{132}$ may be same or different, and each represents a sulfur atom or $C_{12}$ or shorter dialkylmethylene group. $R^{133}$ and $R^{134}$ may be same or different, and each represents a $C_{20}$ or shorter hydrocarbon group which may have a substituent group. Preferable examples of the substituent group include a $C_{12}$ or shorter alkoxy group, carboxyl group, and sulfo group. $R^{135}$, $R^{136}$, $R^{137}$ and $R^{138}$ may be same or different, and each represents a hydrogen atom or $C_{12}$ or shorter hydrocarbon group. From the viewpoint of availability of the source materials, hydrogen atom is preferable. $Z_a^-$ represents a counter anion. Note that $Z_a^-$ is not necessary if the cyanine colorant represented by the formula (a) has an anionic substituent group in the structure thereof, and is omissible if there is no need of neutralization of electric charge. Preferable examples of $Z_a^-$ include halide ion, perchlorate ion, tetrafluoroborate ion, hexafluorophosphate ion and sulfonate ion from the viewpoint of storage stability of coating liquid for forming the image recording layer. Particularly preferable examples include perchlorate ion, hexafluorophosphate ion and aryl sulfonate ion.

Specific examples of the cyanine colorant represented by the formula (a) include the compounds described in paragraphs [0017] to [0019] of Japanese Laid-Open Patent Publication No. 2001-133969, paragraphs [0016] to [0021] of Japanese Laid-Open Patent Publication No. 2002-023360, and paragraphs [0012] to [0037] of Japanese Laid-Open Patent Publication No. 2002-040638, preferable examples include those described in paragraphs [0034] to [0041] of Japanese Laid-Open Patent Publication No. 2002-278057, and paragraphs [0080] to [0086] of Japanese Laid-Open Patent Publication No. 2008-195018, and particularly preferable examples include those described in paragraphs [0035] to [0043] of Japanese Laid-Open Patent Publication No. 2007-90850.

Also compounds described in paragraphs [0008] to [0009] of Japanese Laid-Open Patent Publication No. H05-5005, and paragraphs [0022] to [0025] of Japanese Laid-Open Patent Publication No. 2001-222101 are preferably used.

The infrared absorbing dye may be used alone, or in combination of two or more species, and may contain an infrared absorber other than infrared absorbing dye, which is exemplified by pigment. As the pigment, the compounds described in paragraphs [0072] to [0076] of Japanese Laid-Open Patent Publication No. 2008-195018 are preferable.

The content of the dye (E) is preferably 0.05 to 30 parts by mass relative to the total solid content (100 parts by mass) of the image recording layer, more preferably 0.1 to 20 parts by mass, and particularly 0.2 to 10 parts by mass.

(F) Low-Molecular-Weight Hydrophilic Compound

The image recording layer may contain a low-molecular-weight hydrophilic compound, for the purpose of improving the on-press developability without degrading the printing durability.
Examples of the low-molecular-weight hydrophilic compound, categorized as water-soluble organic compound, include glycols such as ethylene glycol, diethylene glycol, triethylene glycol, propylene glycol, dipropylene glycol, and tripropylene glycol, and ether or ester derivatives thereof; polyols such as glycerin, pentaerythritol, and tris(2-hydroxyethyl) isocyanurate; organic amines such as triethanolamine, diethanolamine, and monoethanolamine, and salts thereof; organic sulfonic acids such as alkyl sulfonic acid, toluenesulfonic acid, and benzenesulfonic acid, and salts thereof; organic sulfamic acids such as alkyl sulfamic acid, and salt thereof; organic sulfuric acids such as alkyl sulfuric acid, alkyl ether sulfuric acid, and salts thereof; organic phosphonic acids such as phenylphosphonic acid, and salt thereof; organic carboxylic acids such as tartaric acid, oxalic acid, citric acid, malic acid, lactic acid, gluconic acid, and amino acid, and salts thereof; and betaines.
Among them, at least one species selected from polyols, organic sulfate salts, organic sulfonate salts, and betaines are preferably contained in the present invention.
Specific examples of the organic sulfonate salt include alkylsulfonate salt such as sodium n-butylsulfonate, sodium n-hexylsulfonate, sodium 2-ethylhexylsulfonate, sodium cyclohexylsulfonate, and sodium n-octylsulfonate; alkylsulfonate salt having an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, and sodium 5,8,11,14-tetraoxatetracosane-1-sulfonate; aryl sulfonate salt such as sodium benzenesulfonate, sodium p-toluenesulfonate, sodium p-hydroxybenzenesulfonate, sodium p-styrenesulfonate, sodium dimethyl isophthalate-5-sulfonate, sodium 1-naphthylsulfonate, sodium 4-hydroxynaphthylsulfonate, disodium 1,5-naphthalenedisulfonate, and trisodium 1,3,6-naphthalenetrisulfonate; the compounds described in paragraphs [0026] to [0031] of Japanese Laid-Open Patent Publication No. 2007-276454, and paragraphs [0020] to [0047] of Japanese Laid-Open Patent Publication No. 2009-154525. The salt may also be potassium salts or lithium salts.
The organic sulfate salts are exemplified by sulfate salts of alkyl, alkenyl, alkynyl, aryl or heterocyclic monoether of polyethylene oxide. The number of ethylene oxide unit is preferably 1 to 4, and the salts are preferably sodium salt, potassium salt or lithium salt. Specific examples thereof include the compounds described in paragraphs [0034] to [0038] of Japanese Laid-Open Patent Publication No. 2007-276454.
The betaine is preferably a compound having $C_{1-5}$ hydrocarbon substituent group on the nitrogen atom, and preferable examples include trimethylammonium acetate, dimethylpropylammonium acetate, 3-hydroxy-4-trimethylammoniobutyrate, 4-(1-pyridinio)butyrate, 1-hydroxyethyl-1-imidazolio acetate, trimethylammonium methanesulfonate, dimethylpropylammonium methanesulfonate, 3-trimethylammonio-1-propanesulfonate, and 3-(1-pyridinio)-1-propanesulfonate.
The low-molecular-weight hydrophilic compound scarcely exhibits a surfactant activity due to its small size of the hydrophobic portion, so that fountain solution does not immerse into the exposed area of the image recording layer (image-forming area) to consequently degrade the hydrophobicity and film strength of the image-forming area, and thereby the ink receptivity and printing durability of the image recording layer are kept at desirable levels.
The content of the low-molecular-weight hydrophilic compound in the image recording layer is preferably 0.5 to 20% by mass of the total solid content of the image recording layer, more preferably 1 to 15% by mass, and more preferably 2 to 10% by mass. In this range, desirable levels of on-press developability and printing durability are obtained. The low-molecular-weight hydrophilic compound may be used alone, or in combination of two or more species.

(G) Sensitizer

The image recording layer may contain a sensitizer such as phosphonium compound, nitrogen-containing low-molecular-weight compound, and ammonium group-containing polymer, aiming at improving inking performance. In particular, for the case where the protective layer contains an inorganic layered compound, the sensitizer functions as a surface coating agent of the inorganic layered compound, and prevent the inking performance from degrading in the process of printing, due to the inorganic layered compound.
Preferable examples of the phosphonium compound include those described in Japanese Laid-Open Patent Publication Nos. 2006-297907 and 2007-50660. Specific examples thereof include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate, and 1,9-bis(triphenylphosphonio)nonanenaphthalene -2,7-disulfonate.
The nitrogen-containing low-molecular-weight compound is exemplified by amine salts, and quaternary ammonium salts. Other examples include imidazolinium salts, benzoimidazolinium salts, pyrydinium salts, and quinolinium salts. Among them, quaternary ammonium salts and pyrydinium salts are preferable. Specific examples include tetramethylammonium hexafluorophosphate, tetrabutylammonium hexafluorophosphate, dodecyltrimethylammonium p-toluenesulfonate, benzyl triethylammonium hexafluorophosphate, benzyl dimethyloctylammonium hexafluorophosphate, benzyl dimethyldodecylammonium hexafluorophosphate, the compounds described in paragraphs [0021] to [0037] of Japanese Laid-Open Patent Publication No. 2008-284858, and the compounds described in paragraphs [0030] to [0057] of Japanese Laid-Open Patent Publication No. 2009-90645.

While the ammonium group-containing polymer may be arbitrarily selected so long as it has an ammonium group in the structure thereof, a preferable polymer contains, as a copolymerizable component, 5 to 80 mol% of (meth)acrylate having an ammonium group in the side chain thereof. Specific examples include the polymers described in paragraphs [0089] to [0105] of Japanese Laid-Open Patent Publication No. 2009-208458.

The ammonium salt-containing polymer preferably has a reduced specific viscosity (in ml/g), measured by the method of measurement described below, of 5 to 120, more preferably 10 to 110, and particularly 15 to 100. Mass average molecular weight, converted from the reduced specific viscosity, is preferably 10,000 to 150,000, more preferably 17,000 to 140,000, and particularly 20,000 to 130,000.

«Method of Measuring Reduced Specific Viscosity»

In a 20-ml measuring flask, 3.33 g (1 g as solid content) of a 30% polymer solution is weighed, and the flask is filled up with N-methylpyrrolidone. The obtained solution is allowed to stand in a thermostat chamber at 30°C for 30 minutes, and then placed in a Ubbelohde reduced viscosity tube (viscometer constant=0.010 cSt/s), and the time it takes for the solution to elute at 30°C is measured. The measurement is repeated twice using the same sample, to thereby find an average value. The blank (N-methylpyrrolidone only) is also measured similarly, and the reduced specific viscosity (ml/g) is calculated by the formula below.

$$\text{Reduced specific viscosity (ml/g)} = \frac{\dfrac{\text{Elution time of sample solution (sec)} - \text{Elution time of blank (sec)}}{\text{Elution time of blank (sec)}}}{\dfrac{3.33\ (\text{g}) \times \dfrac{30}{100}}{20\ (\text{ml})}}$$

Specific examples of the ammonium group-containing polymer will be enumerated below:

(1) 2-(trimethylammonio)ethyl methacrylate *p*-toluenesulfonate/3,6-dioxaheptyl methacrylate copolymer (molar ratio=10/90, mass average molecular weight: 450,000)
(2) 2-(trimethylammonio)ethyl methacrylate hexafluorophosphate/3,6-dioxaheptyl methacrylate copolymer (molar ratio=20/80, mass average molecular weight: 600,000)
(3) 2-(ethyldimethylammonio)ethyl methacrylate p-toluenesulfonate/hexyl methacrylate copolymer (molar ratio=30/70, mass average molecular weight: 450,000)
(4) 2-(trimethylammonio)ethyl methacrylate hexafluorophosphate/2-ethylhexyl methacrylate copolymer (molar ratio=20/80, mass average molecular weight: 600,000)
(5) 2-(trimethylammonio)ethyl methacrylate methylsulfate/hexyl methacrylate copolymer (molar ratio=40/60, mass average molecular weight: 700,000)
(6) 2-(butyldimethylammonio)ethyl methacrylate hexafluorophosphate/3,6-dioxaheptyl methacrylate copolymer (molar ratio=25/75 mass average molecular weight: 650,000)
(7) 2-(butyldimethylammonio)ethyl acrylate hexafluorophosphate/3,6-dioxaheptyl methacrylate copolymer (molar ratio=20/80, mass average molecular weight: 650,000)
(8) 2-(butyldimethylammonio)ethyl methacrylate 13-ethyl-5,8,11-trioxa-1-heptadecane sulfonate/3,6-dioxaheptyl methacrylate copolymer (molar ratio=20/80, mass average molecular weight: 750,000)
(9) 2-(butyldimethylammonio)ethyl methacrylate hexafluorophosphate/3,6-dioxaheptyl methacrylate /2-hydroxy-3-methacryloyloxypropylmethacrylate copolymer (molar ratio=15/80/5 mass average molecular weight: 650,000)

The content of the sensitizer is preferably 0.01 to 30.0% by mass of the total solid content of the image recording layer, more preferably 0.01 to 15.0% by mass, and still more preferably 1 to 5% by mass. (H) Hydrophobization Precursor

The image recording layer may contain a hydrophobization precursor, for the purpose of improving the on-press developability. The hydrophobization precursor means a fine particle capable of turning, upon heating, the image

recording layer into hydrophobic. The fine particle is preferably at least one species selected from hydrophobic thermoplastic polymer particle, thermoreactive polymer particle, polymer particle having polymerizable group, and microcapsule and microgel (crosslinked polymer particle) containing hydrophobic compound. Among them, polymer particle and microgel having polymerizable group are preferable.

Preferable examples of the hydrophobic thermoplastic polymer particle include those described in Research Disclosure No.333003 published in January 1992, Japanese Laid-Open Patent Publication Nos. H09-123387, H09-131850, H09-171249, H09-171250 and European Patent No. 931647.

Specific examples of polymer composing the polymer particle include ethylene, styrene, vinyl chloride, methyl acrylate, ethyl acrylate, methyl methacrylate, ethyl methacrylate, vinylidene chloride, acrylonitrile, vinylcarbazole, acrylate or methacrylate having a polyalkylene structure, all of which being available in the form of monomer, homopolymer, copolymer and mixture. Among them, more preferable examples include polystyrene, copolymer containing styrene and acrylonitrile, and methyl polymethacrylate.

Average particle size of the hydrophobic thermoplastic polymer particle used in the present invention is preferably 0.01 to 2.0 $\mu$m.

The thermoreactive polymer particle used in the present invention is exemplified by polymer particle having a thermoreactive group which forms a hydrophobic domain as a result of crosslinking by thermal reaction and concomitant change in the functional group.

While the thermoreactive group contained in the polymer particle used in the present invention may be arbitrarily selected from those capable of proceeding any type of reaction so long as it can form a chemical bond, it is preferably a polymerizable group. The preferable examples include ethylenic unsaturated group which undergoes radical polymerization reaction (acryloyl group, methacryloyl group, vinyl group, allyl group, etc.); cation polymerizable group (vinyl group, vinyloxy group, epoxy group, oxetanyl group, etc.); isocyanate group or block thereof which undergoes addition reaction; epoxy group, vinyloxy group and functional group containing an activated hydrogen atom reactive with them (amino group, hydroxy group, carboxyl group, etc.); carboxyl group which undergoes condensation reaction, and functional group capable of reacting therewith and having a hydroxy group or amino group; and acid anhydride which undergoes ring-opening addition reaction, and amino group or hydroxy group allow to react therewith.

The microcapsule used in the present invention contains all of, or a part of, the constituents of the image recording layer, typically as described in Japanese Laid-Open Patent Publication Nos. 2001-277740 and 2001-277742. The constituents of the image recording layer may also be contained outside the microcapsule. Still alternatively, the image recording layer containing microcapsule may be configured so as to contain the hydrophobic constituents encapsulated in the microcapsule, and hydrophilic constituents outside the microcapsule.

The microgel used in the present invention may contain at least either therein or on the surface thereof, a part of constituents of the image recording layer. In particular, an embodiment of reactive microgel, configured by attaching the radical-polymerizable group onto the surface thereof, is preferable from the viewpoint of image-forming sensitivity and printing durability.

Encapsulation of the constituents of the image recording layer into the microcapsule or microgel is arbitrarily selectable from those known in the art.

Average particle size of the microcapsule or microgel is preferably 0.01 to 3.0 $\mu$m, more preferably 0.05 to 2.0 $\mu$m, and particularly 0.10 to 1.0 $\mu$m. Satisfactory levels of resolution and long-term stability may be ensured in the above-described ranges.

The content of the hydrophobization precursor is preferably 5 to 90% by mass relative to the total solid content of the image recording layer.

(I) Other Components of Image Recording Layer

The image recording layer preferably contains chain transfer agent. The chain transfer agent is defined typically in "Kobunshi Jiten (The Dictionary of Polymer), 3rd Edition" (edited by The Society of Polymer Science, Japan, 2005) p. 683-684. The chain transfer agent adoptable herein includes compound having SH, PH, SiH or GeH in the molecule thereof. These groups may produce a radical by donating a hydrogen to a low-active radical species, or, may produce a radical after being oxidized, followed by deprotonation. It is particularly preferable for the image recording layer to contain a thiol compound (2-mercapto benzimidazoles, 2-mercapto benzthiazoles, 2-mercapto benzoxazoles, 3-mercapto triazoles, 5-mercapto tetrazoles, etc.).

The content of the chain transfer agent is preferably 0.01 to 20 parts by mass relative to the total solid content (100 parts by mass) of the image recording layer, more preferably 1 to 10 parts by mass, and particularly 1 to 5 parts by mass.

The image recording layer may further contain various additives as needed. The additives are exemplified by surfactant for enhancing developability and improving coating surface texture; hydrophilic polymer for improving developability and dispersion stability of the microcapsule; colorant and baking agent for easy discrimination between the

image-forming area and the non-image-forming area; polymerization inhibitor for avoiding unnecessary thermal polymerization of the polymerizable compound in the process of manufacturing or storage of the image recording layer; hydrophobic low-molecular-weight compound such as higher aliphatic acid derivative for avoiding inhibition of oxygen-induced polymerization; inorganic particle and organic particle for improving strength of cured film in the image-forming area; co-sensitizer for improving the sensitivity; and plasticizer for improving plasticity. These compounds may be any of those known in the art, such as those disclosed in paragraphs [0161] to [0215] of Japanese Laid-Open Patent Publication No. 2007-206217, paragraph [0067] of Published Japanese Translation of PCT International Publication for Patent Application No. 2005-509192, and paragraphs [0023] to [0026], and [0059] to [0066] of Japanese Laid-Open Patent Publication No. 2004-310000. The surfactant may also be those which may be added to the developer described later.

(Formation of Image Recording Layer)

The image recording layer in the lithographic printing plate precursor according to the present invention may be formed by an arbitrary method known in the art, without special limitation. The image recording layer is formed by dispersing or dissolving the above-described necessary components of the image recording layer into a solvent to prepare a coating liquid, and then coating the liquid. The solvent adoptable herein is exemplified by methyl ethyl ketone, ethylene glycol monomethyl ether, 1-methoxy-2-propanol, 2-methoxyethyl acetate, 1-methoxy-2-propyl acetate, and $\gamma$-butyrolactone, but not limited thereto. The solvent may be used alone, or in combination of two or more species. The solid content of the coating liquid is preferably 1 to 50% by mass.

The amount of coating (solid content) of the image recording layer is preferably 0.3 to 3.0 g/$m^2$. Method of coating may be arbitrarily selected from various methods, including bar coater coating, spin coating, spray coating, curtain coating, dip coating, air knife coating, blade coating, and roll coating.

The copolymer (A) may be incorporated into the image recording layer or undercoat layer, by adding the copolymer (A) to the coating liquid for forming the image recording layer, or to the coating liquid for forming the undercoat layer. For the case where the copolymer (A) is contained in the image recording layer, the content of the copolymer (A) (solid content) is preferably 0.1 to 100 mg/$m^2$, more preferably 1 to 30 mg/$m^2$, and still more preferably 5 to 24 mg/$m^2$.

[Support]

The support used for the lithographic printing plate precursor according to the present invention is not specifically limited, provided that it is plate-like hydrophilic support with dimensional stability. Aluminum plate is particularly preferable as the support. The aluminum plate preferably undergoes surface treatment such as roughening or anodizing prior to use. The surface of aluminum plate may be roughened by various methods including mechanical roughening, electro-chemical roughening (eroding the surface by an electro-chemical process), and chemical roughening (selectively eroding the surface in a chemical process). Preferable examples of these methods of treatment are descried in paragraphs [0241] to [0245] of Japanese Laid-Open Patent Publication No. 2007-206217.

The support preferably has a center line average roughness of 0.10 to 1.2 $\mu$m. In this range, the support will exhibit good adhesiveness with the image recording layer, good printing durability, and good staining resistance.

Color density of the support is preferably 0.15 to 0.65 in terms of reflection density value. In this range, good image forming performance by virtue of suppressed halation in the process of pattern-wise exposure, and readiness of plate check after development may be ensured.

The support is preferably 0.1 to 0.6 mm thick, more preferably 0.15 to 0.4 mm thick, and still more preferably 0.2 to 0.3 mm thick.

<Hydrophilization>

In the lithographic printing plate precursor according to the present invention, it is also effective to hydrophilize the surface of the support, for the purpose of improving the hydrophilicity in the non-image-forming area and of preventing printing blot.

Methods of hydrophilization of the surface of the support include alkali metal silicate treatment by which the support is dipped into an aqueous solution of sodium silicate or the like, for electrolytic treatment; treatment using potassium fluorozirconate; and treatment using polyvinyl phosphonate. The method using an aqueous solution of polyvinyl phosphonate is preferably used.

[Protective Layer]

For the purpose of blocking diffusive intrusion of oxygen which may inhibit the polymerization reaction in the

process of exposure to light, the lithographic printing plate precursor according to the present invention is preferably provided with the protective layer (oxygen barrier layer) on the image recording layer. Materials for composing the protective layer are arbitrarily selectable either from water-soluble polymer and water-insoluble polymer, and two or more species may be combined as necessary. More specifically, polyvinyl alcohol, modified polyvinyl alcohol, polyvinyl pyrrolidone, water-soluble cellulose derivative, and poly(meth)acrylonitrile are exemplified. Among them, water-soluble polymer compound is preferably used by virtue of its relatively good crystallinity. More specifically, a good result may be obtained by using polyvinyl alcohol as a major constituent, from the viewpoint of achieving excellent basic performances such as oxygen barrier performance, and removability in development.

Polyvinyl alcohol used for the protective layer may partially be substituted, at the hydroxy groups thereof, by ester, ether or acetal, so long as a certain amount of unsubstituted vinyl alcohol units, necessary for ensuring oxygen barrier performance and water-solubility, is contained. Similarly, polyvinyl alcohol may also contain other polymerizable component partially in the structure thereof. Polyvinyl alcohol may be obtained by hydrolyzing polyvinyl acetate. Specific examples of polyvinyl alcohol include those having a degree of hydrolysis of 69.0 to 100 mol%, and having a number of polymerizable repeating units of 300 to 2400. More specific examples include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and PVA L-8, all of which commercially available from Kuraray Co. Ltd. Polyvinyl alcohol may be used alone, or in the form of mixture. The content of polyvinyl alcohol in the protective layer is preferably 20 to 95% by mass, and more preferably 30 to 90% by mass.

Also modified polyvinyl alcohol may preferably be used. In particular, acid-modified polyvinyl alcohol having the carboxylate group or sulfonate group is preferably used. More specifically, preferable examples include the polyvinyl alcohol described in Japanese Laid-Open Patent Publication Nos. 2005-250216 and 2006-259137.

For the case where polyvinyl alcohol is used in a mixed form with other materials, the materials to be mixed are preferably modified polyvinyl alcohol, polyvinyl pyrrolidone or a modified product thereof, from the viewpoint of oxygen barrier performance and readiness of removal in development. The content in the protective layer is 3.5 to 80% by mass, preferably 10 to 60% by mass, and more preferably 15 to 30% by mass.

The protective layer may be added with several percents, relative to the polymer, of glycerin, dipropylene glycol or the like so as to give flexibility. Alternatively, several percents by mass, relative to the polymer, of anionic surfactants such as the sodium alkyl sulfuric acid and sodium alkyl sulfonate; ampholytic surfactants such as alkylamino carboxylate salt, and alkylamino dicarboxylate salt; and nonionic surfactants such as polyoxyethylene alkyl phenyl ether polymer may be added.

In addition, for the purpose of improving the oxygen barrier performance and surface protective performance of the image recording layer, the protective layer may contain an inorganic layered compound. Among the inorganic layered compounds, fluorine-containing swellable synthetic mica, which is a synthetic inorganic layered compound, is particularly useful. More specifically, preferable examples include the inorganic layered compounds described in Japanese Laid-Open Patent Publication No. 2005-119273.

The amount of coating of the protective layer is preferably 0.05 to 10 $g/m^2$, and is more preferably 0.1 to 5 $g/m^2$ if the inorganic layered compound is contained, and whereas more preferably 0.5 to 5 $g/m^2$ if the inorganic layered compound is not contained.

[Back Coat Layer]

The lithographic printing plate precursor according to the present invention may be provided with a back coat layer on the back surface of the support as necessary. The back coat layer is preferably exemplified by a cover layer composed of the organic polymer compounds described in Japanese Laid-Open Patent Publication No. H05-45885, or composed of the metal oxides described in Japanese Laid-Open Patent Publication No. H06-35174 which are obtained by allowing organic metal compound or inorganic metal compound to hydrolyze or undergo polycondensation. Among them, alkoxy compounds of silicon, such as $Si(OCH_3)_4$, $Si(OC_2H_5)_4$, $Si\ (OC_3H_7)_4$, $Si(OC_4H_9)_4$ are preferable in view of inexpensiveness and availability of the source materials.

[Method of Manufacturing Lithographic printing plate]

The lithographic printing plate may be manufactured by exposing the lithographic printing plate precursor according to the present invention in a pattern-wise manner, followed by development.

The method of manufacturing the lithographic printing plate of the present invention include a step of exposing the lithographic printing plate precursor according to the present invention in a pattern-wise manner; and a step of developing the exposed lithographic printing plate precursor using a developer of pH2 to 10; wherein the step of development includes a step of concomitantly removing the unexposed area of the image recording layer and the protective

layer, in the presence of the developer.

The method of manufacturing the lithographic printing plate of the present invention preferably includes a step of forming a protective layer on the surface of the image recording layer on the side opposite to the support; and the step of development further includes a step of concomitantly removing the image recording layer in the unexposed area and the protective layer (excluding water washing process), under the presence of the developer additionally containing a surfactant.

A second embodiment of the method of manufacturing the lithographic printing plate of the present invention includes a step of exposing the lithographic printing plate precursor according to the present invention in a pattern-wise manner; and a step of removing the image recording layer selectively in the unexposed area, by feeding a printing ink and a fountain solution on a printing machine.

Preferable embodiments of the individual steps in the method of manufacturing the lithographic printing plate of the present invention will be explained in sequence. According to the method of manufacturing the lithographic printing plate of the present invention, the lithographic printing plate precursor according to the present invention may be manufactured for the case where the step of development includes a step of water washing.

<Exposure Step>

The method of manufacturing the lithographic printing plate of the present invention includes a step of exposing the lithographic printing plate precursor according to the present invention in a pattern-wise manner. The lithographic printing plate precursor according to the present invention is exposed by laser shot through a transparent original having a line image or halftone image or the like, or laser scanning modulated by digital data.

Wavelength of light source is preferably 300 to 450 nm or 750 to 1400 nm. When the light source of 300 to 450 nm is used, the lithographic printing plate precursor preferably contains, in the image recording layer thereof, a sensitizing dye showing an absorption maximum in this wavelength. On the other hand, for the case where the light source of 750 to 1400 nm is used, the lithographic printing plate precursor preferably contains, in the image recording layer thereof, an infrared absorber, which is a sensitizing dye showing an absorption maximum in this wavelength range. The light source of 300 to 450 nm is preferably a semiconductor laser. The light source of 750 to 1400 nm is preferably a solid-state laser or semiconductor laser capable of emitting infrared radiation. The infrared laser preferably has an output of 100 mW or larger, exposure time per pixel is preferably 20 microseconds or shorter, and exposure energy is preferably 10 to 300 $mJ/cm^2$. A multi-beam laser device is preferably used in order to shorten the exposure time. An exposure mechanism may be based on any of internal drum system, external drum system, and flat bed system.

The pattern-wise exposure may be proceeded by a general method using a plate setter, for example. When the on-machine development is adopted, the lithographic printing plate precursor may be set on a printing machine and may be exposed pattern-wise on the printing machine.

<Development Step>

The development may be implemented by (1) a method of development using a developer of pH2 to 10 (developer process), or (2) a method of development on a printing machine, while feeding fountain solution and/or ink (on-machine development).

(Developer Process)

In the developer process, the lithographic printing plate precursor is treated using the developer of pH2 to 10, so as to remove the unexposed area of the image recording layer, and thereby lithographic printing plate is manufactured.

In a general process of development using a strong alkaline developer (pH12 or above), the protective layer is removed by pre-water washing, subjected to alkaline development, post-water washing for removing alkali by water washing, gum solution treatment, and drying process, to thereby obtain the lithographic printing plate.

According to a first preferable embodiment of the present invention, the developer used herein has pH value of 2 to 10.

In this embodiment, the developer preferably contains a surfactant or water-soluble polymer compound, so as to concomitantly allow the development and gum solution treatment to proceed. Accordingly, the post-water washing is not indispensable, and the development and the gum solution treatment may be proceeded in a single solution.

Also the pre-water washing is not indispensable, so that also the removal of the protective layer may be proceeded concomitantly with the gum solution treatment. In the method of manufacturing the lithographic printing plate of the present invention, the development and gum solution treatment is preferably followed by removal of excessive developer using a squeeze roller for example, and drying.

The development by developer in the lithographic printing plate precursor of the present invention may be

proceeded as usual at 0 to 60°C, preferably 15 to 40°C or around, typically by a method of dipping the exposed lithographic printing plate precursor into a developer followed by rubbing with a brush, or a method of spraying a developer followed by rubbing with a brush.

The development using the developer is successfully implemented on an automatic processor, equipped with a developer feeder and a rubbing member. The automatic processor having rotating brush rollers as the rubbing member is particularly preferable. The automatic processor preferably has a unit for removing excessive developer, such as squeeze rollers, and a drying unit such as a hot air blower, on the downstream side of the developing unit. Moreover, the automatic processor may have a pre-heating unit for heating the exposed lithographic printing plate precursor, on the upstream side of the developing unit.

An example of automatic processor used for the method of manufacturing a lithographic printing plate of the present invention will be briefed below, referring to FIG. 2.

The automatic processor illustrated in FIG. 1 is basically composed of a developing unit 6 and a drying unit 10, wherein the lithographic printing plate precursor 4 is developed in the developing tank 20, and dried in the drying unit 10.

The automatic processor 100 illustrated in FIG. 2 is composed of a chamber shaped by an equipment frame 202, and has a pre-heating section 200, a developing section 300 and a drying section 400 aligned in line in the direction of a feed path 11 along which the lithographic printing plate precursor is fed (indicated by arrow A).

The pre-heating section 200 has a heating chamber 208 with a feeding port 212 and an output port 218, and has tandem rollers 210, heaters 214 and a circulating fan 216 arranged therein.

The developing section 300 is partitioned by an outer panel 310 from the pre-heating section 200, and the outer panel 310 has an insertion slit 312.

Inside the developing section 300, there is provided a process tank 306 having therein a developing tank 308 filled with a developer, and an insertion roller pair 304 for guiding the lithographic printing plate precursor into the process tank 306. The upper portion of the developing tank 308 is covered with a shielding lid 324.

Inside the developing tank 308, there is provided a guide roller 344 and a guiding member 342, an immersed roller pair 316, a brush roller pair 322, a brush roller pair 326, and an output roller pair 318 which are aligned in sequence from the upstream side of the feeding direction. The lithographic printing plate precursor brought into the developing tank 308 is dipped in the developer, and allowed to pass through the rotating brush roller pairs 322, 326, to be removed with the non-image-forming area.

Below the brush roller pairs 322, 326, there is provided a spray pipe 330. The spray pipe 330 is connected to a pump (not illustrated), and the developer in the developing tank 308 sucked up by the pump is ejected through the spray pipe 330 into the developing tank 308.

On the sidewall of the developing tank 308, there is provided an overflow port 51 opened at the top end portion of a first circulating pipe C1, so as to allow an excessive portion of the developer to flow into the overflow port 51, run down through the first circulating pipe C1, to be discharged into an external tank 50 provided outside the developing section 300.

The external tank 50 is connected to a second circulating pipe C2. The second circulating pipe C2 is provided with a filter unit 54 and a developer feed pump 55. By the developer feed pump 55, the developer is fed from the external tank 50 to the developing tank 308. The external tank 50 is provided with a upper level gauge 52 and a lower level gauge 53.

The developing tank 308 is connected through a third circulating pipe C3 to a supplementary water tank 71. The third circulating pipe C3 is provided with a water supplement pump 72 by which water reserved in the supplementary water tank 71 is fed to the developing tank 308.

A liquid temperature sensor 336 is provided on the upstream side of the immersed roller pair 316, and a level gauge 338 is provided on the upstream side of the output roller pair 318.

A partition board 332 placed between the developing section 300 and the drying section 400 has an insertion slit 334 provided thereto. On a path between the developing section 300 and the drying section 400, there is provided a shutter (not illustrated) which closes the path when the lithographic printing plate precursor 11 does not travel on the path.

The drying section 400 has a support roller 402, ducts 410, 412, a feed roller pair 406, ducts 410, 412, and a feed roller pair 408 aligned therein in sequence. Each of the ducts 410, 412 has a slit hole 414 provided to the tip thereof. The drying section 400 has provided thereto an unillustrated drying unit such as a hot air blower, heat generator or the like. The drying section 400 has a discharge port 404, through which the lithographic printing plate dried by the drying unit is ejected.

In the present invention, the developer used for the development by developer is preferably an aqueous solution of pH2 to 14, or contains a surfactant. The developer is preferably an aqueous solution mainly composed of water (with a water content of 60% by mass or more), wherein an aqueous solution containing a surfactant (anionic, nonioic, cationic, ampholytic ion-based, etc.), or an aqueous solution containing a water-soluble polymer compound is particularly preferable. Also an aqueous solution containing both of surfactant and water-soluble polymer compound is preferable. The developer is preferably pH3.5 to 13, more preferably pH6 to 13, and particularly pH6.5 to 10.5. In particular, for the case where the developer of pH2.0 to 10.0 is used, it is difficult to concomitantly preventing all of staining resistance, printing

durability, and long-term staining resistance from degrading. The reason why may be explained as below. When species of the developer is tried to change, while leaving the material for composing the lithographic printing plate precursor unchanged, the developer of pH2.0 to 10.0 will degrade the staining resistance of the unexposed area, as compared with the case where the conventional alkali developer of pH12 to 13 was used. On the other hand, a trial of elevating the hydrophilicity of the material so as to adapt it to the developer of pH2.0 to 10.0, aiming at improving the staining resistance, will result in a degrading tendency of the printing durability. By using the lithographic printing plate precursor according to the present invention, it is now possible to preferably use the developer of pH2.0 to 10.0.

The anionic surfactant used for the developer in the present invention is not specifically limited and is preferably selectable from fatty acid salts, abietate salts, hydroxyalkanesulfonate salts, alkanesulfonate salts, dialkylsulfosuccinate salts, straight-chain alkylbenzenesulfonate salts, branched alkylbenzenesulfonate salts, alkylnaphthalenesulfonate salts, alkyl diphenyl ether (di)sulfonate salts, alkylphenoxypolyoxyethylenealkylsulfonate salts, polyoxyethylenealkylsulfophenyl ether salts, sodium salts of N-alkyl-N-oleyltaurin, disodium salts of N-alkyl sulfolsuccinate monoamide, petroleum sulfonate salts, sulfated castor oil, sulfated beef tallow, sulfate ester salts of fatty acid alkyl ester, alkyl sulfate ester salts, polyoxyethylenealkyl ether sulfate ester salts, fatty acid monoglyceride sulfate ester salts, polyoxyethylenealkylphenyl ether sulfate ester salts, polyoxyethylenestyrylphenyl ether sulfate ester salts, alkylphosphoester salts, polyoxyethylenealkyl ether phosphoester salts, polyoxyethylenealkylphenyl ether phosphoester salts, partially saponified styrene-maleic anhydride copolymer, partially saponified olefin-maleic anhydride copolymer, and naphthalene sulfonate salt-formalin condensates. Among them, alkylbenzenesulfonate salts, alkylnaphthalenesulfonate salts, and alkyldiphenyl ether (di)sulfonate salts are particularly preferable.

The cationic surfactant used for the developer in the present invention is arbitrarily selectable from those known in the art, without special limitation. The examples include alkylamine salts, quaternary ammonium salts, alkylimidazolinium salt, polyoxyethylene alkylamine salts, and polyethylene polyamine derivative.

The nonionic surfactant used for the developer in the present invention is not specifically limited, and is selectable from ethylene oxide adduct of polyethylene glycol-type higher alcohol, ethylene oxide adduct of alkylphenol, ethylene oxide adduct of alkylnaphthol, ethylene oxide adduct of phenol, ethylene oxide adduct of naphthol, ethylene oxide adduct of fatty acid, ethylene oxide adduct of polyhydric alcohol fatty acid ester, ethylene oxide adduct of higher alkylamine, ethylene oxide adduct of fatty acid amide, ethylene oxide adduct of fat, ethylene oxide adduct of polypropylene glycol, dimethylsiloxane-ethylene oxide block copolymer, dimethylsiloxane-(propylene oxide -ethylene oxide) block copolymer, fatty acid ester of polyhydric alcohol-type glycerol, fatty acid ester of pentaerythritol, fatty acid ester of sorbitol and sorbitan, fatty acid ester of sucrose, polyhydric alcohol alkyl ether, and fatty acid amide of alkanolamines. Among them, those having an aromatic ring and an ethylene oxide chain are preferable, and more preferable examples include ethylene oxide adduct of alkyl substituted or unsubstituted phenol, or ethylene oxide adduct of alkyl substituted or unsubstituted naphthol.

The ampholytic ion-based surfactant used for the developer in the present invention is not specifically limited, and is selectable from amine oxide-based surfactant such as alkyldimethylamine oxide; betaine-based surfactant such as alkyl betaine; and amino acid-based surfactant such as sodium salt of alkylaminofatty acid. In particular, alkyl dimethylamine oxide which may have a substituent group, alkyl carboxybetaine which may have a substituent group, and alkyl sulfobetaine which may have a substituent group are preferably used. More specifically, the compounds represented by the formula (2) in paragraph [0256] of Japanese Laid-Open Patent Publication No. 2008-203359; the compounds represented by the formula (I), formula (II) and formula (VI) in paragraph [0028] of Japanese Laid-Open Patent Publication No. 2008-276166; and the compounds described in paragraphs [0022] to [0029] of Japanese Laid-Open Patent Publication No. 2009-47927 may be used.

Two or more species of the surfactant may be used in the developer. The content of the surfactant contained in the developer is preferably 0.01 to 20% by mass, and more preferably 0.1 to 10% by mass.

Examples of the water-soluble polymer compound used for the developer in the present invention include soybean polysaccharides, modified starch, gum arabic, dextrin, cellulose derivative (carboxymethyl cellulose, carboxyethyl cellulose, methyl cellulose, etc.) and modified product thereof, pullulan, polyvinyl alcohol and derivative thereof, polyvinylpyrrolidone, polyacrylamide and acrylamide copolymer, vinyl methyl ether/maleic anhydride copolymer, vinyl acetate/maleic anhydride copolymer, styrene/maleic anhydride copolymer, polyvinylsulfonic acid and salt thereof, and polystyrenesulfonic acid and salt thereof.

The soybean polysaccharides are selectable from those known in the art, such as those commercially available under the trade name of Soyafive (from Fuji Oil Co. Ltd.) with a variety of grades. Among them, those showing a viscosity of a 10% by mass aqueous solution of 10 to 100 mPa/sec are preferably used.

Also the modified starch is selectable from those known in the art, which may be prepared for example by decomposing starch derived from corn, potato, tapioca, rice, wheat or the like by acid or enzyme, so as to give molecules having 5 to 30 glucose residues, and by adding thereto oxypropylene in an alkaline solution.

Two or more species of the water-soluble polymer compounds may be used in the developer. The content of the water-soluble polymer compound in the developer is preferably 0.1 to 20% by mass, and more preferably 0.5 to 10%

by mass.

The developer used in the present invention may contain a pH buffering agent. For the developer of the present invention, the pH buffering agent is arbitrarily selectable without special limitation, so long as it exhibits a buffering action in the range from pH2 to 14. In the present invention, a weak alkaline buffering agent is preferably used, wherein the examples include (a) carbonate ion and hydrogen carbonate ion, (b) borate ion, (c) water-soluble amine compound and ion thereof, and combination of these ions. More specifically, (a) combination of carbonate ion and hydrogen carbonate ion, (b) borate ion, or (c) combination of water-soluble amine compound and ion thereof, for example, exhibits a pH buffering action in the developer, capable of suppressing pH from fluctuating even if the developer is used over a long period, and is therefore capable of suppressing degradation in the developability and generation of development scum due to fluctuation in pH. In the method of manufacturing the lithographic printing plate of the present invention, the combination of carbonate ion and hydrogen carbonate ion is particularly preferable.

In order to allow carbonate ion and hydrogen carbonate ion to reside in the developer, one possible method is to add a carbonate salt and a hydrogen carbonate salt into the developer, and another method is to adjust pH after the carbonate salt or hydrogen carbonate salt are added, so as to generate carbonate ion or hydrogen ion. While the carbonate salt and the hydrogen carbonate salt are not specifically limited, alkali metal salt is preferable. The alkali metal is exemplified by lithium, sodium, and potassium, wherein sodium is particularly preferable. The alkali metal may be used alone, or in combination of two or more species.

Total content of carbonate ion and hydrogen carbonate ion is preferably 0.05 to 5 mol/L in the developer, more preferably 0.07 to 2 mol/L, and particularly 0.1 to 1 mol/L.

The developer used in the present invention may contain an organic solvent. Examples of the organic solvent adoptable herein include aliphatic hydrocarbons (hexane, heptane, Isopar E, Isopar H, Isopar G (from Esso), etc.), aromatic hydrocarbon (toluene, xylene, etc.), halogenated hydrocarbon (methylene dichloride, ethylene dichloride, trichloroethylene, monochlorobenzene, etc.), and polar solvent. Examples of the polar solvent include alcohols (methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methylphenyl carbinol, n-amyl alcohol, methylamyl alcohol, etc.); ketones (acetone, methyl ethyl ketone, ethyl butyl ketone, methyl isobutyl ketone, cyclohexanone, etc.); esters (ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate, etc.); and others (triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide, N-methylpyrrolidone, etc.).

Two or more species of the organic solvent may be contained in the developer. If the organic solvent is not water-soluble, it may be used after solubilizing it into water with the aid of the surfactant or the like. When the developer contains the organic solvent, the content of the organic solvent is preferably less than 40% by mass, from the viewpoint of safety and inflammability.

Besides the above-described components, the developer of the in the present invention may also contain antiseptic, chelating compound, defoamer, organic acid, inorganic acid, inorganic salt and so forth. More specifically, the compounds described in paragraphs [0266] to [0270] of Japanese Laid-Open Patent Publication No. 2007-206217 are preferably used.

In the present invention, the developer may be used both as a developer and a supplementary developer for the lithographic printing plate precursor. It is also preferably adoptable to the automatic processor described in the above. In the process of development on the automatic processor, since the developer is exhausted with the progress of development, so that the supplementary solution or fresh developer may be used to restore the process capacity.

<On-machine development System>

In the on-machine development system, the lithographic printing plate precursor after pattern-wise exposure is fed, on a printing machine, with an oil-based ink and water-based component, so as to remove the image recording layer selectively in the non-image-forming area, to thereby give a lithographic printing plate.

More specifically, the lithographic printing plate precursor is exposed pattern-wise and then set on the printing machine without development, or, the lithographic printing plate precursor is set on the printing machine and then exposed pattern-wise on the printing machine. Next, printing is started by feeding the oil-based ink and the water-based component. In the non-image-forming area, the uncured image recording layer is removed in the early stage of printing, by dissolution or dispersion with the aid of the oil-based ink and/or water-based component fed thereto, and thereby the hydrophilic surface exposes in the area. On the other hand, in the light-exposed area, the image recording layer cured by exposure

forms an acceptance sites for oil-based ink where a lipophilic surface exposes. While it is arbitrary which of the oil-based ink and the water-based component is the first to be fed onto the surface of plate, it is more preferable to feed the oil-based ink first, in view of preventing the water-based component from being contaminated by components of the removed image recording layer. In this way, the lithographic printing plate precursor is developed on the printing machine, and is directly used in a large number of impressions. The oil-based ink and the water-based component are preferably a printing ink and fountain solution, respectively, which are used for general planographic printing.

In the method of manufacturing a lithographic printing plate from a lithographic printing plate precursor according to the present invention, the entire surface of the lithographic printing plate precursor may be heated before exposure, or during exposure, or between exposure and development, irrespective of the development style. By the heating, the image forming reaction in the recording layer may be accelerated, to thereby advantageously improve the sensitivity and printing durability, and stabilize the sensitivity. For the development by developer, it is also effective to subject the developed plate to post-heating or exposure over the entire surface, aiming at improving the strength of the image-forming area and printing durability. In general, the pre-heating is preferably proceeded under a mild condition typically at 150°C or lower. Too high temperature may result in curing of the non-image-forming area. On the other hand, the post-heating after development needs a very strong condition, typically at 100 to 500°C. Too low temperature may result in insufficient strength of the image-forming area, whereas too high temperature may degrade the support, or decompose the image-forming area.

EXAMPLES

Features of the present invention will further be detailed referring to Examples.

<Exemplary Synthesis>

(1) Synthesis of *N,N*-Bis(Carboxymethyl)Acrylamide

Water (360 ml) and a 30 w/v% aqueous sodium hydroxide solution (160 ml) were put in a 1-L three necked flask, and iminodiacetic acid (93.17 g) was added and dissolved therein while cooling the mixture on ice. Next, acryloyl chloride (63.36 g) was added while cooling the mixture on ice, and after completion of the dropping, the mixture was allowed to react at room temperature for 3 hours. After completion of the reaction, an unreacted portion of acryloyl chloride was removed with ethyl acetate, the mixture was added with concentrated hydrochloric acid (52.07 g), and then separated using ethyl acetate. The organic phase was dried over sodium sulfate, and the solvent was then removed under reduced pressure. The obtained white solid was reslurried using a mixed solvent of hexane (700 ml) and ethyl acetate (140 ml), and the slurry was filtered to thereby obtain the target compound (22.40 g).

(2) Synthesis of Specific Polymer Compound (P-1)

The N,N-bis(carboxymethyl)acrylamide (12.84 g) synthesized in (1), allyl methacrylate (2.16 g), and N-methylpyrrolidone (64.5 g) were put in a 200 ml three necked flask, and the mixture was stirred under heating at 75°C for 10 minutes, under a nitrogen gas flow. Thereafter, a solution obtained by dissolving V-601 (1.0 g) (from Wako Pure Chemical Industries, Ltd.) into N-methylpyrrolidone (20.5 g) was dropped over 3 hours. The mixture was added with V-601 (1.0 g), heated at 90°C for 3 hours, and then cooled, to thereby obtain a N-methylpyrrolidone solution of P-1.

(3) Synthesis of Specific Polymer Compound (P-3)

The *N,N*-bis(carboxymethyl)acrylamide (7.26 g) synthesized in (1), [3-(methacryloylamino)propyl]dimethyl-(3-sulfopropyl)am monium betain salt (4.76 g), 2-methacrylamidoethylamine (2.98 g), and distilled water (64.5 g) were put in a 200 ml three necked flask, and stirred under heating at 55°C for 10 minutes, under a nitrogen gas flow. Thereafter, a solution obtained by dissolving VA-046B (0.75 g) (from Wako Pure Chemical Industries, Ltd.) into distilled water (20.5 g) was dropped over 3 hours. The mixture was added with VA-046B (0.75 g) (from Wako Pure Chemical Industries, Ltd.), heated at 80°C for 3 hours, and then cooled. The obtained polymer solution was added with NaOH so as to adjust pH to 9.7. The mixture was then added with 4-hydroxy-tetramethyl piperidinyloxy (4-OH-TEMPO) (0.1 g) (from Tokyo Chemical Industry Co. Ltd.), heated to 55°C, added with methacrylic anhydride (12.0 g), and then allowed to react at 55°C for 6 hours. Thereafter, the mixture was separated using ethyl acetate (250 g), and the lower layer was collected. The collected lower layer was added with an ion exchanger resin "Amberlyst 15" (10 g) (from Ardrich), and then filtered to obtain an aqueous solution of polymer P-3.

Also the other polymers in the present invention were synthesized in a similar manner.

(B) Lithographic printing plate

Manufacturing of Lithographic printing plate precursor

[Manufacturing of Aluminum Support 1]

An aluminum plate of 0.3 mm thick (JIS A1050) was degreased, in order to remove rolling oil remained on the surface, using a 10% by mass aqueous sodium aluminate solution at 50°C for 30 seconds, grained using three bristle-bundle-implanted nylon brushes having a bristle diameter of 0.3 mm, and an aqueous suspension (specific gravity: 1.1 $g/cm^3$) of pumice having a median diameter of 25 μm, and then thoroughly washed with water. The plate was etched by dipping it into a 25% by mass aqueous sodium hydroxide solution at 45°C for 9 seconds, washed with water, dipped in a 20% by mass aqueous nitric acid solution at 60°C for 20 seconds, and then washed with water. The amount of etching of the grained surface was found to be approximately 3 $g/m^2$.

Next, the aluminum plate was subjected to continuous electrochemical surface roughening under AC voltage at 60 Hz, using a 1% by mass aqueous nitric acid solution (containing 0.5% by mass of aluminum ion) as an electrolytic solution at 50°C. The electrochemical surface roughening was proceeded using an AC power source producing a trapezoidal waveform with a zero-to-peak time TP of current value of 0.8 msec, and a duty ratio of 1:1, and by using a carbon electrode as the counter electrode, and a ferrite electrode as an auxiliary anode. The current density was 30 $A/dm^2$ in terms of peak current value, wherein 5% of the current fed from the power source was divided to the auxiliary anode. The quantity of electricity in the nitric acid electrolysis, with the aluminum plate connected to the anode, was 175 $C/dm^2$. The aluminum plate was then washed by spraying water.

Next, the aluminum plate was subjected to continuous electrochemical surface roughening similarly to the electrolysis in nitric acid, except that a 0.5% by mass aqueous hydrochloric acid solution (containing 0.5% by mass of aluminum ion) was used as an electrolytic solution at 50°C, under the quantity of electricity, measured with the aluminum plate connected to the anode, of 50 $C/dm^2$. The aluminum plate was then washed by spraying water. The plate was then subjected to DC anodizing in a 15% by mass aqueous sulfuric acid solution (containing 0.5% by mass of aluminum ion) used as an electrolytic solution, at a current density of 15 $A/dm^2$, to thereby form an anodized film of 2.5 $g/m^2$ thick, followed by washing with water and drying. An aluminum support 1 was thus manufactured.

From a measurement using a probe of 2 μm in diameter, the thus-obtained support was found to have a center line average roughness (Ra) of 0.51 μm.

[Manufacturing of Aluminum Support 2]

The aluminum support 1 was treated using a 1% by mass aqueous sodium silicate solution at 20°C for 10 seconds, to thereby manufacture an aluminum support 2. The surface roughness was found to be 0.54 μm (as Ra, conforming to JIS B0601).

[Manufacturing of Aluminum Support 3]

An aluminum plate (material 1050, work hardened H16) of 0.24 mm thick was degreased by dipping in a 5% aqueous sodium hydroxide solution kept at 65°C for 1 minute, and then washed with water. The aluminum plate was dipped into a 10% aqueous hydrochloric acid solution kept at 25°C for 1 minute for neutralization, and then washed with water. Next, the surface of the aluminum plate was roughened in a 0.3% by mass aqueous hydrochloric acid solution at 25°C for 60 seconds, under an AC current density of 100 $A/dm^2$, and then desmutted in a 5% aqueous sodium hydroxide solution kept at 60°C for 10 seconds. The aluminum plate was then anodized in a 15% aqueous sulfuric acid solution at 25°C for 1 minute, under a current density of 10 $A/dm^2$, and a voltage of 15V, to thereby form an aluminum support. The surface roughness was found to be 0.44 μm (as Ra, conforming to JIS B0601).

[Formation of Undercoat Layer]

A coating liquid for forming the undercoat layer having the composition shown below was coated on the aluminum support using a bar coater, and dried at 100 °C for 1 minute, to thereby form an undercoat layer. The dry amount of coating of the undercoat layer was found to be 12 $mg/m^2$.

<Coating Liquid for Forming Undercoat Layer>

· Polymer listed in Table below, or Comparative Polymer shown below 0.50 g
· methanol 90.0 g
· water 10.0 g

[Formation of Image Recording Layer 1]

A coating liquid 1 for forming an image recording layer having the composition listed below was coated on the undercoat layer by bar coating, and the work was dried at 90°C for 60 seconds in an oven, to thereby form an image recording layer 1 having a dry amount of coating of 1.3 g/$m^2$.

<Coating Liquid 1 for Forming Image Recording Layer>

· binder polymer (1) shown below (mass average molecular weight: 80,000) 0.34 g
· polymerizable compound (1) shown below 0.68 g (PLEX6661-O, from Degussa Japan Co. Ltd.)
· sensitizing dye (1) shown below 0.06 g
· polymerization initiator (1) shown below 0.18 g
· chain transfer agent (1) shown below 0.02 g
· dispersion of ε-phthalocyanine colorant 0.40 g (pigment: 15 parts by mass, dispersion aid (allyl methacrylate/methacrylate copolymer (mass average molecular weight: 60,000, copolymerization molar rartio:83/17)): 10 parts by mass, cyclohexanone: 15 parts by mass)
· heat polymerization inhibitor (aluminum salt of N-nitrosophenylhydroxylamine) 0.01 g
· fluorine-containing surfactant (1) shown below (mass average molecular weight: 10,000) 0.001 g
· polyoxyethylene-polyoxypropylene condensate 0.02 g (Pluronic L44, from ADEKA Corporation)
· dispersion of yellow pigment 0.04 g (yellow pigment (Novoperm Yellow H2G, from Clariant K.K.): 15 parts by mass, dispersion aid (allyl methacrylate/methacrylate copolymer (mass average molecular weight: 60,000, copolymerization molar ratio 83/17) ) : 10 parts by mass, cyclohexanone: 15 parts by mass)
· 1-methoxy-2-propanol 3.5 g
· methyl ethyl ketone 8.0 g

Binder polymer (1)

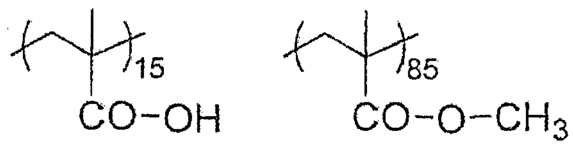

Acid value = 85 mg KOH/g

Polymerizable compound (1)

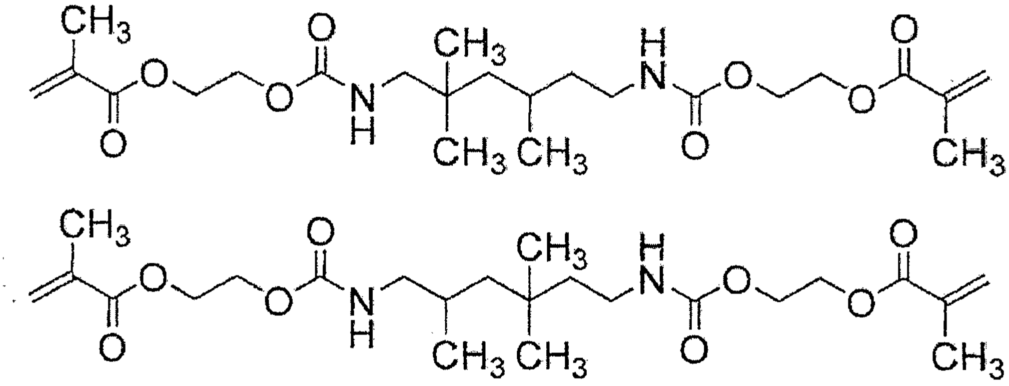

[Mixture of these two isomers]

Sensitizing dye (1)

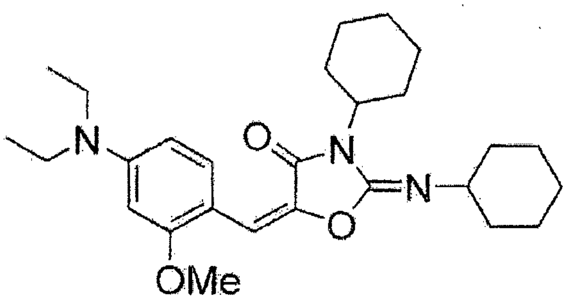

Polymerization initiator (1)

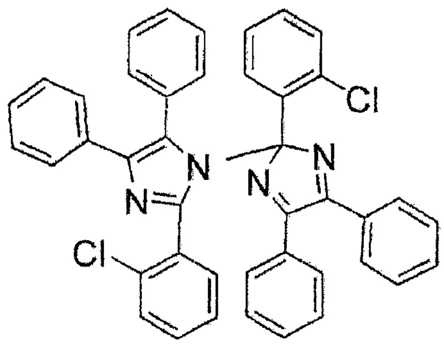

Chain transfer agent (1)

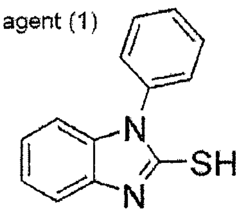

Fluorine-containing surfactant (1)

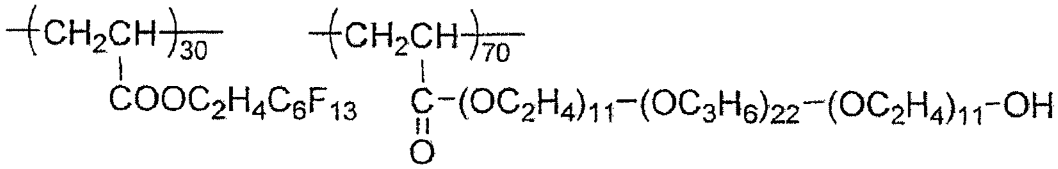

[Formation of Image Recording Layer 2]

A coating liquid 2 for forming an image recording layer was coated on the undercoat layer by bar coating, and the work was dried at 90°C for 60 seconds in an oven, to thereby form an image recording layer 2 having a dry amount of coating of 1.3 g/$m^2$.

<Coating Liquid 2 For Forming Image Recording Layer>

· binder polymer (1) shown in the above (mass average molecular weight: 50,000) 0.04 g
· binder polymer (2) shown below (mass average molecular weight: 80,000) 0.30 g
· polymerizable compound (1) shown in the above 0.17 g (PLEX6661-O, from Degussa Japan Co. Ltd.)
· polymerizable compound (2) shown below 0.51 g
· sensitizing dye (2) shown below 0.03 g
· sensitizing dye (3) shown below 0.015 g
· sensitizing dye (4) shown below 0.015 g
· polymerization initiator (1) shown in the above 0.13 g
· chain transfer agent: mercaptobenzothiazole 0.01 g
· dispersion of ε-phthalocyanine colorant 0.40 g (pigment: 15 parts by mass, dispersion aid (allyl methacrylate/methacrylate copolymer) (mass average molecular weight: 60,000, copolymerization molar ratio: 83/17) ) : 10 parts by mass, cyclohexanone: 15 parts by mass)
· heat polymerization inhibitor (N-nitrosophenylhydroxylamine aluminum salt) 0.01 g
· fluorine-containing surfactant (1) described in the above (mass average molecular weight: 10,000) 0.001 g
· 1-methoxy-2-propanol 3.5 g
· methyl ethyl ketone 8.0 g Binder polymer (2) (acid value: 66 mgKOH/g)

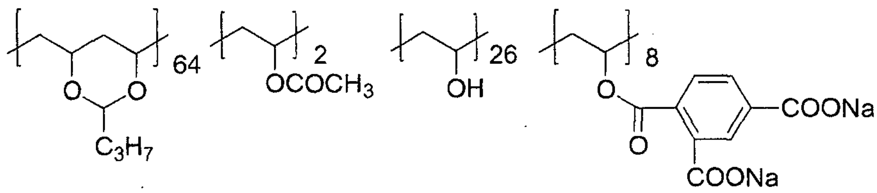

Polymerizable compound (2)

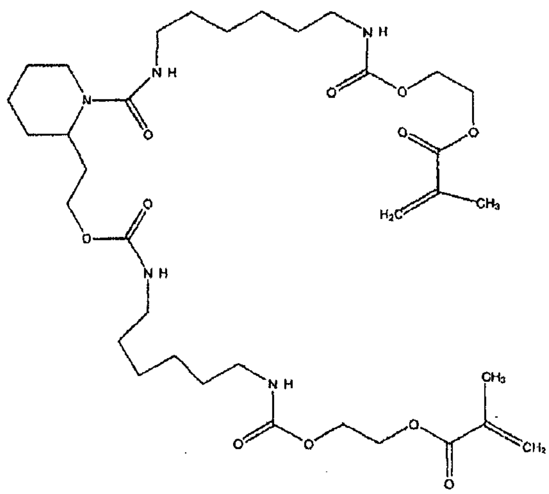

Sensitizing dye (2)

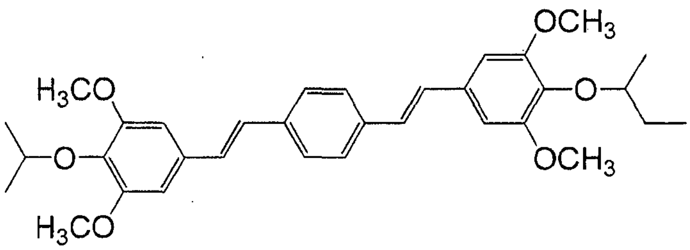

Sensitizing dye (3)

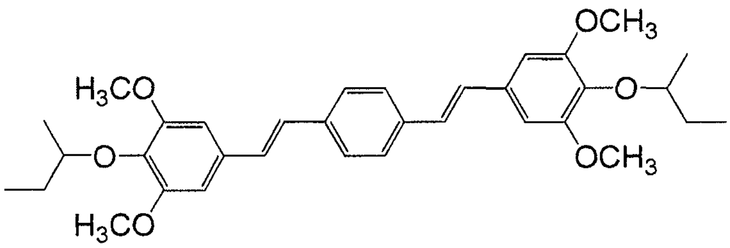

Sensitizing dye (4)

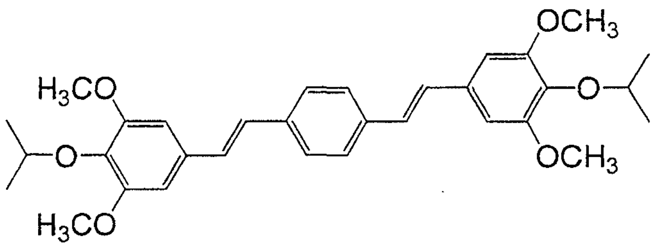

[Formation of Image Recording Layer 3]

A coating liquid 3 for forming an image recording layer was coated on the undercoat layer by bar coating, and the work was dried at 100°C for 60 seconds in an oven, to thereby form an image recording layer 3 having a dry amount of coating of 1.0 $g/m^2$.

The coating liquid for forming the image recording layer 3 was prepared by mixing the sensitizing liquid (1) shown below and the hydrophobization precursor liquid (1) shown below, immediately before coating.

<Sensitizing Liquid (1)>

· binder polymer (3) shown below 0.162 g
· infrared absorber (1) shown below 0.030 g
· polymerization initiator (3) shown below 0.162 g
· polymerizable compound (Alonix M215, Toagosei Co. Ltd.) 0.385 g
· surfactant (Pionin A-20, from Takemoto Oil & Fat Co. Ltd.) 0.055 g
· sensitizer (1) shown below 0.044 g
· fluorine-containing surfactant (1) shown in the above 0.008 g
· methyl ethyl ketone 1.091 g
· 1-methoxy-2-propanol 8.609 g

<Hydrophobization Precursor Liquid (1)>

· hydrophobization precursor water dispersion (1) shown below 2.640 g
· distilled water 2.425 g Binder polymer (3)

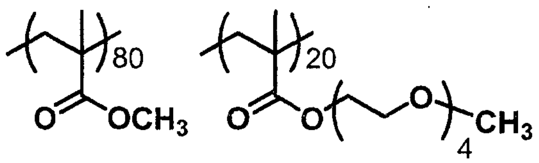

Mw=80,000

Infrared absorber (1)

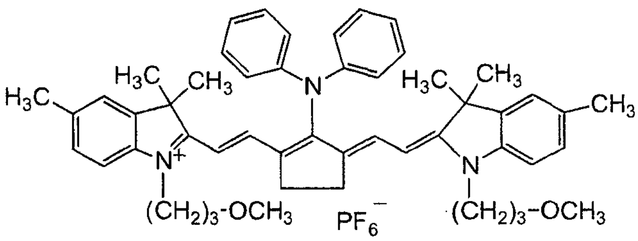

Polymerization initiator (3)

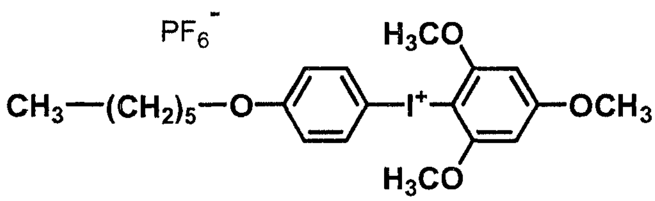

Sensitizer (1)

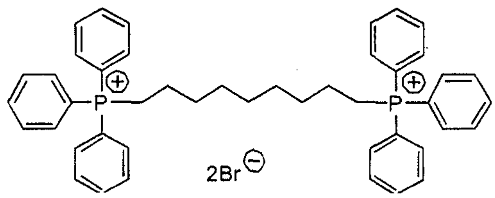

(Preparation of Water Dispersion of Hydrophobization Precursor (1))

Distilled water (350 ml) was placed in a 1000-ml four necked flask attached with a stirrer, a thermometer, a dropping funnel, a nitrogen introducing tube, and a reflux condenser, and was heated to attain an internal temperature of 80° C while introducing nitrogen gas for deoxigenation. Sodium dodecylsulfate (1.5 g) was added as a dispersion aid, ammonium persulfate (0.45 g) was added as an initiator, and a mixture of glycidyl methacrylate (45. 0 g) and styrene (45.0 g) was dropped from the dropping funnel over approximately 1 hour. After completion of the dropping, the reaction was allowed to proceed for 5 hours, and unreacted monomer was removed by steam distillation. The distillate was then cooled, adjusted to pH6 with an aqueous ammonia solution, and finally added with pure water so as to adjust the content of non-volatile matter to 15% by mass, to thereby obtain a water dispersion of hydrophobization precursor (1) containing a polymer particle. The particle size distribution of the polymer particle was found to maximize at 60 nm.

The particle size distribution was determined by capturing an image of the polymer particle under an electron microscope, measuring the size of total 5000 particles on the image, and plotting frequency of particles in the individual size intervals obtained by dividing the dimensional range from zero to the maximum value into 50 intervals according to the logarithmic scale. Size of aspherical particle was represented by size of spherical particle having the same surface area.

[Formation of Protective Layer 1]

A coating liquid 1 for forming the protective layer having the composition shown below was coated on the image recording layer by bar coating, so as to attain a dry amount of coating of 0.75 g/$m^2$, and the work was dried at 125°C for 70 seconds in an oven, to thereby form a protective layer 1.

[Coating Liquid 1 for Forming Protective Layer]

· polyvinyl alcohol (degree of saponification: 98 mol%, degree of polymerization: 500) 40 g
· polyvinyl pyrrolidone (molecular weight: 50,000) 5 g
· poly[vinyl pyrrolidone/vinyl acetate (1/1)] (molecular weight: 70,000) 0.5 g
· surfactant (Emalex 710, from Nihon Emulsion Co. Ltd.) 0.5 g
· water 950 g

[Formation of Protective Layer 2]

A coating liquid for forming the protective layer 2 having the composition shown below was coated on the image recording layer by bar coating, so as to attain a dry amount of coating of 0.75 g/$m^2$, and the work was dried at 125°C for 70 seconds in an oven, to thereby form a protective layer 2.

[Coating Liquid 2 for forming Protective Layer]

- · dispersion of inorganic layered compound (1) shown below 1.5 g
- · 6% by mass aqueous solution of sulfonic acid-modified polyvinyl alcohol 0.55 g (CKS50, from Nippon Synthetic Chemical Industry Co. Ltd., degree of saponification: ≥99 mol%, degree of polymerization: 300)
- · 6% by mass aqueous solution of polyvinyl alcohol 0.03 g (PVA-405, from Kuraray Co. Ltd., degree of saponification: 81.5 mol%, degree of polymerization 500)
- · 1% by mass aqueous solution of surfactant (Emalex 710, from Nihon Emulsion Co. Ltd.) 0.86 g
- · deionized water 6.0 g (Preparation of Dispersion (1) of Inorganic Layered Compound)

To 193.6 g of deionized water, 6.4 g of a synthetic mica (Somasif ME-100, from CO-OP Chemical Co. Ltd.) was added, and the mixture was allowed to disperse using a homogenizer until an average particle size of 3 μm is confirmed by laser scattering method, to thereby prepare a dispersion (1) of an inorganic layered compound. The aspect ratio of the dispersed particle thus obtained was found to be 100 or larger.

The aluminum support, the undercoat layer, the image recording layer, and the protective layer were combined as listed in Tables below, to thereby manufacture the original plates of lithographic printing plate according to Examples and Comparative Examples. The polymers used in Comparative Examples are as listed below.

(R-1)
Mw=20,000

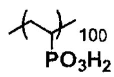

(R-2)
Mw=120,000

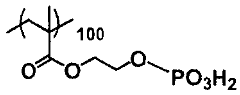

(R-3)
Mw=180,000

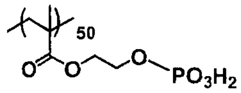
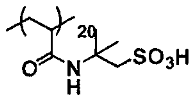
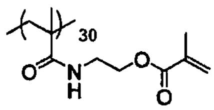

(R-4)
Mw=15,000

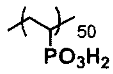
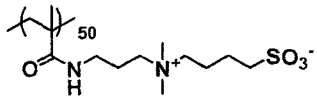

(R-5)
Mw=130,000

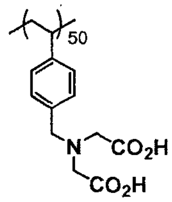
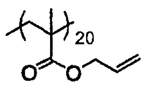
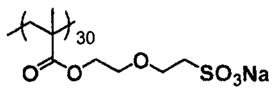

(R-6)
Compound Described in Patent Document 2 (JP-A-2007-72308)

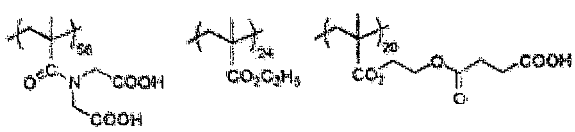

[Evaluation of Quality Of Coated Surface]

Quality of coated surface of the obtained negative lithographic printing plate precursor [A-1] was visually evaluated. Results are shown in Table below. Results are shown in Table below. The surface found to be smooth and uniform was denoted as "good".

[Table 1]

| Lithographic printing plate precursor | Aluminum support | polymer Specific polymer compound | Coating liquid for forming image recording layer | Coating liquid for forming protective layer | Quality of coated surface |
|---|---|---|---|---|---|
| A-1 | 1 | P-1 | 1 | 1 | good |
| A-2 | 1 | P-2 | 1 | 1 | good |
| A-3 | 1 | P-3 | 1 | 1 | good |
| A-4 | 1 | P-4 | 1 | 1 | good |
| A-5 | 1 | P-5 | 1 | 1 | good |
| A-6 | 1 | P-6 | 1 | 1 | good |
| A-7 | 1 | P-7 | 1 | 1 | good |
| A-8 | 1 | P-8 | 1 | 1 | good |
| A-9 | 1 | P-9 | 1 | 1 | good |
| A-10 | 1 | P-10 | 1 | 1 | good |
| A-11 | 1 | P-11 | 1 | 1 | good |
| A-12 | 1 | P-12 | 1 | 1 | good |
| A-13 | 1 | P-13 | 1 | 1 | good |
| A-14 | 1 | P-14 | 1 | 1 | good |
| A-15 | 1 | P-15 | 1 | 1 | good |
| A-16 | 1 | P-16 | 1 | 1 | good |
| A-17 | 1 | P-17 | 1 | 1 | good |
| A-18 | 1 | P-18 | 1 | 1 | good |
| A-19 | 1 | P-19 | 1 | 1 | good |
| A-20 | 1 | P-20 | 1 | 1 | good |
| A-21 | 1 | P-21 | 1 | 1 | good |
| A-22 | 1 | P-22 | 1 | 1 | good |
| A-23 | 1 | P-23 | 1 | 1 | good |
| A-24 | 1 | P-24 | 1 | 1 | good |
| A-25 | 1 | P-25 | 1 | 1 | good |
| A-26 | 1 | P-26 | 1 | 1 | good |

[Table 2]

| Lithographic printing plate precursor | Aluminum support | Specific polymer compound | Coating liquid for forming image recording layer | Coating liquid for forming protective layer | Quality of coated surface |
|---|---|---|---|---|---|
| A-27 | 3 | P-1 | 2 | 1 | good |
| A-28 | 3 | P-2 | 2 | 1 | good |
| A-29 | 3 | P-4 | 2 | 1 | good |
| A-30 | 3 | P-6 | 2 | 1 | good |

(continued)

| Lithographic printing plate precursor | Aluminum support | Specific polymer compound | Coating liquid for forming image recording layer | Coating liquid for forming protective layer | Quality of coated surface |
|---|---|---|---|---|---|
| A-31 | 3 | P-7 | 2 | 1 | good |
| A-32 | 3 | P-14 | 2 | 1 | good |
| A-33 | 3 | P-15 | 2 | 1 | good |
| A-34 | 2 | P-1 | 3 | 2 | good |
| A-35 | 2 | P-2 | 3 | 2 | good |
| A-36 | 2 | P-4 | 3 | 2 | good |
| A-37 | 2 | P-6 | 3 | 2 | good |
| A-38 | 2 | P-7 | 3 | 2 | good |
| A-39 | 2 | P-14 | 3 | 2 | good |
| A-40 | 2 | P-15 | 3 | 2 | good |
| B-1 | 1 | R-1 | 1 | 1 | not uniform |
| B-2 | 1 | R-2 | 1 | 1 | not uniform |
| B-3 | 1 | R-3 | 1 | 1 | not uniform |
| B-4 | 1 | R-4 | 1 | 1 | not uniform |
| B-5 | 1 | R-5 | 1 | 1 | not uniform |
| B-6 | 3 | R-2 | 2 | 1 | not uniform |
| B-7 | 3 | R-4 | 2 | 1 | not uniform |
| B-8 | 3 | R-5 | 2 | 1 | not uniform |
| B-9 | 2 | R-4 | 3 | 2 | not uniform |
| B-10 | 2 | R-5 | 3 | 2 | not uniform |
| B-11 | 1 | R-6 | 1 | 1 | not uniform |
| B-12 | 1 | なし | 1 | 1 | not uniform |

All of the lithographic printing plate precursors of the present invention were found to show good quality of the coated surface, whereas all of the lithographic printing plate precursors of Comparative Examples were found to show non-uniformity on the coated surface. (2) Evaluation of Lithographic printing plate precursor

(Examples 1 to 138, Comparative Examples 1 to 19)

[Exposure, Development and Printing]

Each of the original plates of lithographic printing plate was exposed pattern-wise using a Violet semiconductor laser plate setter Vx9600 (with an InGaN-based semiconductor laser (emission wavelength: 405 nm±10 nm/output 30 mW)), from FUJIFILM Electronic Imaging Ltd. (FFEI). The pattern-wise exposure was conducted at a resolution of 2,438 dpi, using an FM screen (TAFFETA 20) from FUJIFILM Corporation, while adjusting the exposure energy on the surface to 0.05 mJ/cm$^2$ so as to attain a dot area ratio of 50%.

Next, each plate was pre-heated at 100°C for 30 seconds, and then developed using each of the developers listed below, and using the automatic processor configured as illustrated in FIG. 2. The automatic processor had one brush roll of 50 mm in outer diameter, implanted with polybutylene terephthalate bristles (bristle diameter: 200 μm, bristle length: 17 mm), which was rotated at 200 rpm in the same direction as the transfer direction (peripheral speed at the brush end: 0.52 m/sec). Temperature of the developer was kept at 30°C. The lithographic printing plate precursor was transferred at 100 cm/min. After the development, the original plate was dried at 80°C. Note that the development using

the developer 2 was followed by water washing, prior to the drying process.

Compositions of the developers 1 to 5 are shown below. In the compositions below, Newcol B13 (from Nippon Nyukazai Co. Ltd.) is a polyoxyethylene β-naphthyl ether (average number of oxyethylene units n: 13), and gum arabic has a mass average molecular weight of 200,000.

<Developer 1>

· sodium carbonate 13.0 g
· sodium hydrogen carbonate 7.0 g
· Newcol B13 50.0 g
· primary ammonium phosphate 2.0 g
· 2-bromo-2-nitropropane-1,3-diol 0.01 g
· 2-methyl-4-isotiazoline-3-one 0.01 g
· trisodium citrate 15.0 g
· distilled water 913.98 g (pH: 9.8)

<Developer 2>

· potassium hydroxide 0.15 g
· Newcol B13 5.0 g
· Chelest 400 (chelating agent) 0.1 g
· distilled water 94.75 g (pH: 12.05)

<Developer 3>

· gum arabic 25.0 g
· enzyme-modified potato starch 70.0 g
· sodium salt of dioctylsulfosuccinic ester 5.0 g
· primary ammonium phosphate 1.0 g
· citric acid 1.0 g
· 2-bromo-2-nitropropane-1,3-diol 0.01 g
· 2-methyl-4-isothiazophosphorus-3-one 0.01 g
· ampholytic surfactant (W-1) shown below 70.0 g
· anionic surfactant (AN-1) shown below 3.0 g
· distilled water 824.98 g
(pH adjusted to 4.5 with phosphoric acid and sodium hydroxide)

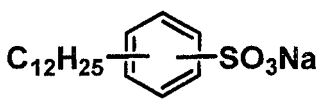

(AN-1)

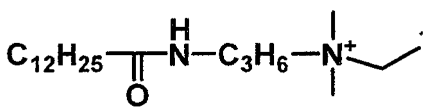

(W-1)

<Developer 4>

· water 937.2 g

· anionic surfactant (W-2) shown below 23.8 g
· phosphoric acid 3 g
· phenoxypropanol 5 g
· triethanolamine 6 g
· potato dextrin 25 g
(pH adjusted to 7.0 with phosphoric acid)

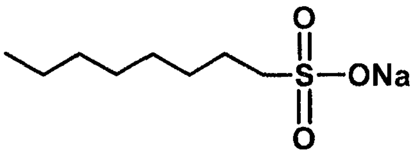

(W-2)

<Developer 5>

· water 88.6 g
· nonionic surfactant (W-3) shown below 2.4 g
· nonionic surfactant (W-4) shown below 2.4 g
· nonionic surfactant 1.0 g
(Emalex 710, from Nihon Emulsion Co. Ltd.)
· phenoxypropanol 1.0 g
· octanol 0.6 g
· N-(2-hydroxyethyl)morpholine 1.0 g
· triethanolamine 0.5 g
· sodium gluconate 1.0 g
· trisodium citrate 0.5 g
· tetrasodium ethylenediamine tetraacetate 0.05 g
· polystyrenesulfonic acid 1.0 g (Versa TL77 (30% solution), from Alco Chemical)
(pH adjusted to 7.0 with phosphoric acid)

Nonionic surfactant (W-3)

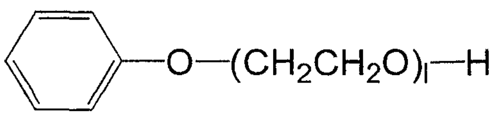

l=13-28

Nonionic surfactant (W-4)

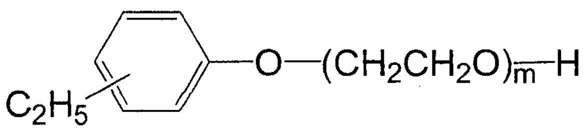

m=12-26

Each of the thus-obtained lithographic printing plates was set on a printing machine SOR-M from Heidelberg, and subjected to printing at a printing speed of 6000 imprints per hour, using a fountain solution (EU-3, etching solution from FUJIFILM Corporation)/water/isopropanol=1/89/10 (ratio by volume)) and a black ink (TRANS-G(N), from DIC Corporation).

[Evaluation]

Each of the original plates of lithographic printing plate was evaluated for printing durability, and staining resistance as described below. Results are shown in Tables below.

<Printing durability>

Ink density on the printing paper was found to decrease as the number of impressions increased, due to gradual wear of the image recording layer and consequent degradation in the ink receptivity. The printing durability was evaluated by the number of impressions up to the time when the ink density (reflection density) decreased by 0.1 from that observed at the start of printing, under the same exposure energy. The larger the number of impressions, the higher the printing durability.

Printing durability was evaluated according to relative printing durability defined by the equation below, wherein Examples 1 to 26 and Comparative Examples 1 to 7 were evaluated on the basis of Comparative Example 1 (assumed as 1.0), Examples 27 to 33 and Comparative Examples 8 to 10 were evaluated on the basis of Comparative Example 8, and, Examples 34 to 42 and Comparative Examples 11 to 13 were evaluated on the basis of Comparative Example 11. The larger the value of relative printing durability, the better the printing durability.

Relative printing durability = (printing durability of target lithographic printing plate precursor) / (printing durability of reference lithographic printing plate precursor)

<Staining resistance>

A printed matter from the 20th impression after the start of printing was sampled, and the staining resistance was evaluated based on the density of ink adhered in the non-image-forming area. Since the adhesion of ink in the non-image-forming area do not always occur in a uniform manner, so that the adhesion was expressed by scores per 75-$cm^2$ area based on visual observation. Scores of visual observation are as follow: "10" for a ratio of ink adhesion area of 0%; "9" for the ratio exceeding 0% and not exceeding 10%; "8" for the ratio exceeding 10% and not exceeding 20%; "7" for the ratio exceeding 20% and not exceeding 30%; "6" for the ratio exceeding 30% and not exceeding 40%; "5" for the ratio exceeding 40% and not exceeding 50%; "4" for the ratio exceeding 50% and not exceeding 60%; "3" for the ratio exceeding 60% and not exceeding 70%; "2" for the ratio exceeding 70% and not exceeding 80%; "1" for the ratio exceeding 80% and not exceeding 90%; and "0" for the ratio exceeding 90% and not exceeding 100%. The larger the score, the better the staining resistance.

[Table 3]

| | Lithographic printing plate precursor | treatment liquid | Printing property | |
|---|---|---|---|---|
| | | | Printing durability | Staining resistance |
| Example 1 | A-1 | 1 | 1.8 | 7 |
| Example 2 | A-2 | 1 | 1.7 | 8 |
| Example 3 | A-3 | 1 | 2.2 | 9 |
| Example 4 | A-3 | 3 | 2.1 | 10 |
| Example 5 | A-3 | 4 | 1.9 | 8 |
| Example 6 | A-3 | 5 | 2.0 | 9 |
| Example 7 | A-4 | 1 | 2.0 | 9 |
| Example 8 | A-5 | 1 | 1.9 | 9 |
| Example 9 | A-6 | 1 | 1.8 | 8 |

(continued)

| | Lithographic printing plate precursor | treatment liquid | Printing property | |
|---|---|---|---|---|
| | | | Printing durability | Staining resistance |
| Example 10 | A-7 | 1 | 1.9 | 8 |
| Example 11 | A-8 | 1 | 1.7 | 8 |
| Example 12 | A-9 | 1 | 1.7 | 8 |
| Example 13 | A-10 | 1 | 2.1 | 9 |
| Example 14 | A-11 | 1 | 1.7 | 7 |
| Example 15 | A-12 | 1 | 2.0 | 10 |
| Example 16 | A-13 | 1 | 1.6 | 8 |
| Example 17 | A-14 | 1 | 2.1 | 10 |
| Example 18 | A-15 | 1 | 2.0 | 10 |
| Example 19 | A-16 | 1 | 1.9 | 9 |
| Example 20 | A-17 | 1 | 2.0 | 9 |
| Example 21 | A-18 | 1 | 2.0 | 8 |
| Example 22 | A-19 | 1 | 1.7 | 8 |
| Example 23 | A-20 | 1 | 1.7 | 7 |
| Example 24 | A-21 | 1 | 1.7 | 8 |
| Example 25 | A-22 | 1 | 1.8 | 7 |
| Example 26 | A-23 | 1 | 1.7 | 8 |
| comparative Example 1 | B-1 | 1 | 1.0 | 3 |
| comparative Example 2 | B-2 | 1 | 1.1 | 2 |
| comparative Example 3 | B-3 | 1 | 1.2 | 4 |
| comparative Example 4 | B-4 | 1 | 0.6 | 5 |
| comparative Example 5 | B-5 | 1 | 1.4 | 5 |
| comparative Example 6 | B-12 | 1 | 0.8 | 0 |
| comparative Example 7 | B-11 | 1 | 0.4 | 5 |

[Table 4]

| | Lithographic printing plate precursor | treatment liquid | Printing property | |
|---|---|---|---|---|
| | | | Printing durability | Staining resistance |
| Example 27 | A-1 | 2 | 2.0 | 7 |
| Example 28 | A-2 | 2 | 1.9 | 8 |

(continued)

| | Lithographic printing plate precursor | treatment liquid | Printing property | |
|---|---|---|---|---|
| | | | Printing durability | Staining resistance |
| Example 29 | A-4 | 2 | 2.3 | 10 |
| Example 30 | A-6 | 2 | 2.0 | 8 |
| Example 31 | A-7 | 2 | 2.1 | 8 |
| Example 32 | A-14 | 2 | 2.3 | 10 |
| Example 33 | A-15 | 2 | 2.2 | 10 |
| comparative Example 8 | B-2 | 2 | 1.0 | 4 |
| comparative Example 9 | B-4 | 2 | 0.2 | 5 |
| comparative Example 10 | B-5 | 2 | 1.2 | 5 |

[Table 5]

| | Lithographic printing plate precursor | treatment liquid | Printing property | |
|---|---|---|---|---|
| | | | Printing durability | Staining resistance |
| Example 34 | A-27 | 4 | 1.8 | 7 |
| Example 35 | A-27 | 1 | 1.8 | 8 |
| Example 36 | A-27 | 5 | 1.8 | 7 |
| Example 37 | A-28 | 4 | 1.8 | 8 |
| Example 38 | A-29 | 4 | 2.2 | 10 |
| Example 39 | A-30 | 4 | 1.7 | 8 |
| Example 40 | A-31 | 4 | 1.9 | 7 |
| Example 41 | A-32 | 4 | 2.2 | 10 |
| Example 42 | A-33 | 4 | 2.1 | 10 |
| comparative Example 11 | B-6 | 4 | 1.0 | 3 |
| comparative Example 12 | B-7 | 4 | 0.5 | 4 |
| comparative Example 13 | B-8 | 4 | 1.1 | 4 |

As is clear from Tables in the above, the lithographic printing plate precursors of the present invention were found to be excellent in coatability, and also in printing durability and staining resistance.

It was also found that the effect was slightly suppressed when the repeating unit having an ethylenic unsaturated bond in the side chain thereof contains an aromatic group (Example 23).

It was also found that the effect was slightly suppressed when the repeating unit having a hydrophilic group in the side chain thereof was not derived from a (meth)acrylic monomer (Example 24).

It was also found that the effect was slightly suppressed when the ratio of addition of the repeating unit represented by the formula (O) in the polymer (A) was slightly fewer (Example 26).

[Exposure, Development and Printing]

Each of the original plates of lithographic printing plate listed in Tables below was exposed pattern-wise using a Trendsetter 3244VX from Creo (with a water-cooled, 40-W infrared semiconductor laser (830 nm)). The pattern-wise exposure was conducted at an output of 9 W, a number of rotation of external drum of 210 rpm, and a resolution of 2,400 dpi, so as to attain a dot area ratio of 50%. Each plate was then developed using the developers 1 or 4, on the automatic processor configured as illustrated in FIG. 1, by setting the heater so as to adjust the plate surface temperature in the pre-heating section to 100°C, and by controlling the transfer speed so as to adjust the dipping time (development time) in the developer to 20 seconds.

Each of the thus-obtained lithographic printing plates was set on a printing machine SOR-M from Heidelberg, and subjected to printing at a printing speed of 6000 imprints per hour, using a fountain solution (EU-3, etching solution from FUJIFILM Corporation)/water/isopropanol=1/89/10 (ratio by volume)) and a black ink (TRANS-G(N), from DIC Corporation).

The printing durability and staining resistance of the individual lithographic printing plate precursors were evaluated similarly to Example 1. The printing durability was evaluated according to relative printing durability defined by the equation below, wherein Examples 43 to 49 and Comparative Examples 14, 15 were evaluated on the basis of Comparative Example 1 (assumed as 1.0), and Examples 50 to 56 and Comparative Examples 16, 17 were evaluated on the basis of Comparative Example 16. The larger the value of relative printing durability, the better the printing durability.

[Table 6]

| | Lithographic printing plate precursor | treatment liquid | Printing property | |
|---|---|---|---|---|
| | | | Printing durability | Staining resistance |
| Example 43 | A-34 | 1 | 1.8 | 8 |
| Example 44 | A-35 | 1 | 1.9 | 9 |
| Example 45 | A-36 | 1 | 2.1 | 10 |
| Example 46 | A-37 | 1 | 1.8 | 8 |
| Example 47 | A-38 | 1 | 1.8 | 9 |
| Example 48 | A-39 | 1 | 2.2 | 10 |
| Example 49 | A-40 | 1 | 2.1 | 10 |
| comparative Example 14 | B-9 | 1 | 1.0 | 4 |
| comparative Example 15 | B-10 | 1 | 1.6 | 4 |

[Table 7]

| | Lithographic printing plate precursor | treatment liquid | Printing property | |
|---|---|---|---|---|
| | | | Printing durability | Staining resistance |
| Example 50 | A-34 | 4 | 1.7 | 6 |
| Example 51 | A-35 | 4 | 1.6 | 7 |
| Example 52 | A-36 | 4 | 2.0 | 9 |
| Example 53 | A-37 | 4 | 1.7 | 7 |
| Example 54 | A-38 | 4 | 1.8 | 7 |
| Example 55 | A-39 | 4 | 2.0 | 9 |
| Example 56 | A-40 | 4 | 1.9 | 9 |

(continued)

| | Lithographic printing plate precursor | treatment liquid | Printing property | |
|---|---|---|---|---|
| | | | Printing durability | Staining resistance |
| comparative Example 16 | B-9 | 4 | 1.0 | 3 |
| comparative Example 17 | B-10 | 4 | 1.4 | 3 |

[Exposure, Development and Printing]

Each of the original plates of lithographic printing plate was exposed using Luxel Platesetter T-6000III from FUJIFILM Corporation, with an infrared semiconductor laser, at a number of rotation of external drum of 1000 rpm, a laser output of 70%, and a resolution of 2,400 dpi. The pattern was prepared to contain a solid image and a 50% halftone chart of a 20-μm-dot FM screen. The exposed lithographic printing plate precursor, without being developed, was attached to a plate cylinder of printing machine LITHRONE 26, from Komori Corporation. The plate was then developed on-press, using a fountain solution [(Ecolity-2, from FUJIFILM Corporation)/tap water=2/98 (ratio by volume)], and a black ink (Values-G(N), from DIC Corporation), by feeding the fountain solution and the ink according to the standard scheme of starting printing on LITHRONE 26, and then subjected to printing on 100 sheets of Tokubishi art paper (76.5 kg), at a printing speed of 10,000 imprints per hour.

<Printing Durability>

As the number of impression increased, ink density on the printed matter decreased, due to gradual wear of the image recording layer. The printing durability was evaluated while assuming the end of printing by the number of impression at which the dot area ratio of an FM screen with a dot area ratio of 50%, measured on the printed matter using a Gretag densitometer, was found to decrease by 5% from the measured value on the 100-th printed matter. The printing durability was expressed on the basis of Comparative Example 18 (assumed as 1.0), by the relative printing durability defined by the equation below. The larger the value of relative printing durability, the better the printing durability.

Relative printing durability = (Printing durability of target lithographic printing plate precursor)/(printing durability of reference lithographic printing plate precursor)

[Table 8]

| | Lithographic printing plate precursor | Printing property | |
|---|---|---|---|
| | | Printing durability | Staining resistance |
| Example 57 | A-34 | 1.7 | 7 |
| Example 58 | A-35 | 1.8 | 8 |
| Example 59 | A-36 | 2.0 | 10 |
| Example 60 | A-37 | 1.9 | 8 |
| Example 61 | A-38 | 1.8 | 8 |
| Example 62 | A-39 | 2.2 | 10 |
| Example 63 | A-40 | 2.0 | 10 |
| comparative Example18 | B-9 | 1.0 | 5 |

(continued)

| | Lithographic printing plate precursor | Printing property | |
|---|---|---|---|
| | | Printing durability | Staining resistance |
| comparative Example19 | B-10 | 1.3 | 3 |

## Claims

1. A lithographic printing plate precursor having, on a support, an undercoat layer and an image recording layer stacked in this order, the undercoat layer containing a polymer (A) containing a repeating unit (a1) represented by the formula (O), and a repeating unit (a2) having an ethylenic unsaturated bond in the side chain thereof:

Formula (O)

(0)

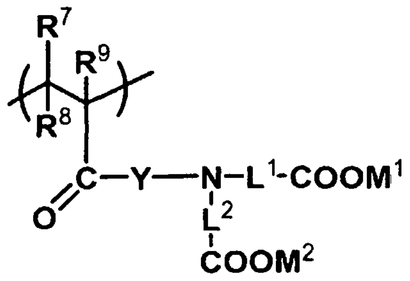

in the formula (O), each of $R^7$ to $R^9$ independently represents a hydrogen atom, halogen atom, or methyl group, Y represents a single bond, or a divalent linking group which may have a substituent, each of $L^1$ and $L^2$ independently represents a single bond, or a divalent linking group which may have a substituent, $L^1$ or the substituent on $L^1$, and $L^2$ or the substituent on $L^2$ may combine with each other to form a ring; each of $M^1$ and $M^2$ independently represents a hydrogen atom or monovalent metal ion or ammonium.

2. The lithographic printing plate precursor of Claim 1, wherein the polymer (A) further contains a repeating unit having a hydrophilic group (a3) in the side chain thereof.

3. The lithographic printing plate precursor of Claim 2, wherein the repeating unit having a hydrophilic group (a3) in the side chain thereof is a repeating unit derived from a (meth)acrylic monomer.

4. The lithographic printing plate precursor of Claim 2 or 3, wherein the repeating unit having a hydrophilic group (a3) in the side chain thereof has structure (s) represented by the formula formulae (a3-1) and/or (a3-2) below, in the side chain thereof:

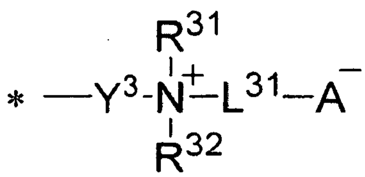

(a3-1)

in the formula (a3-1), each of $R^{31}$ and $R^{32}$ independently represents a hydrogen atom, alkyl group, alkenyl group, alkynyl group, aryl group, or heterocyclic group, $R^{31}$ and $R^{32}$ may combine to form a ring, $L^{31}$ represents a divalent linking group, and A-represents a structure having an anion; $Y^3$ represents a single bond or a divalent linking group which may have a substituent; * represents a connector;

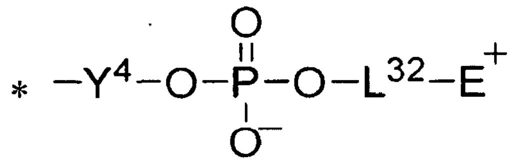

(a3-2)

in the formula (a3-2), $L^{32}$ represents a divalent linking group, and $E^+$ represents a structure having a cation; $Y^4$ represents a single bond or a divalent linking group which may have a substituent; * represents a connector.

**5.** The lithographic printing plate precursor of Claim 4, wherein the repeating unit having a hydrophilic group (a3) in the side chain thereof is represented by the formula (a3-3) below:

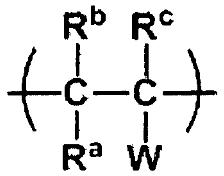 (a3-3)

in the formula (a3-3), each of $R^a$ to $R^c$ independently represents a hydrogen atom, $C_{1-6}$ alkyl group or halogen atom; W represents a structure represented by the formula (a3-1) or formula (a3-2), and is bound to a carbon atom at the position indicated by * in the formula (a3-1) or formula (a3-2).

**6.** The lithographic printing plate precursor of any one of Claims 1 to 5, wherein the repeating unit (a2) having an ethylenic unsaturated bond in the side chain thereof is a repeating unit derived from a (meth)acrylic monomer.

**7.** The lithographic printing plate precursor of any one of Claims 1 to 5, wherein the repeating unit (a2) having an ethylenic unsaturated bond in the side chain thereof is represented by the formula (a2-1):

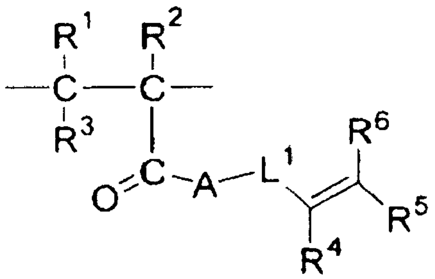 (a2-1)

in the formula (a2-1), each of $R^1$ to $R^3$ independently represents a hydrogen atom, $C_{1-6}$ alkyl group, or halogen atom; each of $R^4$ to $R^6$ independently represents a hydrogen atom, $C_{1-6}$ alkyl group, halogen atom, acyl group, or acyloxy group; $R^4$ and $R^5$, or $R^5$ and $R^6$, may combine to form a ring; "A" represents an oxygen atom or $NR^7$-, $R^7$ represents a hydrogen atom or $C_{1-10}$ monovalent hydrocarbon group. $L^1$ represents a single bond or a divalent linking group which may have a substituent.

**8.** The lithographic printing plate precursor of any one of Claims 1 to 7, wherein each of $L^1$ and $L^2$ independently represents a single bond, alkylene group which may have a substituent, cycloalkylene group which may have a substituent, or arylene group which may have a substituent, $L^1$ or the substituent on $L^1$, and $L^2$ or the substituent on $L^2$ may combine with each other to form a ring.

**9.** The lithographic printing plate precursor of any one of Claims 1 to 8, wherein Y in the formula (O) is a single bond, or, a divalent linking group selected from the group consisting of -CO-, -O-, -NH-, divalent aliphatic group, divalent aromatic group and arbitrary combinations of them.

**10.** The lithographic printing plate precursor of any one of Claims 1 to 9, wherein the image recording layer of the lithographic printing plate precursor is removable with an aqueous solution of pH2 to 10.

**11.** The lithographic printing plate precursor of any one of Claims 1 to 10, wherein the image recording layer of the lithographic printing plate precursor is removable with at least either of a printing ink and dampening solution.

**12.** A method of manufacturing a lithographic printing plate comprising exposing the lithographic printing plate precursor described in any one of Claims 1 to 11 to light in a pattern-wise manner; and removing an unexposed portion of the image recording layer of the lithographic printing plate precursor under the presence of a developer of pH2 to 10.

**13.** The method of manufacturing a lithographic printing plate of Claim 12, further comprising forming a protective layer on the surface of the support opposite to the surface having the image recording layer formed thereon,
wherein the developing process further comprises removing an unexposed portion of the image recording layer together with the protective layer under the presence of the developer further containing a surfactant, but excluding the water washing process.

**Patentansprüche**

**1.** Lithographischer Druckplattenvorläufer, der auf einem Träger eine Unterschicht und eine Bildaufnahmeschicht aufweist, gestapelt in dieser Reihenfolge, wobei die Unterschicht ein Polymer (A) enthält, umfassend eine Wiederholungseinheit (a1), dargestellt durch die Formel (0), und eine Wiederholungseinheit (a2) mit einer ethylenisch ungesättigten Bindung in der Seitenkette davon:

Formel (0)

(0) 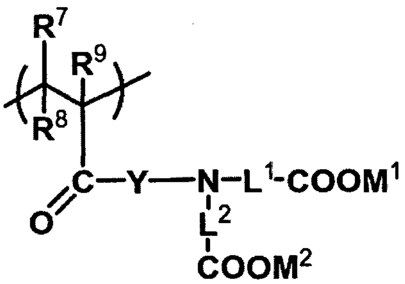

worin in der Formel (0) $R^7$ bis $R^9$ jeweils unabhängig ein Wasserstoffatom, Halogenatom oder Methylgruppe sind, Y eine Einfachbindung oder bivalente Bindegruppe ist, die einen Substituenten haben kann, worin jedes von $L^1$ und $L^2$ unabhängig eine Einfachbindung oder bivalente Bindegruppe sind, die einen Substituenten haben kann, $L^1$ oder der Substituent an $L^1$ und $L^2$ oder der Substituent an $L^2$ miteinander zur Bildung eines Rings kombinieren können, $M^1$ und $M^2$ jeweils unabhängig ein Wasserstoffatom oder ein monovalentes Metallion oder Ammonium sind.

**2.** Lithographischer Druckplattenvorläufer nach Anspruch 1, worin das Polymer (A) weiterhin eine Wiederholungseinheit mit einer hydrophilen Gruppe (a3) in der Seitenkette davon enthält.

**3.** Lithographischer Druckplattenvorläufer nach Anspruch 2, worin die Wiederholungseinheit mit einer hydrophilen Gruppe (a3) in der Seitenkette davon eine Wiederholungseinheit ist, die von einem (Meth)acrylmonomer stammt.

**4.** Lithographischer Druckplattenvorläufer nach Anspruch 2 oder 3, worin die Wiederholungseinheit mit einer hydrophilen Gruppe (a3) in der Seitenkette davon Strukturen, dargestellt durch die Formeln (a3-1) und/oder (a3-2) in der Seitenkette davon aufweist:

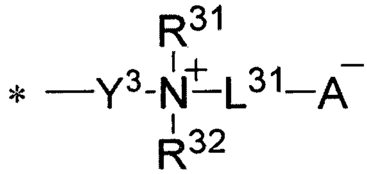

(a3-1)

worin in der Formel (a3-1) $R^{31}$ und $R^{32}$ jeweils unabhängig ein Wasserstoffatom, Alkylgruppe, Alkenylgruppe, Alkinylgruppe, Arylgruppe oder heterocyclische Gruppe sind, $R^{31}$ und $R^{32}$ zur Bildung eines Rings kombinieren können, $L^{31}$ eine bivalente Bindegruppe ist und $A^-$ eine Struktur mit einem Anion ist, $Y^3$ eine Einfachbindung oder bivalente Bindegruppe sind, die einen Substituenten haben kann, * eine Verbindungsstelle darstellt;

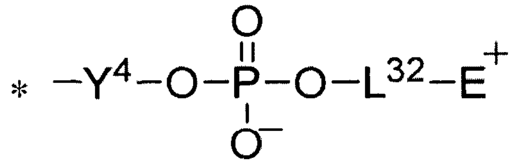

(a3-2)

worin in der Formel (a3-2) $L^{32}$ eine bivalente Bindegruppe ist und $E^+$ eine Struktur mit einem Kation ist, $Y^4$ eine Einfachbindung oder bivalente Bindegruppe ist, die einen Substituenten haben kann, * eine Verbindungsstelle ist.

**5.** Lithographischer Druckplattenvorläufer nach Anspruch 4, worin die Wiederholungseinheit mit einer hydrophilen Gruppe (a3) in der Seitenkette davon durch die Formel (a3-3) unten dargestellt ist:

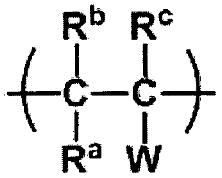
(a3-3)

worin in der Formel (a3-3) $R^a$ bis $R^c$ jeweils unabhängig ein Wasserstoffatom, $C_{1-6}$-Alkylgruppe oder Halogenatom sind, W eine Struktur mit der Formel (a3-1) oder der Formel (a3-2) ist und an ein Kohlenstoffatom an der Position gebunden ist, die mit * in der Formel (a3-1) oder der Formel (a3-2) gezeigt ist.

**6.** Lithographischer Druckplattenvorläufer nach einem der Ansprüche 1 bis 5, worin die Wiederholungseinheit (a2) mit einer ethylenisch ungesättigten Bindung in der Seitenkette davon eine Wiederholungseinheit ist, die von einem (Meth)acrylmonomer stammt.

**7.** Lithographischer Druckplattenvorläufer nach einem der Ansprüche 1 bis 5, worin die Wiederholungseinheit (a2) mit einer ethylenisch ungesättigten Bindung in der Seitenkette davon durch die Formel (a2-1) dargestellt ist:

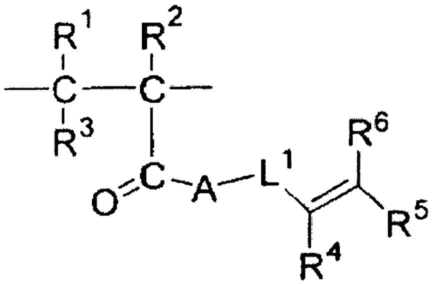

(a2-1)

worin in der Formel (a2-1) $R^1$ bis $R^3$ jeweils unabhängig ein Wasserstoffatom, $C_{1-6}$-Alkylgruppe oder Halogenatom sind, $R^4$ bis $R^6$ unabhängig ein Wasserstoffatom, $C_{1-6}$-Alkylgruppe, Halogenatom, Acylgruppe oder Acyloxygruppe sind, $R^4$ und $R^5$ oder $R^5$ und $R^6$ zur Bildung eines Rings kombinieren können, "A" ein Sauerstoffatom oder $NR^7$-ist, worin $R^7$ ein Wasserstoffatom oder $C_{1-10}$-monovalente Kohlenwasserstoffgruppe ist, $L^1$ eine Einfachbindung oder bivalente Bindegruppe ist, die einen Substituenten haben kann.

**8.** Lithographischer Druckplattenvorläufer nach einem der Ansprüche 1 bis 7, worin $L^1$ und $L^2$ jeweils unabhängig eine Einfachbindung, Alkylengruppe, die einen Substituenten haben kann, Cycloalkylengruppe, die einen Substituenten haben kann, oder Arylengruppe, die einen Substituenten haben kann, sind, $L^1$ oder der Substituent an $L^1$ und $L^2$ oder der Substituent an $L^2$ miteinander zur Bildung eines Rings kombinieren können.

**9.** Lithographischer Druckplattenvorläufer nach einem der Ansprüche 1 bis 8, worin Y in der Formel (0) eine Einfachbindung oder bivalente Bindegruppe ist, ausgewählt aus der Gruppe bestehend aus -CO-, -O-, -NH-, bivalenter aliphatischer Gruppe, bivalenter aromatischer Gruppe oder willkürlichen Kombinationen davon.

**10.** Lithographischer Druckplattenvorläufer nach einem der Ansprüche 1 bis 9, worin die Bildaufzeichnungsschicht des lithographischen Druckplattenvorläufers mit einer wässrigen Lösung mit pH 2 bis 10 entfernbar ist.

**11.** Lithographischer Druckplattenvorläufer nach einem der Ansprüche 1 bis 10, worin die Bildaufzeichnungsschicht des lithographischen Druckplattenvorläufers mit zumindest einem von einer Drucktinte oder Benetzungslösung entfernbar ist.

**12.** Verfahren zur Herstellung einer lithographischen Druckplatte, umfassend das Belichten des lithographischen Druckplattenvorläufers nach einem der Ansprüche 1 bis 11 mit Licht in der Art eines Musters und Entfernen eines nichtbelichteten Bereiches der Bildaufzeichnungsschicht des lithographischen Druckplattenvorläufers in der Gegenwart eines Entwicklers mit pH 2 bis 10.

**13.** Verfahren zur Herstellung einer lithographischen Druckplatte nach Anspruch 12, weiterhin umfassend das Bilden einer Schutzschicht auf der Oberfläche des Trägers entgegengesetzt zur Oberfläche mit der Bildaufzeichnungsschicht, die darauf gebildet ist,
worin der Entwicklungsvorgang weiterhin das Entfernen eines nichtbelichteten Bereiches der Bildaufzeichnungsschicht zusammen mit der Schutzschicht in der Gegenwart des Entwicklers enthält, weiterhin umfassend ein Tensid, aber ohne den Wasserwaschvorgang.

## Revendications

**1.** Précurseur de plaque d’impression lithographique ayant, sur un support, une sous-couche et une couche d’enregistrement d’image empilées dans cet ordre, la sous-couche contenant un polymère (A) contenant une unité répétitive (a1) représentée par la formule (O), et une unité répétitive (a2) ayant une liaison éthylénique insaturée dans la chaîne latérale de celle-ci :

Formule (O)

(O) 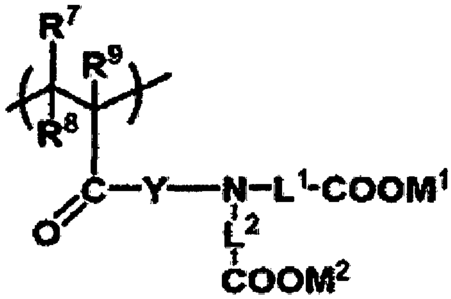

dans la formule (O), chacun de $R^7$ à $R^9$ représente indépendamment un atome d'hydrogène, un atome d'halogène, ou un groupe méthyle, Y représente une liaison simple, ou un groupe de liaison divalent qui peut avoir un substituant, chacun de $L^1$ et $L^2$ représente indépendamment une liaison simple, ou un groupe de liaison divalent qui peut avoir un substituant, $L^1$ ou le substituant sur $L^1$, et $L^2$ ou le substituant sur $L^2$ peuvent se combiner l'un avec l'autre pour former un cycle ; chacun de $M^1$ et $M^2$ représente indépendamment un atome d'hydrogène ou un ion métallique monovalent ou un ammonium.

**2.** Précurseur de plaque d'impression lithographique selon la revendication 1, dans lequel le polymère (A) contient en outre une unité répétitive ayant un groupe hydrophile (a3) dans la chaîne latérale de celle-ci.

**3.** Précurseur de plaque d'impression lithographique selon la revendication 2, dans lequel l'unité répétitive ayant un groupe hydrophile (a3) dans la chaîne latérale de celle-ci est une unité répétitive dérivée d'un monomère (méth)acrylique.

**4.** Précurseur de plaque d'impression lithographique selon la revendication 2 ou 3, dans lequel l'unité répétitive ayant un groupe hydrophile (a3) dans la chaîne latérale de celle-ci a une/des structure(s) représentée(s) par les/la formule(s) (a3-1) et/ou (a3-2) ci-dessous, dans la chaîne latérale de celle-ci :

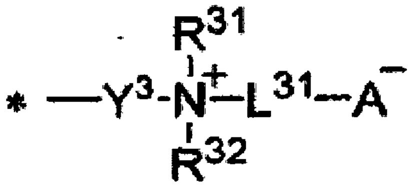

(a3-1)

dans la formule (a3-1), chacun de $R^{31}$ et $R^{32}$ représente indépendamment un atome d'hydrogène, un groupe alkyle, un groupe alcényle, un groupe alcynyle, un groupe aryle, ou un groupe hétérocyclique, $R^{31}$ et $R^{32}$ peuvent se combiner pour former un cycle, $L^{31}$ représente un groupe de liaison divalent, et $A^-$ représente une structure ayant un anion ; $Y^3$ représente une liaison simple ou un groupe de liaison divalent qui peut avoir un substituant ; * représente un connecteur ;

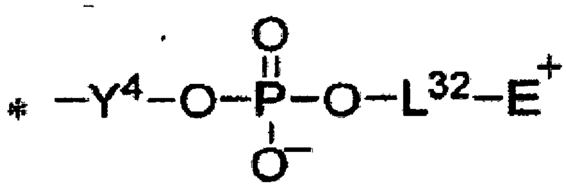

(a3-2)

dans la formule (a3-2), $L^{32}$ représente un groupe de liaison divalent, et $E^+$ représente une structure ayant un cation ; $Y^4$ représente une liaison simple ou un groupe de liaison divalent qui peut avoir un substituant ; * représente un connecteur.

5. Précurseur de plaque d'impression lithographique selon la revendication 4, dans lequel l'unité répétitive ayant un groupe hydrophile (a3) dans la chaîne latérale de celle-ci est représentée par la formule (a3-3) ci-dessous :

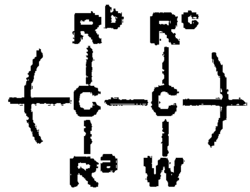
(a3-3)

dans la formule (a3-3), chacun de $R^a$ à $R^c$ représente indépendamment un atome d'hydrogène, un groupe alkyle en $C_1$-$C_6$ ou un atome d'halogène ; W représente une structure représentée par la formule (a3-1) ou la formule (a3-2), et est lié à un atome de carbone à la position indiquée par * dans la formule (a3-1) ou la formule (a3-2).

6. Précurseur de plaque d'impression lithographique selon l'une quelconque des revendications 1 à 5, dans lequel l'unité répétitive (a2) ayant une liaison éthylénique insaturée dans la chaîne latérale de celle-ci est une unité répétitive dérivée d'un monomère (méth)acrylique.

7. Précurseur de plaque d'impression lithographique selon l'une quelconque des revendications 1 à 5, dans lequel l'unité répétitive (a2) ayant une liaison éthylénique insaturée dans la chaîne latérale de celle-ci est représentée par la formule (a2-1) :

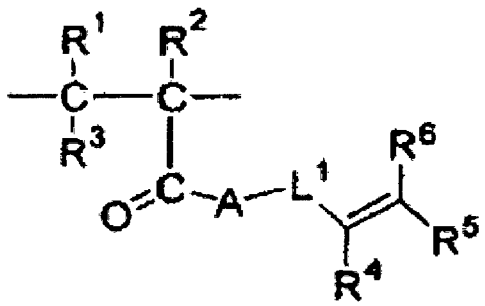
(a2-1)

dans la formule (a2-1), chacun de $R^1$ à $R^3$ représente indépendamment un atome d'hydrogène, un groupe alkyle en $C_1$-$C_6$, ou un atome d'halogène ; chacun de $R^4$ à $R^6$ représente indépendamment un atome d'hydrogène, un groupe alkyle en $C_1$-$C_6$, un atome d'halogène, un groupe acyle, ou un groupe acyloxy ; $R^4$ et $R^5$, ou $R^5$ et $R^6$, peuvent se combiner pour former un cycle ; « A » représente un atome d'oxygène ou $NR^7$-, $R^7$ représente un atome d'hydrogène ou un groupe hydrocarboné monovalent en $C_1$-$C_{10}$ ; $L^1$ représente une liaison simple ou un groupe de liaison divalent qui peut avoir un substituant.

8. Précurseur de plaque d'impression lithographique selon l'une quelconque des revendications 1 à 7, dans lequel

chacun de $L^1$ et $L^2$ représente indépendamment une liaison simple, un groupe alkylène qui peut avoir un substituant, un groupe cycloalkylène qui peut avoir un substituant, ou un groupe arylène qui peut avoir un substituant, $L^1$ ou le substituant sur $L^1$, et $L^2$ ou le substituant sur $L^2$ peuvent se combiner l'un avec l'autre pour former un cycle.

**9.** Précurseur de plaque d'impression lithographique selon l'une quelconque des revendications 1 à 8, dans lequel Y dans la formule (O) est une liaison simple ou un groupe de liaison divalent choisi parmi le groupe consistant en -CO-, -O-, -NH-, un groupe aliphatique divalent, un groupe aromatique divalent et des combinaisons arbitraires de ceux-ci.

**10.** Précurseur de plaque d'impression lithographique selon l'une quelconque des revendications 1 à 9, dans lequel la couche d'enregistrement d'image du précurseur de plaque d'impression lithographique peut être éliminée avec une solution aqueuse de pH 2 à 10.

**11.** Précurseur de plaque d'impression lithographique selon l'une quelconque des revendications 1 à 10, dans lequel la couche d'enregistrement d'image du précurseur de plaque d'impression lithographique peut être éliminée avec au moins l'une ou l'autre d'une encre d'impression et d'une solution de mouillage.

**12.** Procédé de fabrication d'une plaque d'impression lithographique comprenant l'exposition du précurseur de plaque d'impression lithographique selon l'une quelconque des revendications 1 à 11 à une lumière selon un tracé ; et l'élimination d'une partie non exposée de la couche d'enregistrement d'image du précurseur de plaque d'impression lithographique en présence d'un révélateur de pH 2 à 10.

**13.** Procédé de fabrication d'une plaque d'impression lithographique selon la revendication 12, comprenant en outre la formation d'une couche de protection sur la surface du support opposée à la surface ayant la couche d'enregistrement d'image formée sur celui-ci,
dans lequel le processus de révélation comprend en outre l'élimination d'une partie non exposée de la couche d'enregistrement d'image ensemble avec la couche de protection en présence du révélateur contenant en outre un agent tensioactif, mais excluant le processus de lavage à l'eau.

Fig. 1

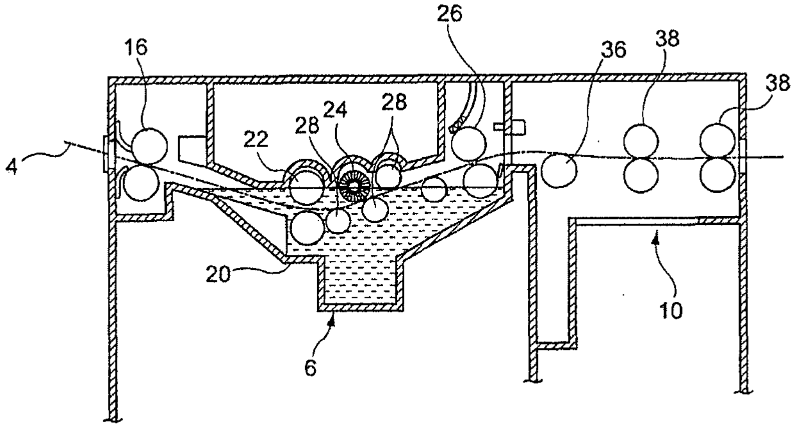

Fig. 2

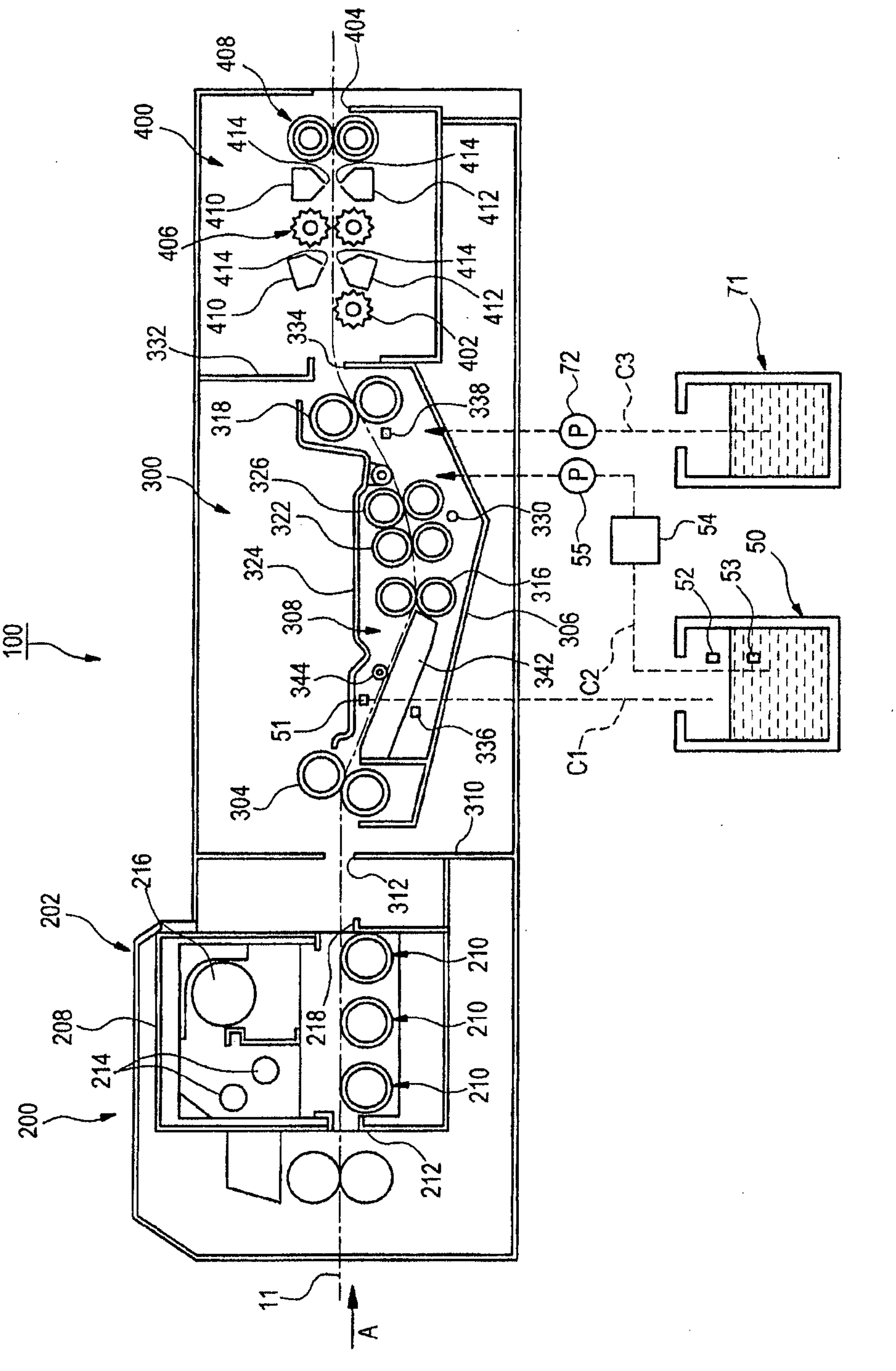

100
200
202
208
210
212
214
216
218
300
304
306
308
310
312
316
318
322
324
326
330
332
334
336
338
342
344
400
402
404
406
408
410
412
414
50
51
52
53
54
55
71
72
C1
C2
C3
P
11
A

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007118579 A
- JP 2007072308 A
- EP 1767352 A2
- JP 2005234385 A
- EP 24629 A
- EP 107792 A
- US 4410621 A
- JP H05158230 B
- JP 4069055 B
- JP H04365049 B
- US 4069055 A
- US 4069056 A
- EP 104143 A
- US 20080311520 A
- JP H02150848 B
- JP 2008195018 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2007206217 A
- JP 2006508380 PCT
- JP 2002287344 A
- JP 2008256850 A
- JP 2001342222 A
- JP H09179296 B
- JP H09179297 B
- JP H09179298 B
- JP 2004294935 A
- JP 2006243493 A
- JP 2002275129 A
- JP 2003064130 A
- JP 2003280187 A
- JP H10333321 B
- JP S4841708 B
- JP S5137193 B
- JP H0232293 B
- JP H0216765 B
- JP 2003344997 A
- JP 2006065210 A
- JP S5849860 B
- JP S5617654 B
- JP S6239417 B
- JP S6239418 B
- JP 2000250211 A
- JP 2007094138 A
- US 7153632 B
- JP H08505958 PCT
- JP 2007293221 A
- JP 2007293223 A
- JP 2007187836 A
- JP 2008276155 A
- JP 2005250438 A
- JP 2005250158 A
- JP 2001075279 A
- JP 2007058170 A
- JP 2007093866 A
- JP 2007072816 A
- JP 2006189604 A
- JP 2007171406 A
- JP 2007206216 A
- JP 2007225701 A
- JP 2007225702 A
- JP 2007316582 A
- JP 2007328243 A
- JP 2001133969 A
- JP 2002023360 A
- JP 2002040638 A
- JP 2002278057 A
- JP 2007090850 A
- JP H055005 B
- JP 2001222101 A
- JP 2007276454 A
- JP 2009154525 A
- JP 2006297907 A
- JP 2007050660 A
- JP 2008284858 A
- JP 2009090645 A
- JP 2009208458 A
- JP 333003 A
- JP H09123387 B
- JP H09131850 B
- JP H09171249 B
- JP H09171250 B
- EP 931647 A
- JP 2001277740 A
- JP 2001277742 A
- JP 2005509192 PCT
- JP 2004310000 A
- JP 2005250216 A
- JP 2006259137 A

- JP 2005119273 A
- JP H0545885 B
- JP H0635174 B
- JP 2008203359 A
- JP 2008276166 A
- JP 2009047927 A


**Non-patent literature cited in the description**


- Shin Kobunshi Jikkengaku. Kyoritsu Shuppan Co. Ltd, 28 March 1996
- Kobunshi no Gosei to Hanno. Kyoritsu Shuppan Co. Ltd, May 1992
- Shin Jikken Kagaku Koza. Kobunshi Kagaku. Maruzen Co. Ltd, 20 November 1980, vol. 19
- Bussitsu Kogaku Koza Kobunshi Gosei Kagaku. Tokyo Denki University Press, September 1995
- **S.I. SCHLESINGER.** *Photogr. Sci. Eng.,* 1974, vol. 18, 387
- **T.S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *The Proc. Conf. Rad. Curing ASIA,* October 1988, 478
- Senryo Binran. 1970
- Kobunshi Jiten. 2005, 683-684